(19) Europäisches Patentamt
European Patent Office
Office européen des brevets

(11) EP 1 879 442 A1

(12) # EUROPEAN PATENT APPLICATION
published in accordance with Art. 153(4) EPC

(43) Date of publication:
**16.01.2008 Bulletin 2008/03**

(21) Application number: **06731701.6**

(22) Date of filing: **12.04.2006**

(51) Int Cl.:
***H05K 9/00*** *(2006.01)*

(86) International application number:
**PCT/JP2006/307765**

(87) International publication number:
**WO 2006/120832 (16.11.2006 Gazette 2006/46)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **18.04.2005 JP 2005119225**

(71) Applicant: **NITTO DENKO CORPORATION**
**Ibaraki-shi,**
**Osaka 567-8680 (JP)**

(72) Inventors:
- **SANO, Masanori**
**ome, Ibaraki-shi, Osaka;5678680 (JP)**
- **IMONO, Shozo**
**ome, Ibaraki-shi, Osaka;5678680 (JP)**
- **NIINO, Takuya**
**ome, Ibaraki-shi, Osaka;5678680 (JP)**

(74) Representative: **Grünecker, Kinkeldey,**
**Stockmair & Schwanhäusser**
**Anwaltssozietät**
**Maximilianstrasse 58**
**80538 München (DE)**

(54) **STRUCTURE HAVING CHARACTERISTIC OF TRANSMITTING OR ABSORBING ELECTROMAGNETIC WAVE**

(57) Disclosed is a structure which can maintain a capability of conducting or absorbing electromagnetic waves even when an external pressure is applied thereon. The structure (1) includes a fibrous protrusion (1b) having the capability of conducting or absorbing electromagnetic waves partially arranged on a substrate (1a) so that at least a part of a fiber of the fibrous protrusion is positioned outward from a surface of the substrate (1a). The structure further includes a fiber protector (1c) arranged at least partially of a portion in a surface (1a1) of the substrate (1a) where no fibrous protrusion (1b) is arranged, in which the fiber protector is capable of suppressing or preventing the fibrous protrusion (1b) from flattening.

Fig. 1

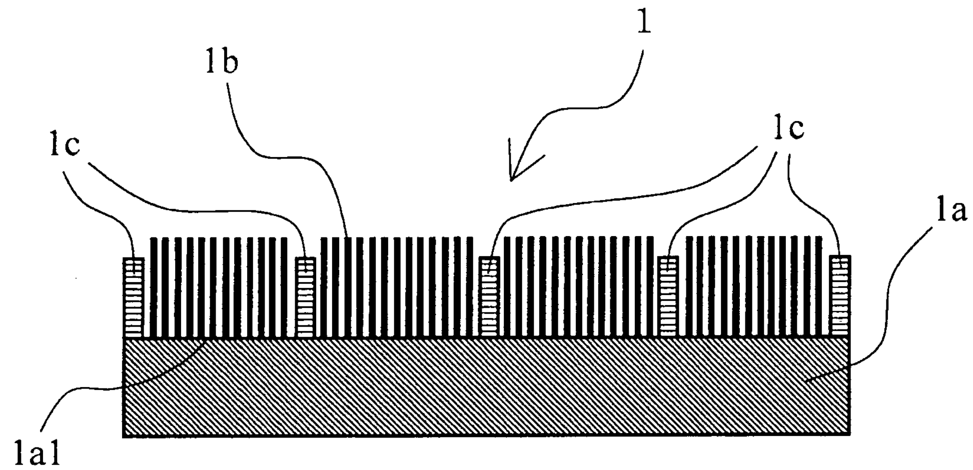


EP 1 879 442 A1

## Description

### Technical Field

The present invention relates to a structure having a capability of conducting or absorbing electromagnetic waves.

### Background Art

In various kinds of joining (especially, joining of electronic parts, etc.) for which a pressure-sensitive adhesive tape is used, it has been frequently required to have a capability of conducting or absorbing electromagnetic waves such as electrical conductivity and electromagnetic shielding ability. Consequently, there have been made a lot of investigations with respect to a method for providing (bringing) a capability of conducting or absorbing electromagnetic waves such as electrical conductivity and electromagnetic shielding ability in a pressure-sensitive adhesive tape. For example, as materials having electrical conductivity or electromagnetic shielding ability, there are proposed an electroconductive mutual connecting material obtained by non-random single layer coating of a particle (Patent Document 1); and an electroconductive sealing material obtained by blending a silica powder, carbon black, and a metal powder in a silicon rubber (Patent document 2). As materials having electrical conductivity or electromagnetic shielding ability, there is also proposed a high molecular molded article having electromagnetic shielding ability in which a flock composed of an electroconductive fiber is flocked and fixed on a high molecular substrate, and electrical conductivity is imparted between flocks on the roots of the flocks (Patent Document 3).

For the purpose of keeping electrical conductivity, the electroconductive mutual connecting material must have an electroconductive particle being regularly aligned. If it is possible to regularly align the electroconductive particle, such is certainly useful in view of the electrical conductivity; however, regular alignment of the particle is a very complicated technique and is accompanied with difficulty in steps.

Furthermore, the electroconductive sealing material is provided with electrical conductivity by kneading an electroconductive particle into resins. For that reason, the preparation method of this material is simple, and there is a less problem in view of steps. However, in order to impart electrical conductivity, a large amount of the electroconductive particle must be blended, and this invites comparatively high costs. In addition, such a large amount of the blended electroconductive particle affects the other properties of the sealing material.

Since the above-mentioned high molecular molded article having electromagnetic shielding ability has a configuration in which an electroconductive fiber is flocked on a high molecular substrate by using, for example, an adhesive layer having electrical conductivity, the electromagnetic shielding ability is improved. It cannot be said, however, that such an improvement is sufficient, and thus a structure having further excellent electromagnetic shielding ability is demanded. In addition, the electroconductive fiber is liable to fall out, because it is merely flocked in the adhesive layer having electrical conductivity. The electroconductive fiber which has fallen out from the adhesive layer having electrical conductivity becomes a dust or adversely affects a device into which the high molecular molded article having electromagnetic shielding ability is installed or surrounding instruments thereof. Thus, when an electroconductive fiber is used, good retention of the electroconductive fiber is demanded.

Patent Document 1: PCT Japanese Translation Patent Publication (JP-A) No. 2002-501821
Patent Document 2: Japanese Unexamined Patent Application Publication (JP-A) No. H10-120904
Patent Document 3: Japanese Unexamined Patent Application Publication (JP-A) No. S61-2394

### Disclosure of the Invention

### Problems to be Solved by the Invention

Under these circumstances, the present inventors found that, by providing a specific structural section composed of a fiber having electrical conductivity in a pressure-sensitive adhesive layer, not only it is possible to impart electrical conductivity to a member having the pressure-sensitive adhesive layer, but also it can be prepared easily and economically. In particular, they found that, by providing a specific structural section composed of a fiber having electrical conductivity partially in a pressure-sensitive adhesive layer, it is possible to impart electrical conductivity without impairing a pressure-sensitive adhesive property which is original in a pressure-sensitive adhesive layer to a considerable extent. The specific structural section composed of an electroconductive fiber, however, is likely to flatten (fall sideways) by the action of an external pressure such as rolling pressure during its manufacturing or pressure (load) during its use, because it is composed of a fiber. If the fiber flatten, the fibrous specific structure may have a reduced thickness to thereby have reduced capability of conducting or absorbing electromagnetic waves.

Accordingly, an object of the present invention is to provide a structure that can effectively maintain its capability of conducting or absorbing electromagnetic waves at a good level even when an external pressure is applied thereon. Another object of the present invention is to provide a structure that can be suitably applied as an electroconductive material, an electromagnetic absorptive material, and/or an electromagnetic shielding material. Means for Solving the Problems

After intensive investigations to achieve the objects, the present inventors found that a fiber can be effectively suppressed or prevented from flattening even when an external pressure typically in roll pressing is applied thereon, by providing a specific structural section composed of an electroconductive fiber on a pressure-sensitive adhesive layer and affixing a fiber protector to a predetermined portion in a surface of the pressure-sensitive adhesive layer, in which the fiber protector is capable of suppressing or preventing the specific structural section composed of the electroconductive fiber from flattening. The present invention has been made based on these findings.

Specifically, according to the present invention, there is provided a structure having a capability of conducting or absorbing electromagnetic waves, which includes a substrate and a fibrous protrusion (fibrous protruding structural section), in which the fibrous protrusion has a capability of conducting or absorbing electromagnetic waves and is partially arranged in the substrate so that at least a part of a fiber of the fibrous protrusion is positioned outward from a surface of the substrate. This structure further includes a fiber protector arranged at least partially in a portion of the surface of the substrate where no fibrous protrusion having a capability of conducting or absorbing electromagnetic waves (electromagnetically conductive or absorptive fibrous protrusion) is arranged, and the fiber protector is capable of suppressing or preventing the electromagnetically conductive or absorptive fibrous protrusion from flattening.

The fiber protector preferably includes a member having one or more through holes. The member having one or more through holes may be preferably a net-like member having two or more through holes or a sheet-like member having two or more perforated through holes. The fiber protector preferably includes a plastic material as a raw material. The fiber protector desirably has such a thickness as to be 10% to 250% of the thickness of the part of the electromagnetically conductive or absorptive fibrous protrusion positioned outward from the surface of the substrate.

The portion of the substrate where the electromagnetically conductive or absorptive fibrous protrusion is arranged desirably has such a total area as to be more than 0% and equal to or less than 99.9% of the total surface area of one surface of the substrate.

The substrate is suitably at least one layer selected from the group consisting of a pressure-sensitive adhesive layer, an adhesive layer, and a polymer layer. The substrate desirably has a capability of conducting or absorbing electromagnetic waves. The substrate may be arranged at least on one surface of a support. The support desirably has a capability of conducting or absorbing electromagnetic waves.

According to a preferred embodiment of the present invention, the electromagnetically conductive or absorptive fibrous protrusion is covered by a covering layer. The covering layer desirably has a capability of conducting or absorbing electromagnetic waves.

A sheet-like structure having a sheet form is suitably used as the structure.

A structure according to the present invention can be advantageously used as an electroconductive material, an electromagnetic absorptive material, and/or an electromagnetic shielding material.

Advantages

Structures according to the present invention have the above-mentioned configurations and can effectively maintain a capability of conducting or absorbing electromagnetic waves at a good level even when an external pressure is applied thereon. Accordingly, the structures according to the present invention can be advantageously used as an electroconductive material, an electromagnetic absorptive material, and/or an electromagnetic shielding material.

Brief Description of the Drawings

Fig. 1 is a schematic cross-sectional view illustrating a part of a structure according to an embodiment of the present invention.
Fig. 2 shows schematic views each illustrating, by way of example, a part of a fiber protector for use in a structure according to the present invention.
Fig. 3 shows schematic cross-sectional views showing structures according to embodiments of the present invention.
Fig. 4 is a schematic cross-sectional view showing a structure according to an embodiment of the present invention.
Fig. 5 is' a schematic view showing a polyethylene net-like member as a fiber protector for use in Example 1.
Fig. 6 is a schematic cross-sectional view showing a sheet-like structure prepared according to Example 1.
Fig. 7 is a schematic cross-sectional view showing a sheet-like structure prepared according to Example 2.
Fig. 8 is a schematic cross-sectional view showing a sheet-like structure prepared according to Example 3.

Fig. 9 is a schematic cross-sectional view showing a sheet-like structure prepared according to Example 4.

Fig. 10 is a schematic cross-sectional view showing a sheet-like structure prepared according to Example 5.

Fig. 11 is a schematic cross-sectional view showing a sheet-like structure prepared according to Comparative Example 1.

Fig. 12 shows a graph relating to magnetic field shielding effects in a part of the data in Table 2.

Fig. 13 shows another graph relating to magnetic field shielding effects in a part of the data in Table 2.

Fig. 14 shows another graph relating to magnetic field shielding effects in a part of the data in Table 2.

Fig. 15 shows another graph relating to magnetic field shielding effects in a part of the data in Table 2.

Fig. 16 shows schematic views each showing a shielding box for use in a measuring instrument for the evaluationa of the electromagnetic shielding effectiveness by the KEC Method, in which Fig. 16(a) shows an electric-field shielding box, and Fig. 16(b) shows a magnetic-field shielding box.

Fig. 17 is a schematic view illustrating, by way of example, a part of another fiber protector for use in a structure according to the present invention.

Reference Numerals

| | |
|---|---|
| 1 | structure |
| 1a | substrate |
| 1a1 | surface of substrate 1a |
| 1b | electromagnetically conductive/absorptive fibrous protrusion |
| 1c | fiber protector |
| 21 | net-like member |
| 21a | through hole |
| 22 | net-like member |
| 22a | through hole |
| 3a | structure |
| 3a1 | pressure-sensitive adhesive or adhesive layer (pressure-sensitive adhesive layer or adhesive layer) |
| 3a2 | base material |
| 3a3 | electromagnetically conductive/absorptive fiber-raised section |
| 3a4 | fiber protector |
| 3b | structure |
| 3b1 | pressure-sensitive adhesive layer |
| 3b2 | release liner |
| 3b3 | electromagnetically conductive/absorptive fiber-raised section |
| 3b4 | fiber protector |
| 3c | structure |
| 3c1 | polymer layer |
| 3c2 | electromagnetically conductive/absorptive fiber-raised section |
| 3c3 | fiber protector |
| 4 | structure |
| 41 | substrate |
| 42 | electromagnetically conductive/absorptive fibrous protrusion |
| 43 | fiber protector |
| 44 | covering layer |
| 5 | sheet-like structure A1 |
| 51 | electromagnetically conductive/absorptive base material |
| 52 | electromagnetically conductive/absorptive pressure-sensitive adhesive layer |
| 53 | fiber protector |
| 54 | electromagnetically conductive/absorptive fiber-raised section |
| 6 | sheet-like structure A2 |
| 61 | electromagnetically conductive/absorptive base material |
| 62 | electromagnetically conductive/absorptive pressure-sensitive adhesive layer |
| 63 | fiber protector |
| 64 | electromagnetically conductive/absorptive fiber-raised section |
| 7 | sheet-like structure A3 |
| 8 | sheet-like structure A4 |

81 electromagnetically conductive/absorptive base material
82 electromagnetically conductive/absorptive pressure-sensitive adhesive layer
83 fiber protector
84 electromagnetically conductive/absorptive fiber-raised section
85 covering layer
85a acrylic pressure-sensitive adhesive layer
85b poly(ethylene terephthalate) film
9 sheet-like structure A5
91 electromagnetically conductive/absorptive base material
92 electromagnetically conductive/absorptive pressure-sensitive adhesive layer
93 fiber protector
94 electromagnetically conductive/absorptive fiber-raised section
95 covering layer
95a acrylic pressure-sensitive adhesive layer
95b woven fabric composed of an acrylic fiber with nickel-plated surface
10 sheet-like structure A6
101 electromagnetically conductive/absorptive base material
102 electromagnetically conductive/absorptive pressure-sensitive adhesive layer
103 electromagnetically conductive/absorptive fiber-raised section
11 perforated sheet member
111 sheet-like base material
112 perforated through hole (perforated section)

Best Mode for Carrying Out the Invention

With reference to Fig. 1, a structure according to the present invention is a structure having a capability of conducting or absorbing electromagnetic waves, because it includes a substrate and a fibrous protrusion, in which the fibrous protrusion has a capability of conducting or absorbing electromagnetic waves (the fibrous protrusion will be hereinafter also referred to as "electromagnetically conductive/absorptive fibrous protrusion") and is partially arranged in the substrate so that at least a part of a fiber of the fibrous protrusion is positioned outside a surface of the substrate. The structure has a configuration in which a fiber protector is arranged at least partially in a portion of the surface of the substrate where no electromagnetically conductive or absorptive fibrous protrusion is arranged, and the fiber protector is capable of suppressing or preventing the electromagnetically conductive/absorptive fibrous protrusion from flattening. Thus, the structure according to the present invention can exhibit a capability of conducting or absorbing electromagnetic waves (hereinafter also referred to as "electromagnetic conductivity/absorptivity") at a good level, because the structure has an electromagnetically conductive/absorptive fibrous protrusion. In addition, the electromagnetically conductive/absorptive fibrous protrusion is suppressed or prevented from flattening, and the structure can thereby effectively maintain its electromagnetic conductivity/absorptivity at a good level even when an external pressure is applied thereon, because the structure further includes a fiber protector arranged at least partially in a portion of the surface of the substrate where no electromagnetically conductive/absorptive fibrous protrusion is arranged, in which the fiber protector is capable of suppressing or preventing the electromagnetically conductive/absorptive fibrous protrusion from flattening. Examples of such an external pressure include an external pressure applied in manufacturing of the structure, such as pressure upon roll pressing; and an external pressure applied in usage of the structure, such as pressing force upon pressing or coiling pressure upon winding or coiling.

Fig. 1 is a schematic cross-sectional view illustrating a part of a structure according to an embodiment of the present invention. Fig. 1 shows a structure 1, a substrate 1a, a surface 1a1 of the substrate 1a, an electromagnetically conductive/absorptive fibrous protrusion 1b, and a fiber protector 1c. The structure 1 illustrated in Fig. 1 has such a configuration that the electromagnetically conductive/absorptive fibrous protrusion 1b is partially arranged on the surface 1a1 of the substrate 1a, and the fiber protector 1c is arranged in a portion of the surface 1a1 of the substrate 1a where no electromagnetically conductive/absorptive fibrous protrusion 1b is arranged.

(Fiber Protector)

In a structure according to the present invention, an electromagnetically conductive/absorptive fibrous protrusion is arranged on a substrate so that at least a part of a fiber thereof is positioned outward from a surface of the substrate; and a fiber protector is arranged at least partially (entirely or partially) in a portion of the surface of the substrate where no electromagnetically conductive/absorptive fibrous protrusion is arranged. The fiber protector is desirably arranged entirely in a portion of the surface of the substrate where no electromagnetically conductive/absorptive fibrous protrusion is arranged. The fiber protector may be arranged on a surface of the substrate in any form not specifically limited, as long as the fiber protector is not come off easily and may be fixed on a surface of the substrate; however, the fiber protector is preferably affixed (attached) to a surface of the substrate. When the substrate is, for example, a pressure-sensitive adhesive layer or adhesive layer (pressure-sensitive adhesive or adhesive layer) as mentioned later, a fiber protector affixed to a surface of the substrate is available by affixing the fiber protector to a surface of the pressure-sensitive adhesive or adhesive layer as the substrate. When the substrate is not a pressure-sensitive adhesive or adhesive layer, a fiber protector affixed to a surface of the substrate is available by using, for example, a known fixing procedure. In this case, the fiber protector may be affixed to the substrate, for example, by a process of using a pressure-sensitive adhesive or adhesive; or a process of forming a pressure-sensitive adhesive layer or an adhesive layer on one surface of the fiber protector and affixing the fiber protector to a surface of the substrate through the pressure-sensitive adhesive layer or adhesive layer formed on the surface of the substrate.

The fiber protector is not particularly limited, as long as it is a member capable of suppressing or preventing the electromagnetically conductive/absorptive fibrous protrusion from flattening. When the electromagnetically conductive/absorptive fibrous protrusion has, for example, a configuration in which two or more electromagnetically conductive/absorptive fibrous protrusions are independently arranged on the substrate (namely, arranged as islands in a so-called "islands-in-sea structure"), the fiber protector may include one or more members that are able to cover portions of a surface of the substrate where no electromagnetically conductive/absorptive fibrous protrusion is arranged; however, the fiber protector preferably includes a member having through holes at least in portions corresponding to the portions of the substrate where the electromagnetically conductive/absorptive fibrous protrusions are arranged. By using such a member having one or more through holes as the fiber protector, the fiber protector can be easily arranged in portions of the surface of the substrate where no electromagnetically conductive/absorptive fibrous protrusion is arranged. According to a preferred embodiment of the present invention, a structure therefore includes a substrate, an electromagnetically conductive/absorptive fibrous protrusion, a fiber protector, in which the structure has an electromagnetic conductivity/absorptivity by arranging the electromagnetically conductive/absorptive fibrous protrusion partially on a substrate so that at least a part of a fiber thereof is positioned outward from a surface of the substrate; the fiber protector includes a member having one or more through holes and is arranged on a surface of the substrate; and the electromagnetically conductive/absorptive fibrous protrusion is arranged in a portion of the substrate corresponding to the through hole of the fiber protector so that at least a part of a fiber thereof is positioned outward from the surface of the substrate.

The fiber protector composed of a member having one or more through holes may be composed of one member having two or more through holes or may be composed of two or more members each having one or more through holes.

The through hole(s) of the member having one or more through holes may have any shape, as long as an electromagnetically conductive/absorptive fibrous protrusion can be positioned in the through hole; however the through hole preferably has a shape corresponding to the shape of the electromagnetically conductive/absorptive fibrous protrusion. More specifically, the through hole may have any shape including a regular shape such as a substantially circular shape or a substantially polygonal shape, or any of various irregular shapes according to the shape of the electromagnetically conductive/absorptive fibrous protrusion. When the member has two or more through holes, the through holes may be arranged in any arrangement. For example, they may be arranged regularly or irregularly.

Consequently, in a member having one or more through holes as the fiber protector, the diameters (e.g., average diameter, smallest diameter, and largest diameter) and size of through hole(s), and intervals (e.g., average interval, smallest interval, and largest interval) between through holes are not particularly limited and can be set according typically to the dimensions of an electromagnetically conductive/absorptive fibrous protrusion arranged on the substrate. The through holes may therefore be formed regularly or irregularly.

A member having one or more through holes for use in the present invention is not particularly limited, as long as it is a member having one or more through holes (open holes). Preferred examples of the member include a member having two or more through holes in a net-like arrangement (hereinafter also referred to as "net-like member") as illustrated in Fig. 2; and a sheet-like member having two or more perforated or punched through holes (hereinafter also referred to as "perforated sheet member") as illustrated in Fig. 17. Namely, the fiber protector is preferably composed of a net-like member and/or a perforated sheet member.

Fig. 2 shows schematic views each illustrating, by way of example, a part of a fiber protector for use in a structure according to an embodiment of the present invention. Fig. 2 illustrates net-like members 21 and 22, through holes 21a of the net-like member 21, and through holes 22a of the net-like member 22. The net-like member 2 has two or more through holes 2a arranged in a net-like arrangement. Such a net-like member can have two or more through holes having regular or irregular shapes in a regular or irregular arrangement.

Fig. 17 is a schematic view illustrating, by way of example, a part of a fiber protector for use in a structure according to the present invention. Fig. 17 illustrates a perforated sheet member 11, a sheet-like base material 111, and perforated through holes (perforated sections) 112. The perforated sheet member 11 has two or more perforated sections as through holes formed as a result of perforating (punching) and arranged in predetermined portions of the sheet-like base material 111. Such a perforated sheet member can have two or more through holes having regular or irregular shapes in a regular or irregular arrangement, as in a net-like member.

Especially, when a perforated sheet member is employed, the shapes, sizes, and positions of through holes (perforated sections) in the perforated sheet member can be easily controlled, because the perforated sheet member is prepared through perforating with a perforator (drill). Specifically, the perforated sheet member has a high degree of freedom in design of through holes to be arranged. In addition, the perforated sheet member is more likely to ensure an adhesion area than a net-like member is, when it is stuck or adhered to a substrate such as a pressure-sensitive adhesive or adhesive layer. Thus, when a perforated sheet member is employed, a perforated sheet member having through holes arranged in a predetermined patterned arrangement can be easily prepared by adjusting the sizes and positions of through holes upon perforating.

Such a perforated sheet member is prepared through perforating or punching, and the formed perforated section generally has a thick-walled section in a peripheral region, and the thick-walled section protrudes toward only one surface thereof. The perforated sheet member is used such that the protruded side of the thick-walled section is positioned outward. When the member having one or more through holes for use in the present invention is a perforated sheet member, the thickness of the perforated sheet member refers to the thickness (largest thickness) of the thick-walled section in a peripheral region of the perforated section. When the member having one or more through holes is a net-like member or a perforated sheet member having no thick-walled section in a peripheral region of a perforated section, the thickness of the member having one or more through holes refers to the thickness of the peripheral region of the through hole, and in this case, the thickness corresponds to the average thickness of the member having one or more through holes.

The percentage of holes (porosity) of a member having one or more through holes, such as a net-like member or a perforated sheet member, is not particularly limited and can be set according to the area of an electromagnetically conductive/absorptive fibrous protrusion arranged on the substrate. It can be set, for example, within a range of more than 0% and equal to or less than 99.9%. The percentage of holes in a member having one or more through holes can be set as appropriate according typically to the usage of the structure and the surface area of one surface of the structure. More specifically, a structure according to the present invention may be used as an electromagnetic shielding material typically for use in an electronic component typified by an electronic component and the like for use in a "mobile phone." In addition or alternatively, the structure may have a small surface area (e.g., 500 $mm^2$ or less) of one surface thereof. In these cases, the member having one or more through holes preferably has a percentage of holes of 0.3% to 99.8%, more preferably 30% to 90%, and particularly preferably 45% to 80%. In contrast, a structure according to the present invention may be used, for example, as an electromagnetic shielding material for building; for example, the structure may be used as a member constituting planes (wall plane, ceiling plane, and floor plane, etc.) of the building or may be affixed to a constituting material thereof such as a board or floor material before use. Alternatively, the structure may have a large surface area (e.g., 0.5 $m^2$ or more) of one surface thereof. In these cases, the member having one or more through holes preferably has a percentage of holes of 0.03% to 99.8%, more preferably 0.1% to 50%, and particularly preferably 0.3% to 40%.

The "percentage of holes" of a member having one or more through holes is a value measured by the following "method for measuring percentage of holes."

(Method for Measuring Percentage of Holes)

A sample member having one or more through holes is colored to a suitable color according to necessity and is placed on paper showing a predetermined color different from that of the member having one or more through holes. When the member having one or more through holes shows, for example, a whitish color such as white or translucent white color, it may be placed on a black paper. Alternatively, the member having one or more through holes may be colored to black regardless of its original color and placed on a white paper. Then image data of the member having one or more through holes on the paper is inputted into a computer by carrying out scanning with a scanner. The image data are then subjected to processing or editing, such as removal of unnecessary portion, on the computer using an image processing software under the trade name of "PHOTOSHOP ELEMENTS 2.0" (produced by Adobe Systems Inc.; digital image editing software). More specifically, when the member having one or more through holes shows, for example, a black color or has been colored to black, processing or editing is carried out to convert the colors of the other (unnecessary) portions into a predetermined color so that a portion corresponding to the member having one or more through holes becomes a black portion, and a portion corresponding to the through hole becomes a white portion. Thus, processing or editing is carried out so as to yield two colors consisting of a color corresponding to the member portion and another color corresponding to the through hole portion, and thereafter binarization is carried out using an image processing software under the trade name of "MATROX INSPECTOR 2.1" (produced by Matrox Electronic Systems Ltd.; supplied from Canon System Solutions Inc.; image processing algorithm verification tool), the proportions or ratios of respective colors per unit area (10 mm x 10 mm) are determined by determining proportions or ratios of respective colors at different three points, respectively, and averaging the values, and the ratio of through holes in the member having one or more through holes is determined. More specifically, when a member having one or more through holes being black or being colored to black is placed on a white paper, the proportions or ratios of the white and black portions are determined. In this case, the ratio of black portion (black ratio) is defined as the ratio of the member having one or more through holes; and the ratio of white portion (white ratio) is the ratio of through hole in the member having one or more through holes, namely, the percentage of holes of the member having one or more through holes.

When the image data of the member having one or more through holes is inputted into the computer through a scanner and a portion corresponding to the member having one or more through holes is clearly distinguished from a portion corresponding to the through hole without coloring of the member having one or more through holes on an outputted image of the image data outputted and displayed on the computer, the data may be processed or edited so as to separate two colors including a color corresponding to the portion of member having one or more through holes and another color corresponding to the portion of through holes, by conducting processing or editing to separate the color corresponding to the portion of member having one or more through holes from the color corresponding to the portion of through hole using an image processing software under the trade name of "PHOTOSHOP ELEMENTS 2.0" (produced by Adobe Systems Inc.; digital image editing software). Thereafter, as with above, binarization is carried out using an image processing software under the trade name of "MATROX INSPECTOR 2.1" (produced by Matrox Electronic Systems Ltd.; supplied from Canon System Solutions Inc.; image processing algorithm verification tool), the proportions or ratios of respective colors per unit area (10 mm x 10 mm) are determined by determining proportions or ratios of respective colors at different three points, respectively, and averaging the values, and the ratio of through holes in the member having one or more through holes is determined.

A material for the fiber protector is not particularly limited and includes, for example, plastic materials, fibrous materials, paper materials, and metallic materials. Examples of the plastic materials include olefin resins such as polyethylenes (e.g., low-density polyethylenes, straight-chain low-density polyethylenes, medium-density polyethylenes, and high-density polyethylenes), polypropylenes, poly-1-butenes, poly-4-methyl-1-pentenes, ethylene-propylene copolymers, ethylene-1-butene copolymers, ethylene-vinyl acetate copolymers, ethylene-acrylate ester copolymers (e.g., ethylene-ethyl acrylate copolymers and ethylene-methyl methacrylate copolymers), and ethylene-vinyl alcohol copolymers; polyester resins such as poly(ethylene terephthalate)s, poly(butylene terephthalate)s, poly(ethylene naphthalate) s, and poly(butylene naphthalate)s; polyacrylates; styrenic resins such as polystyrenes, styrene-isoprene copolymers, styrene-butadiene copolymers, styrene-isoprene-styrene copolymers, styrene-butadiene-styrene copolymers, and acrylonitrile-butadienestyrene copolymers; polyamide resins such as polyamide-6 and polyamide-6,6; poly(vinyl chloride)s; poly(vinylidene chloride)s; and polycarbonates.

Examples of the fibrous materials include cotton fibers, rayon fibers, polyamide fibers, polyester fibers, polyacrylonitrile fibers, acrylic fiber, poly(vinyl alcohol) fibers, polyethylene fibers, polypropylene fibers, polyimide fibers, silicone fibers, and fluorine-contained resin fibers. Examples of the paper materials include Japanese paper, foreign paper, woodfree paper, glassine paper, kraft paper, "clupack paper" (paper for packaging), creped paper, clay-coated paper, topcoat paper, synthetic paper, plastic-laminated paper, and plastic-coated paper. Examples of the metallic materials include aluminum materials and copper materials.

As materials for the fiber protector for use in the present invention, plastic materials, fibrous materials, and paper materials are preferred, of which plastic materials are more preferred. Each of these materials for the fiber protector can be used alone or in combination.

A fiber protector which is lightweight and has good flexibility can be advantageously used. From the viewpoints of lightness in weight and flexibility, the fiber protector is preferably a member in a thin leaf form and is particularly preferably a member in a sheet form. From these viewpoints, plastic materials are preferred as materials for the fiber protector. Among them, more preferred are olefin resins, of which ethylene polymers and/or propylene polymers containing at least an ethylene monomer and/or propylene monomer, such as polyethylenes, polypropylenes, and ethylene-propylene copolymers are particularly preferred; and polyester resins, of which poly(ethylene terephthalate)s are particularly preferred.

The thickness (or height) of the fiber protector is not particularly limited; however, it should be such a thickness as to suppress or prevent the electromagnetically conductive/absorptive fibrous protrusion from flattening (falling sideways). The thickness can be selected as appropriate according typically to the thickness (or height) of the electromagnetically conductive/absorptive fibrous protrusion. More specifically, the thickness (or height) of the fiber protector can be such a thickness as to be, for example, 10% to 250%, preferably 20% to 200%, more preferably 80% to 150%, and particularly preferably 90% to 120%, of the thickness (or height) of a portion of the electromagnetically conductive/absorptive fibrous protrusion positioned outward from the surface of the substrate. If the fiber protector has a thickness of less than 10% of the thickness of a portion of the electromagnetically conductive/absorptive fibrous protrusion positioned outward from the surface of the substrate, the flattening of the electromagnetically conductive/absorptive fibrous protrusion may not be effectively suppressed or prevented. In contrast, if it exceeds 250%, the thickness of the fiber protector may be excessively large, thereby be economically disadvantageous, and the structure may have, for example, insufficient flexibility, plasticity, and/or lightness in weight.

A process for preparing the fiber protector is not particularly limited. When the fiber protector is, for example, a member having one or more through holes typified by a net-like member or a perforated sheet member, the member having one or more through holes may be prepared according to a process of forming one or more through holes in a member having no through hole typically by perforating; or a process of using a material for the member in such a manner that a through hole is formed. More specifically, when the fiber protector is composed of a member having one or more through holes typified by a net-like member or a perforated sheet member and is made from a plastic material, such a member made from a plastic material and having a through hole, typified by a net-like member or a perforated sheet member made from a plastic material, the member can be prepared, for example, according to a process of forming a through hole in a predetermined portion of a member having no through hole typically by perforating; or a process of hot-melting a plastic material and carrying out, for example, gravure printing in such a manner as to form a through hole. In the latter process, for example, a roll with a convex portion or a concave portion may be used.

The fiber protector may be colored to the same color as that of fibers of the electromagnetically conductive/absorptive fibrous protrusion typically from the viewpoint of the appearance of the structure. The fiber protector may have electromagnetic conductivity/absorptivity, from the viewpoint of improving the electromagnetic conductivity/absorptivity of the structure. In addition, a surface of the fiber protector, typified by an outside surface when the fiber protector is arranged on a surface of the substrate, may constitute a release surface with respect to a pressure-sensitive adhesive layer or an adhesive layer. The release surface may be, for example, a surface composed of a layer of a releasing agent.

(Electromagnetic Conductive/Absorptive Fibrous Protrusion)

In a structure according to the present invention, an electromagnetically conductive/absorptive fibrous protrusion is partially arranged in the substrate so that at least a part of a fiber of the fibrous protrusion is positioned outward (in the outer surface side) from a surface of the substrate, as is described above. The shape or configuration of the electromagnetically conductive/absorptive fibrous protrusion is not particularly limited, as long as at least a part of a fiber of the fibrous protrusion is positioned outward from a surface of the substrate, and the fibrous protrusion has electromagnetic conductivity/absorptivity. More specifically, examples of the configuration of the electromagnetically conductive/absorptive fibrous protrusion include (1) a configuration in which the electromagnetically conductive/absorptive fibrous protrusion is partially arranged on a surface of the substrate; and (2) a configuration in which a concave is partially arranged in the substrate, and the electromagnetically conductive/absorptive fibrous protrusion is arranged on a wall surface of the concave in such a manner that at least a part of a fiber thereof protrudes outward (in the external side) from the surface of the substrate.

Of these configurations of the electromagnetically conductive/absorptive fibrous protrusion, the configuration (1) may be said to have a portion in which all fibers are positioned outward from the surface of the substrate, since the electromagnetically conductive/absorptive fibrous protrusion is arranged on the surface of the substrate. The configuration (2) may be said to have a portion in which at least a part of the fibers (moreover, at least a part of one fiber) is positioned outward from the surface of the substrate, since the electromagnetically conductive/absorptive fibrous protrusion is arranged on the wall surface of a concave in the substrate. In this way, in the electromagnetically conductive/absorptive fibrous protrusion, it is not always required that all fibers are positioned outward (in the external side) from the surface of the substrate. It is only required that at least a part of the fiber (e.g., when the electromagnetically conductive/absorptive fibrous protrusion is arranged on the wall surface of a concave of the substrate, a fiber formed in the upper side of the wall surface of the concave of the substrate) is positioned outward from the surface of the substrate.

Furthermore, as the fiber which is positioned outward from the surface of the substrate, it is not always required that the full length of one fiber is positioned outward from the surface of the substrate. It is only required that at least a part of one fiber is positioned outward from the surface of the substrate.

In addition, when the electromagnetically conductive/absorptive fibrous protrusion is arranged on the wall surface of a concave in the substrate, it is not always required that the electromagnetically conductive/absorptive fibrous protrusion is arranged on the entire surface of the wall surface of the concave of the substrate. It is only required that the electromagnetically conductive/absorptive fibrous protrusion is arranged in at least a part of the wall surface of the concave of the substrate.

The electromagnetically conductive/absorptive fibrous protrusion may be a structural section having a shape, in which at least a part of the fiber is positioned outward from the surface of the substrate and the shape is formed in a convex shape due to the fiber, and having electromagnetic conductivity/absorptivity. Examples thereof include a fiber-raised section having electromagnetic conductivity/absorptivity (hereinafter also referred to as "electromagnetically conductive/absorptive fiber-raised section") of a structure in which the fiber stands up from the surface on which the fiber is arranged; and an electromagnetically conductive/absorptive fibrous protrusion of a structure in which a mass of the fiber is provided on the surface on which the fiber is arranged. Specifically, when the electromagnetically conductive/absorptive fibrous protrusion is arranged on the surface of the substrate, examples thereof include an electromagnetically conductive/absorptive fiber-raised section having a structure in which the fiber stands up from the surface of the substrate; and an electromagnetically conductive/absorptive fibrous protrusion of a structure in which a mass of the fiber is provided on the surface of the substrate. When the electromagnetically conductive/absorptive fibrous protrusion is arranged on the wall surface of a concave in the substrate, examples thereof include an electromagnetically conductive/absorptive fiber-raised section having a structure in which at least a part of the fiber stands up from the wall surface of a concave of the substrate and stands up protruded outward from the surface of the substrate (in particular, the end of the fiber protrudes); and an electromagnetically conductive/absorptive fibrous protrusion having a structure in which a mass of the fiber is provided on the wall surface of a concave of the substrate and a part of the fiber protrudes outward from the surface of the substrate. The electromagnetically conductive/absorptive fibrous protrusion may be composed of a single structure or a structure of a combination of two or more structures.

In this connection, one electromagnetically conductive/absorptive fibrous protrusion is usually composed of plural fibers. The number and density of fibers which constitute one electromagnetically conductive/absorptive fibrous protrusion are not particularly limited but can be properly selected depending upon the desired electromagnetic conductivity/absorptivity.

As the electromagnetically conductive/absorptive fibrous protrusion, an electromagnetically conductive/absorptive fiber-raised section of a structure in which the fiber stands up from the surface on which the fiber is formed, is preferred, of which an electromagnetically conductive/absorptive fiber-raised section having a structure in which the fiber stands up from the surface of the substrate is more preferred.

Examples of the structure of such an electromagnetically conductive/absorptive fiber-raised section include (1) a structure in which the fiber stands up in a substantially "I" shape and protrudes outward from the surface of the substrate so that one of the ends of one fiber is adhered and fixed to a predetermined surface of the substrate (e.g., the surface of the substrate or the wall surface of the concave), while the other end is not fixed (it is free); (2) a.structure in which the fiber stands up in a substantially "V" shape and protrudes outward from the surface of the substrate so that the center of one fiber is adhered to a predetermined surface of the substrate (e.g., the surface and the wall surface of the concave), while the both ends of the fiber are not fixed (they are free); (3) a structure in which the fiber stands up in a substantially inverse "U" shape and protrudes outward from the surface of the substrate so that the both ends of one fiber are adhered and fixed to a predetermined surface of the substrate (e.g., the surface of the substrate or the wall surface of the concave), while the center of the fiber is not fixed (it is free); a structure in which the fiber stands up in a shape such as a substantially "W" shape, a substantially "M" shape, a substantially "N" shape, or a substantially "O" shape from a predetermined surface of the substrate (e.g., the surface of the substrate or the wall surface of the concave) and protrudes outward from the surface of the substrate; and a combined structure of these structures. As the electromagnetically conductive/absorptive fiber-raised section, the structure (1) is suitable, in which the fiber stands up in a substantially "I" shape from a predetermined surface of the substrate, such as the surface of the substrate or the wall surface of the concave, and protrudes outward from the surface of the substrate.

As a matter of course, the electromagnetically conductive/absorptive fiber-raised section may be such that the fiber linearly stands up in an "I" shape, etc., from a predetermined surface of the substrate (e.g., the surface of the substrate or the wall surface of the concave) and protrudes outward from the surface of the substrate, or such that the fiber entirely stands so as to have, for example, a jagged form, a wave line form, or a loop form and protrudes outward from the surface of the substrate.

The electromagnetically conductive/absorptive fibrous protrusion is partially arranged in the substrate; and the shape as a whole is not particularly limited, but it may have a predetermined patterned shape. When the electromagnetically conductive/absorptive fibrous protrusion is arranged on the wall surface of the concave in the substrate, the entire shape of the electromagnetically conductive/absorptive fibrous protrusion corresponds to the entire shape of the concave.

The total area of a portion or portions of the substrate where the electromagnetically conductive/absorptive fibrous protrusion is arranged (the area of entire electromagnetically conductive/absorptive fibrous protrusion) is not particularly limited; however, the total area is preferably such an area to be, for example, more than 0% and equal to or less than 99.9% of the total surface area of one surface of the substrate, from the viewpoint of satisfactory electromagnetic conductivity/absorptivity. The area of entire electromagnetically conductive/absorptive fibrous protrusion can be selected as appropriate depending on how the structure is used and how large the surface area of one surface of the structure is, as in the percentage of holes of the member having one or more through holes. More specifically, a structure according to the present invention may be used as an electromagnetic shielding material typically for use in an electronic component typified by an electronic component for use in a "mobile phone"; alternatively, the structure may have a small surface area (e.g., 500 $mm^2$ or less) of one surface thereof. In these cases, the total area of entire electromagnetically conductive/absorptive fibrous protrusion(s) is preferably 0.3% to 99.8%, more preferably 30% to 90%, and particularly preferably 45% to 80%. In contrast, a structure according to the present invention may be used, for example, as an electromagnetic shielding material for building; for example, the structure may be used as a member constituting places (wall plane, ceiling plane, and floor plane) of the building or may be affixed to a constituting material thereof such as a board or floor material before use. Alternatively, the structure may have a large surface area (e.g., 0.5 $m^2$ or more) of one surface thereof. In these cases, the total area of the entire electromagnetically conductive/absorptive fibrous protrusion(s) is preferably 0.03% to 99.8%, more preferably 0.1% to 50%, and particularly preferably 0.3% to 40%. If the total area of the entire electromagnetically conductive/absorptive fibrous protrusion(s) on the surface of the substrate is excessively small with respect to the total surface area of one surface (one side) of the substrate, the electromagnetic conductivity/absorptivity may decrease. In contrast, if the total area of the entire electromagnetically conductive/absorptive fibrous protrusion(s) on the surface of the substrate is more than 99.9% of the total surface area of one surface (one side) of the substrate, the ratio of a portion where the fiber protector is arranged may be excessively small, and the flattening of the electromagnetically conductive/absorptive fibrous protrusion may not be satisfactorily prevented.

The areas of respective electromagnetically conductive/absorptive fibrous protrusions on the surface of the substrate, and the shortest interval between electromagnetically conductive/absorptive fibrous protrusions are not particularly limited.

As the area of the electromagnetically conductive/absorptive fibrous protrusion in the surface of the substrate, an area of a portion surrounded by the electromagnetically conductive/absorptive fibrous protrusion can be employed. Accordingly, when the electromagnetically conductive/absorptive fibrous protrusion is arranged on the wall surface of the concave in the substrate, the area of the electromagnetically conductive/absorptive fibrous protrusion in the surface of the substrate corresponds to the area of an opening of the concave in the surface of the substrate.

Such an electromagnetically conductive/absorptive fibrous protrusion can be composed of a fiber having electromagnetic conductivity/absorptivity (hereinafter also referred to as "electromagnetically conductive/absorptive fiber"). Though the electromagnetically conductive/absorptive fiber is not particularly limited, it may be a fiber in which a fiber raw material itself has electromagnetic conductivity/absorptivity (hereinafter also referred to as "electromagnetically conductive/absorptive raw-material fiber") or may be a fiber in which electromagnetic conductivity/absorptivity is imparted to a fiber raw material by an electromagnetically conductive/absorptive material (hereinafter also referred to as "electromagnetic conductivity/absorptivity-imparted fiber"). Each of these electromagnetically conductive/absorptive fibers may be used alone or in combination.

As the fiber constituting the electromagnetically conductive/absorptive fibrous protrusion, a fiber not having electromagnetic conductivity/absorptivity (hereinafter also referred to as "electromagnetically non-conductive/non-absorptive fiber") may be used together with an electromagnetically conductive/absorptive fiber. In this way, when an electromagnetically non-conductive/non-absorptive fiber is used together with an electromagnetically conductive/absorptive fiber, the electromagnetically conductive/absorptive fiber and the electromagnetically non-conductive/non-absorptive fiber may be used as different separate yarns from each other or may be used as a single yarn. That is, the electromagnetically conductive/absorptive fibrous protrusion may be composed of a yarn composed of only the electromagnetically conductive/absorptive fiber and a yarn composed of only the electromagnetically non-conductive/non-absorptive fiber or may be composed of a twisted yarn of the electromagnetically conductive/absorptive fiber and the electromagnetically non-conductive/non-absorptive fiber. Examples of the electromagnetically non-conductive/non-absorptive fiber include a cotton fiber, a rayon fiber, a polyamide-based fiber, a polyester-based fiber, a polyacrylonitrile-based fiber, an acrylic fiber, a poly(vinyl alcohol) fiber, a polyethylene-based fiber, a polyimide-based fiber, a polyolefinic fiber, a silicone-based fiber, and a fluorine-contained resin fiber.

Of the electromagnetically conductive/absorptive fibers, a fiber composed of a material in which the fiber raw material itself has electromagnetic conductivity/absorptivity can be used as the electromagnetically conductive/absorptive raw-material fiber. Examples of the electromagnetically conductive/absorptive raw-material fiber include a metallic fiber in addition to a carbonaceous fiber and a fiber made of an electroconductive polymer. Examples of the carbonaceous fiber include a fiber made of a carbonaceous raw material such as carbon black. The electroconductive polymer in the fiber made of an electroconductive polymer is not particularly limited, and examples thereof include a polyacetylene-based electroconductive polymer, a polypyrrole-based electroconductive polymer, a polyacene-based electroconductive polymer, a polyphenylene-based electroconductive polymer, a polyaniline-based electroconductive polymer, and a polythiophene-based electroconductive polymer. The metallic fiber is not particularly limited, and, for example, it can be properly selected among fibers made of a metallic material as specifically exemplified below. Specific examples of the metallic fiber include fibers made of a metal element, such as a gold fiber, a silver fiber, an aluminum fiber, an iron fiber, a copper fiber, a nickel fiber, a stainless steel-based fiber, and a copper-nickel alloy fiber; and fibers made of a metallic compound of every kind including metal elements and non-metal elements, such as a copper sulfide fiber.

Of the electromagnetically conductive/absorptive fibers, the electromagnetic conductivity/absorptivity-imparted fiber is not particularly limited, as long as it is a fiber in a form that electromagnetic conductivity/absorptivity is imparted by an electromagnetically conductive/absorptive material. Examples thereof include a fiber coated by an electromagnetically conductive/absorptive material (hereinafter also referred to as "electromagnetically conductive/absorptive material-coated fiber"); a fiber having an electromagnetically conductive/absorptive material impregnated therewith (hereinafter also referred to as "electromagnetically conductive/absorptive material-impregnated fiber"); and a fiber containing an electromagnetically conductive/absorptive material in a fiber raw material (hereinafter also referred to as "electromagnetically conductive/absorptive material-containing raw-material fiber").

As the electromagnetic conductivity/absorptivity-imparted fiber, the electromagnetically conductive/absorptive material-coated fiber and the electromagnetically conductive/absorptive material-impregnated fiber can be suitably used. In the electromagnetically conductive/absorptive material-coated fiber and the electromagnetically conductive/absorptive material-impregnated fiber as the electromagnetic conductivity/absorptivity-imparted fiber, a fiber (fiber raw material) before the electromagnetic conductivity/absorptivity is imparted by the electromagnetically conductive/absorptive material is not particularly limited, and any of a natural fiber, a semisynthetic fiber, and a synthetic fiber may be employed. The fiber raw material (fiber) may be an electromagnetically conductive/absorptive fiber or may be an electromagnetically non-conductive/non-absorptive fiber. More specifically, examples of the fiber raw material (fiber) include an electromagnetically non-conductive/non-absorptive fiber such as a cotton fiber, a rayon fiber, a polyamide-based fiber [for example, an aliphatic polyamide fiber and an aromatic polyamide fiber (so-called aramid fiber)], a polyester-based fiber (e.g., a product under the trade name of "TETRON"), a polyacrylonitrile-based fiber, an acrylic fiber, a poly(vinyl alcohol) fiber (so-called vinylon fiber), a polyethylene-based fiber, a polyimide-based fiber, a polyolefinic fiber, a silicone-based fiber, and a fluorine-contained resin fiber; and an electromagnetically conductive/absorptive fiber such as a carbon fiber (carbonaceous fiber). As the fiber raw material, an electromagnetically non-conductive/non-absorptive fiber is preferable; of which a cotton fiber, a rayon fiber, a polyamide-based fiber, and a polyester-based fiber are especially preferable. Each of such fiber raw materials may be used alone or in combination.

In the electromagnetically conductive/absorptive material-coated fiber as the electromagnetic conductivity/absorptivity-imparted fiber, the electromagnetically conductive/absorptive material is not particularly limited and includes, for example, a metallic material, a plastic material having electromagnetic conductivity/absorptivity (hereinafter also referred to as "electromagnetically conductive/absorptive plastic material"), and a magnetic material of every kind. Of these, a metallic material can be suitably used. Each of these electromagnetically conductive/absorptive materials can be used alone or in combination. In the electromagnetically conductive/absorptive material-coated fiber, the metallic material may be a metallic material composed of only a metal element such as an elementary metal and an alloy or may be a metallic compound of every kind containing a non-metal element together with a metal element. As the metallic material, a metallic material composed of only a metal element is suitable. Specifically, examples of the metal element in the metallic material composed of an elementary metal include elements belonging to Group 1 of the Periodic Table, such as lithium, sodium, potassium, rubidium, and cesium; elements belonging to Group 2 of the Periodic Table, such as magnesium, calcium, strontium, and barium; elements belonging to Group 3 of the Periodic Table, such as scandium, yttrium, lanthanoids (e.g., lanthanum and cerium), and actinoids (e.g., actinium); elements belonging to Group 4 of the Periodic Table, such as titanium, zirconium, and hafnium; elements belonging to Group 5 of the Periodic Table, such as vanadium, niobium, and tantalum; elements belonging to Group 6 of the Periodic Table, such as chromium, molybdenum, and tungsten; elements belonging to Group 7 of the Periodic Table, such as manganese, technetium, and rhenium; elements belonging to Group 8 of the Periodic Table, such as iron, ruthenium, and osmium; elements belonging to Group 9 of the Periodic Table, such as cobalt, rhodium, and iridium; elements belonging to Group 10 of the Periodic Table, such as nickel, palladium, and platinum; elements belonging to Group 11 of the Periodic Table, such as copper, silver, and gold; elements belonging to Group 12 of the Periodic Table, such as zinc, cadmium, and mercury; elements belonging to Group 13 of the Periodic Table, such as aluminum, gallium, indium, and thallium; elements belonging to Group 14 of the Periodic Table, such as tin and lead; and elements belonging to Group 15 of the Periodic Table, such as antimony and bismuth. Examples of the alloy include stainless steel, a copper-nickel alloy, brass, a nickel-chromium alloy, an iron-nickel alloy, a zinc-nickel alloy, a gold-copper alloy, a tin-lead alloy, a silver-tin-lead alloy, a nickel-chromium-iron alloy, a copper-manganese-nickel alloy, and a nickel-manganese-iron alloy.

The metallic compound of every kind containing a non-metal element together with a metal element is not particularly limited, as long as it is a metallic compound containing a metal element or an alloy as exemplified previously and capable of exhibiting electromagnetic conductivity/absorptivity. Examples thereof include metal sulfides such as copper sulfide; metal oxides such as iron oxide, titanium oxide, tin oxide, indium oxide, and cadmium tin oxide; and metal multiple oxides.

Specifically, gold, silver, aluminum, iron, copper, nickel, stainless steel, and a copper-nickel alloy can be suitably used as the metallic material. In particular, gold, silver, aluminum, copper, nickel, and a copper-nickel alloy can be more suitably used.

Examples of the electromagnetically conductive/absorptive plastic material include electroconductive plastic materials including, e. g., electroconductive polymers such as a polyacetylene-based electroconductive polymer, a polypyrrole-based electroconductive polymer, a polyacene-based electroconductive polymer, a polyphenylene-based electroconductive polymer, a polyaniline-based electroconductive polymer, and a polythiophene-based electroconductive polymer.

The magnetic material is not particularly limited, and examples thereof include soft magnetic powders, ferrites, and zinc oxide whiskers. As the magnetic material, a ferromagnetic material exhibiting ferromagnetism or ferrimagnetism is suitable. Specific examples of the magnetic material include high-permeability ferrites (e.g., so-called soft ferrite" (e.g., so-called "Mn ferrite", so-called "Ni ferrite", so-called "Zn ferrite", so-called "Mn-Zn ferrite", and so-called "Ni-Zn ferrite")), pure iron, silicon-containing iron (e.g., so-called "silicon steel"), a nickel-iron alloy (e.g., so-called "permalloy" (e.g., a nickel-manganese-iron alloy, a nickel-molybdenum-copper-iron alloy, and a nickel-molybdenum-manganese-iron alloy)), an iron-cobalt alloy, an amorphous metal high-permeability material, an iron-aluminum-silicon alloy (e.g., so-called "Sendust alloy"), an iron-aluminum-silicon-nickel alloy (e.g., so-called "Super Sendust alloy"), so-called "ferrite magnet" (e.g., so-called "hard ferrite" (e.g., so-called "Ba ferrite" and so-called "Sr ferrite")), so-called "Alnico magnet" (e.g., an iron-nickel-aluminum-cobalt alloy), an iron-chromium-cobalt alloy, so-called "rare earth cobalt magnet" (e.g., so-called "Sm-Co magnet" and so-called "2-17 type magnet"), so-called "Nd-Fe-B magnet", so-called "rare earth-iron-nitrogen interstitial compound magnet", and so-called "Mn-Al-C magnet."

In the electromagnetically conductive/absorptive material-coated fiber, a process for applying an electromagnetically conductive/absorptive material on a fiber raw material is not particularly limited, but a known coating process can be properly selected and applied depending upon the type of the electromagnetically conductive/absorptive material. For example, when the electromagnetically conductive/absorptive material is a metallic material, a coating process by vapor deposition of a metallic material and a coating process by plating of a metallic material are suitable as a process for forming the electromagnetically conductive/absorptive material-coated fiber.

In the electromagnetically conductive/absorptive material-impregnated fiber as the electromagnetic conductivity/absorptivity-imparted fiber, usable examples of the electromagnetically conductive/absorptive material include electromagnetically conductive/absorptive materials, such as a metallic material, an electromagnetically conductive/absorptive plastic material, and a magnetic material, as with the electromagnetically conductive/absorptive material in the above-mentioned electromagnetically conductive/absorptive material-coated fiber. Among them, metallic materials are suitable, of which gold, silver, aluminum, copper, nickel, and a copper-nickel alloy are more suitable. In the electromagnetically conductive/absorptive material-impregnated fiber, a method for impregnating the fiber raw material with the electromagnetically conductive/absorptive material is not particularly limited, but a known impregnation method can be properly selected and applied depending upon the type of the electromagnetically conductive/absorptive material. When the electromagnetically conductive/absorptive material is, for example, a metallic material, an impregnation method for dipping the fiber raw material into the metallic material is suitable as a method for forming the electromagnetically conductive/absorptive material-impregnated fiber.

In the electromagnetically conductive/absorptive material-containing raw-material fiber as the electromagnetic conductivity/absorptivity-imparted fiber, usable examples of the electromagnetically conductive/absorptive material include electromagnetically conductive/absorptive materials such as a metallic material, an electromagnetically conductive/absorptive plastic material, and a magnetic material as with the electromagnetically conductive/absorptive material in the above-mentioned electromagnetically conductive/absorptive material-coated fiber. Among them, metallic materials are suitable, of which gold, silver, aluminum, copper, nickel, and a copper-nickel alloy are more suitable. The electromagnetically conductive/absorptive material such as a metallic material may have a form of every kind such as a powdery form, a film form, a foil form, a thin-layer form, or a fibrous form. Furthermore, as a material of the fiber raw material in the electromagnetically conductive/absorptive material-containing raw-material fiber, suitable is a plastic material such as a polyamide, a polyester, polyacrylonitrile, an acrylic resin, poly(vinyl alcohol), polyethylene, a polyimide, a polyolefin resin, a silicone resin, and a fluorine-contained resin. In the electromagnetically conductive/absorptive material-containing raw-material fiber, a process for incorporating the electromagnetically conductive/absorptive material into the fiber raw material is not particularly limited, and a known containing process can be properly selected and applied depending upon the type of the electromagnetically conductive/absorptive material. An example of such process is a process for incorporating the electromagnetically conductive/absorptive material into the fiber raw material by mixing a material as the fiber raw material with the electromagnetically conductive/absorptive material typically by kneading, and then fibrillating the mixture.

As the electromagnetically conductive/absorptive fiber for use in the present invention, at least one fiber selected from an electromagnetically conductive/absorptive material-coated fiber, an electromagnetically conductive/absorptive material-impregnated fiber, and an electromagnetically conductive/absorptive raw-material fiber can be suitably used. Accordingly, the electromagnetically conductive/absorptive fibrous protrusion can be suitably composed of at least one fiber selected from an electromagnetically conductive/absorptive material-coated fiber, an electromagnetically conductive/absorptive material-impregnated fiber, and an electromagnetically conductive/absorptive raw-material fiber.

A short fiber can be suitably used as such an electromagnetically conductive/absorptive fiber (or fiber raw material). When the length of the electromagnetically conductive/absorptive fiber is excessively long, the electromagnetically conductive/absorptive fibrous protrusion may be likely to flatten (fall sideways). The electromagnetically conductive/absorptive fiber (or fiber raw material) desirably has a length of from about 0.1 to 5 mm, preferably from about 0.3 to 5 mm, and more preferably from about 0.3 to 2 mm. In this connection, when the length of the electromagnetically conductive/absorptive fiber is too short, the production may be difficult and the costs may become high, and therefore, such is not preferable from the viewpoint of cost.

The thickness of the electromagnetically conductive/absorptive fiber (or fiber raw material) is not particularly limited, and it can be selected, for example, within a range of from about 0.1 to 20 deniers, preferably from about 0.5 to 15 deniers, and more preferably from about 1 to 6 deniers. When the thickness of the electromagnetically conductive/absorptive fiber is too large, for example, the flexibility and plasticity of the structure may decrease. In contrast, when the thickness of the electromagnetically conductive/absorptive fiber is too small, the handling properties may be impaired, and therefore, such is not preferable.

The thickness of the electromagnetically conductive/absorptive fiber (or fiber raw material) may be defined or set by the diameter thereof. The diameter of the electromagnetically conductive/absorptive fiber may be selected, for example, within a range of from 5 to 100 $\mu$m, preferably from 10 to 50 $\mu$m, and more preferably from 15 to 45 $\mu$m.

As the electromagnetically conductive/absorptive fiber, two or more different electromagnetically conductive/absorptive fibers or an electromagnetically conductive/absorptive fiber using two or more different electromagnetically conductive/absorptive materials are preferably used. Among them, two or more different electromagnetically conductive/absorptive fibers can be suitably used. Two or more kinds of electromagnetically conductive/absorptive fibers, when used as the electromagnetically conductive/absorptive fiber, may be used as different separate yarns from each other or may be used as a single yarn. Specifically, the electromagnetically conductive/absorptive fibrous protrusion may be composed of two or more different yarns composed of two or more different electromagnetically conductive/absorptive fibers or may be composed of a twisted yarn using two or more different electromagnetically conductive/absorptive fibers. In this way, a structure corresponding to wide electromagnetic waves as described below can be obtained by using, for example, two or more different electromagnetically conductive/absorptive fibers as the electromagnetically conductive/absorptive fiber.

A process for forming the electromagnetically conductive/absorptive fibrous protrusion (in particular, the electromagnetically conductive/absorptive fiber-raised section) is not particularly limited, but a flocking process (in particular, an electrostatic flocking process) can be suitably applied as described below. As the electrostatic flocking process, any of an up process, a down process and a side process may be employed. When the electromagnetically conductive/absorptive fibrous protrusion is formed in a predetermined position on the surface of the substrate by the flocking process, it is preferred to arrange, before flocking, a member (in particular, a net-like member) having one or more through holes in a position corresponding to a predetermined site on the surface of the substrate in which the electromagnetically conductive/absorptive fibrous protrusion is to be arranged. When the electromagnetically conductive/absorptive fibrous protrusion is formed on the wall surface of the concave in the substrate by the flocking process, it is preferred to arrange a member (in particular, a net-like member) in a predetermined position of the surface of the substrate before flocking, in which the member has one or more through holes in a position corresponding to the concave of the substrate (the concave in which the electromagnetically conductive/absorptive fibrous protrusion is to be arranged).

(Substrate)

A substrate where the electromagnetically conductive/absorptive fibrous protrusion is arranged is not particularly limited, as long as it can ensure fluidity or pressure-sensitive adhesive or adhesive properties in forming the electromagnetically conductive/absorptive fibrous protrusion. The substrate can have whichever form of a single layer form and a multilayered form (stacked layer form). In the present invention, a pressure-sensitive adhesive layer, an adhesive layer and/or a polymer layer is advantageously used as the substrate, as illustrated in Figs. 3(a), 3(b), and 3(c). Among them, a pressure-sensitive adhesive layer or an adhesive layer (hereinafter also referred to as "pressure-sensitive adhesive or adhesive layer") is desirable. Fig. 3 shows schematic cross-sectional views showing structures according to embodiments of the present invention. Fig. 3 illustrates a structure 3a, a pressure-sensitive adhesive or adhesive layer (pressure-sensitive adhesive layer or adhesive layer) 3a1, a base material 3a2, an electromagnetically conductive/absorptive fiber-raised section 3a3, a fiber protector 3a4, a structure 3b, a pressure-sensitive adhesive layer 3b1, a release liner 3b2, an electromagnetically conductive/absorptive fiber-raised section 3b3, a fiber protector 3b4, a structure 3c, a polymer layer 3c1, an electromagnetically conductive/absorptive fiber-raised section 3c2, and a fiber protector 3c3. The structure 3a illustrated in Fig. 3(a) has a configuration in which the pressure-sensitive adhesive or adhesive layer 3a1 serving as a substrate is arranged on one side of the base material 3a2 serving as a support; the electromagnetically conductive/absorptive fiber-raised section 3a3 serving as an electromagnetically conductive/absorptive fibrous protrusion is partially arranged on a surface of the pressure-sensitive adhesive or adhesive layer 3al; and the fiber protector 3a4 is arranged in a portion (or part) of the surface of the pressure-sensitive adhesive or adhesive layer 3a1 where no electromagnetically conductive/absorptive fiber-raised section 3a3 is arranged. The structure 3b illustrated in Fig. 3(b) has a configuration in which the pressure-sensitive adhesive layer 3b1 serving as a substrate is arranged on one side of the release liner 3b2 serving as a support; the electromagnetically conductive/absorptive fiber-raised section 3b3 serving as an electromagnetically conductive/absorptive fibrous protrusion is partially arranged on a surface of the pressure-sensitive adhesive layer 3b1; and the fiber protector 3b4 is arranged in a portion of the surface of the pressure-sensitive adhesive layer 3b1 where no electromagnetically conductive/absorptive fiber-raised section 3b3 is arranged. The structure 3c illustrated in Fig. 3(c) has a configuration in which the electromagnetically conductive/absorptive fiber-raised section 3c2 serving as an electromagnetically conductive/absorptive fibrous protrusion is partially arranged on a surface of the polymer layer 3c1 serving as a substrate; and the fiber protector 3c3 is arranged in a portion of the surface of the polymer layer 3c1 where no electromagnetically conductive/absorptive fiber-raised section 3c2 is arranged.

In such a pressure-sensitive adhesive layer or adhesive layer (pressure-sensitive adhesive or adhesive layer) as the substrate, a pressure-sensitive adhesive constituting the pressure-sensitive adhesive layer is not particularly limited, and usable examples thereof include known pressure-sensitive adhesives such as a rubber pressure-sensitive adhesive, an acrylic pressure-sensitive adhesive, a polyester pressure-sensitive adhesive, a urethane pressure-sensitive adhesive, a polyamide pressure-sensitive adhesive, an epoxy pressure-sensitive adhesive, a vinyl alkyl ether pressure-sensitive adhesive, a silicone pressure-sensitive adhesive, and a fluorine pressure-sensitive adhesive. The pressure-sensitive adhesive may be a hot melt pressure-sensitive adhesive. An adhesive constituting the adhesive layer is not particularly limited, and usable examples thereof include known adhesives such as a rubber adhesive, an acrylic adhesive, a polyester adhesive, a urethane adhesive, a polyamide adhesive, an epoxy adhesive, a vinyl alkyl ether adhesive, a silicone adhesive, and a fluorine adhesive. In addition, the adhesive may be a heat-sensitive adhesive. Each of such pressure-sensitive adhesives and adhesives can be used alone or in combination. The pressure-sensitive adhesive or adhesive may be a pressure-sensitive adhesive or adhesive of any form such as an emulsion form, a solvent form, an oligomer form, and a solid form.

The pressure-sensitive adhesive or adhesive may contain appropriate additives depending typically upon the type of the pressure-sensitive adhesive or adhesive, in addition to a polymer component (base polymer) such as a pressure-sensitive adhesive component or adhesive component. Examples of the additives include crosslinking agents such as a polyisocyanate crosslinking agent and an alkyl etherified melamine compound crosslinking agent; tackifiers such as a rosin derivative resin, a polyterpene resin, a petroleum resin, and a phenol resin; plasticizers; fillers; and antiaging agents. When the pressure-sensitive adhesive layer or adhesive layer is formed through crosslinking, the crosslinking can be carried out according to a known crosslinking process such as a heat crosslinking process by heating, an ultraviolet ray crosslinking process by irradiation with ultraviolet rays (UV crosslinking process), an electron beam crosslinking process by irradiation with electron beams (EB crosslinking process), and a spontaneous curing process for achieving spontaneous curing at room temperature and the like.

A pressure-sensitive adhesive layer is suitable as the pressure-sensitive adhesive or adhesive layer for use in the present invention. As the pressure-sensitive adhesive constituting the pressure-sensitive adhesive layer, a rubber pressure-sensitive adhesive and an acrylic pressure-sensitive adhesive can be suitably used.

A process for forming a pressure-sensitive adhesive or adhesive layer can be, for example, a known process for forming a pressure-sensitive adhesive layer or a known process for forming an adhesive layer, such as a coating forming process and a transfer forming process. The forming process can be properly selected depending typically upon the type, shape, and size of the structure or support on which the pressure-sensitive adhesive or adhesive layer is to be arranged. Specifically, for example, when a pressure-sensitive adhesive layer is formed on the base material serving as a support as mentioned below, examples of the process for forming a pressure-sensitive adhesive layer include a process of applying a pressure-sensitive adhesive to the base material (coating process); and a process of applying a pressure-sensitive adhesive to a release film such as a release liner to form a pressure-sensitive adhesive layer and then transferring the subject pressure-sensitive adhesive layer onto the base material (transfer process). For example, when a pressure-sensitive adhesive layer is formed on a release liner of a support as mentioned below, examples of the process for forming a pressure-sensitive adhesive layer include a process of applying a pressure-sensitive adhesive on a release surface of the release liner (coating process). When an adhesive layer is formed on the base material serving as a support, examples of the process for forming an adhesive layer include a process of applying an adhesive to a predetermined surface of the base material (coating process).

A polymer component for constituting the polymer layer of a substrate is not particularly limited, but one or more kinds of known polymer components can be properly selected and used. Examples of such polymer components include resin components such as a thermoplastic resin, a thermosetting resin, and an ultraviolet ray-curable resin; rubber components; and elastomer component. More specifically, of the polymer components constituting the polymer layer, examples of the resin components include an acrylic resin, a styrene resin, a polyester resin, a polyolefin resin, a polyvinyl chloride resin, a vinyl acetate resin, a polyamide resin, a polyimide resin, a urethane resin, an epoxy resin, a fluorine-contained resin, a silicone resin, poly(vinyl alcohol), a polycarbonate, a polyacetal, a polyetherimide, a polyamide-imide, a polyesterimide, a poly(phenylene ether), a poly(phenylene sulfide), a poly(ether sulfone), a poly(ether ether ketone), a poly(ether ketone), a polyallylate, a polyaryl, and a polysulfone. Examples of the rubber components include natural rubbers and synthetic rubbers, such as a polyisobutylene, a polyisoprene, a chloroprene rubber, a butyl rubber, and a nitrile butyl rubber. Examples of the elastomer component include a variety of thermoplastic elastomers such as an olefinic thermoplastic elastomer, a styrenic thermoplastic elastomer, a polyester thermoplastic elastomer, a polyamide thermoplastic elastomer, a polyurethane thermoplastic elastomer, and an acrylic thermoplastic elastomer.

The thickness of the substrate such as a pressure-sensitive adhesive or adhesive layer or polymer layer is not particularly limited and can be selected within a range of, for example, from about 1 to 1000 $\mu$m, and preferably from

about 10 to 500 μm.

A concave may be partially arranged in the substrate (in particular, the pressure-sensitive adhesive layer). Though such a concave may be a depression or recess, it is preferably a hole (a through-hole). Of such holes, a perforated hole is especially suitable. In such a concave, conditions such as the shape as the whole of the concave, the shape of an opening in the surface of the substrate of the respective concave, the whole area of the openings in the surface of the substrate of the concaves, and the area of an opening in the surface of the substrate of the respective concave may be as with those in the above-mentioned electromagnetically conductive/absorptive fibrous protrusion. When the concave is a depression, its depth is not particularly limited but can be properly selected within the range of a depth corresponding to 1% or more, for example, from 1% to 99%, and preferably from 30% to 90% of the thickness of the substrate.

The pressure-sensitive adhesive layer serving as the substrate can be arranged on a release liner. In this case, a depression as the concave can be formed on at least one surface of the pressure-sensitive adhesive layer, and preferably on one surface of the pressure-sensitive adhesive layer. The pressure-sensitive adhesive layer of a substrate can be arranged on both surfaces of the base material serving as the support. In this case, the concave such as a depression or a hole can be arranged on at least one surface of the pressure-sensitive adhesive layer, and preferably on one surface of the pressure-sensitive adhesive layer. When the concave is a hole, examples of a process for forming a hole include a perforating process using a known and/or common hole forming machine [above all, a perforation forming machine having a convex structure of a shape of every kind (protruded structure) and a concave structure counterpart to the subject convex structure], a perforation process by heat or beams (e.g., a process for performing perforation typically with a thermal head, a halogen vapor lamp, a xenon lamp, a flash lamp, or a laser beam), and a molding process using a mold such as a mold having a convex. When the concave is a depression, a forming process the same as the process for forming a hole can be employed as a process for forming a depression.

The substrate for use in the present invention such as a pressure-sensitive adhesive or adhesive layer or a polymer layer desirably has electromagnetic conductivity/absorptivity from the viewpoint of further improving the electromagnetic conductivity/absorptivity of the structure. The substrate having electromagnetic conductivity/absorptivity can be composed of a composition containing an electromagnetically conductive/absorptive material such as a pressure-sensitive adhesive composition, an adhesive composition, or a polymer composition. An electromagnetically conductive/absorptive material which is used in the substrate is not particularly limited. Examples of usable electromagnetically conductive/absorptive materials include one or more kinds of electromagnetically conductive/absorptive materials such as a metallic material, an electromagnetically conductive/absorptive plastic material (e.g., an electroconductive plastic material), and a magnetic material. Examples of the metallic material, the electromagnetically conductive/absorptive plastic material, and the magnetic material include the above-exemplified metallic materials, electromagnetically conductive/absorptive plastic materials, and magnetic materials (e.g., a metallic material, an electromagnetically conductive/absorptive plastic material, and a magnetic material as exemplified in the above-mentioned electromagnetically conductive/absorptive fiber constituting the above-mentioned electro-magnetic conducting or absorbing fibrous protrusion). In this connection, the electromagnetically conductive/absorptive material such as a metallic material, an electromagnetically conductive/absorptive plastic material, or a magnetic material may have any form such as a powdery form, a film form, a foil form, or a thin-layer form.

The substrate, such as a pressure-sensitive adhesive composition, adhesive composition, or polymer composition, containing an electromagnetically conductive/absorptive material can be prepared by mixing a pressure-sensitive adhesive for constituting the pressure-sensitive adhesive layer, an adhesive for constituting the adhesive layer, or a polymer component for constituting the polymer layer with an electromagnetically conductive/absorptive material. Incidentally, the content of the electromagnetically conductive/absorptive material is not particularly limited but can be properly selected depending typically upon the pressure-sensitive adhesive properties or adhesive properties of the pressure-sensitive adhesive or the adhesive, and the electromagnetic conductivity/absorptivity of the pressure-sensitive adhesive or adhesive layer or the polymer layer. The content of the electromagnetically conductive/absorptive material, for example, is preferably from 3 to 98 percent by weight, and particularly preferably from 5 to 95 percent by weight, of the total amount of solids in the pressure-sensitive adhesive composition, adhesive composition, or polymer composition. When the content of the electromagnetically conductive/absorptive material is too small, the electromagnetic conductivity/absorptivity of the substrate may be lowered, while when it is too large, the pressure-sensitive adhesive properties or adhesive properties of the pressure-sensitive adhesive or adhesive layer, if used as the substrate, may be lowered.

(Support)

In a structure according to the present invention, a substrate (in particular, a pressure-sensitive adhesive or adhesive layer as the substrate) may be arranged on at least one surface of a support. When the substrate is arranged on each of both surfaces of the support, the electromagnetically conductive/absorptive fibrous protrusion and fiber protector can be arranged on only one substrate arranged on one surface of the support; alternatively, they may be arranged on each of the two substrates arranged on both surfaces of the support.

Such a support is not particularly limited but can be properly selected and used depending typically upon the type of the structure. The shape of the support may be any shape. Examples of the shape include spherical, columnar, polygonal, polygonal conical, conical, plate-like, and sheet-like shapes. A material for the support is not particularly limited, and any material is employable. Examples of the material include a plastic material, a metallic material, a fibrous material, and a paper material. Each of these materials may be used alone or in combination.

The support for use in the present invention preferably has a sheet form. When the support has a sheet form, the structure can be applied as a sheet-like structure having a sheet form. When the substrate is, for example, a pressure-sensitive adhesive or adhesive layer, usable examples of the support having a sheet form include a base material in a sheet form such as a base material for pressure-sensitive adhesive tape or sheet; and a release liner for pressure-sensitive adhesive tape or sheet. Specifically, when the structure is composed of, for example, a pressure-sensitive adhesive tape or sheet of a base material-provided type in which one or both surfaces thereof are a pressure-sensitive adhesive layer, a base material for pressure-sensitive adhesive tape or sheet can be used as the support. When the structure is composed of, for example, a double-sided pressure-sensitive adhesive tape or sheet of a base material-less type, a release liner (separator) for pressure-sensitive adhesive tape or sheet can be used as the support. When the structure is composed of a pressure-sensitive adhesive tape or sheet of a base material-provided type in which one or both surfaces thereof are a pressure-sensitive adhesive layer, the structure may have a configuration in which, for example, the pressure-sensitive adhesive layer is arranged on one or both surfaces of the base material (the base material for pressure-sensitive adhesive tape or sheet) as the support; the electromagnetically conductive/absorptive fibrous protrusion is arranged on the surface or the wall surface of the concave of the pressure-sensitive adhesive layer arranged on one or both surfaces of the base material; and the fiber protector is arranged in a portion of the surface of the pressure-sensitive adhesive layer where no electromagnetically conductive/absorptive fibrous protrusion is arranged. When the structure is composed of a double-sided pressure-sensitive adhesive tape or sheet of a base material-less type, the structure may have a configuration in which, for example, a release liner (release liner for pressure-sensitive adhesive tape or sheet) serves as a support of the pressure-sensitive adhesive layer; the electromagnetically conductive/absorptive fibrous protrusion is arranged on the surface or the wall surface of the concave of the pressure-sensitive adhesive layer; and the fiber protector is arranged in a portion of the surface of the pressure-sensitive adhesive layer where no electromagnetically conductive/absorptive fibrous protrusion is arranged. In this connection, the release liner as the support not only supports the pressure-sensitive adhesive layer but also protects the surface of the pressure-sensitive adhesive layer until the structure is used.

(Base Material)

A base material in a sheet form (sheet-like base material) can be suitably used as the base material serving as a support as described above. As such a sheet-like base material, a base material for pressure-sensitive adhesive tape or sheet (base material) is suitably used. An appropriate thin-sheet article can be used as the base material. Examples of the thin-sheet article include plastic base materials such as a plastic film or sheet; metallic base materials such as a metal foil and a metal plate; paper base materials including paper such as wood-free paper, Japanese paper, kraft paper, glassine paper, synthetic paper, and topcoat paper; fibrous base materials such as a cloth, a non-woven fabric, and a net; rubber base materials such as a rubber sheet; and foams such as a foamed sheet. The base material may have any form of a single-layered form or a multilayered form. The base material may be, for example, a multilayered article (two-layered or three-layered composite article) of a plastic base material and another base material (e.g., a metallic base material, a paper-based base material, or a fibrous base material) typically by lamination or co-extrusion. When a foam is used as the substrate, the tracking ability (following ability) with respect to depressions and protrusions of a surface of an adherend can be increased.

The base material is preferably a plastic base material such as a plastic film or sheet. Examples of a raw material (plastic material) of such a plastic base material include olefinic resins composed of an $\alpha$-olefin as a monomer component such as a polyethylene (PE), a polypropylene (PP), an ethylene-propylene copolymer, and an ethylene-vinyl acetate copolymer (EVA); resins including polyesters such as a poly(ethylene terephthalate) (PET), a poly(ethylene naphthalate) (PEN), and a poly(butylene terephthalate) (PBT)); poly(vinyl chloride)s (PVC); vinyl acetate resins; poly (phenylene sulfide)s (PPS); amide resins such as a polyamide (nylon) and a wholly aromatic polyamide (aramid); polyimides; and poly(ether ether ketone)s (PEEK). The plastic material of the plastic base material as the base material may be an electromagnetically conductive/absorptive plastic material such as an electroconductive plastic material. Examples of the electroconductive plastic material include an electroconductive polymer as exemplified previously typically in the electromagnetically conductive/absorptive fiber. Each of these plastic materials may be used alone or in combination as a mixture. The plastic film or sheet may be of a non-stretched type or a stretched type having been subjected to a uniaxial or biaxial stretching (drawing).

Examples of the metallic material for forming the metallic base material, such as a metal foil or a metal plate, include metallic materials as exemplified previously typically in the electromagnetically conductive/absorptive fiber. Each of such metallic materials can be used alone or in combination.

The base material for use in the present invention is preferably a base material having a capability of conducting or absorbing electromagnetic waves (hereinafter also referred to as "electromagnetically conductive/absorptive base material"), for the purpose of further enhancing the electromagnetic conductivity/absorptivity of the structure. The electromagnetically conductive/absorptive base material is not particularly limited, as long as it is a base material that can exhibit electromagnetic conductivity/absorptivity, and examples thereof include a base material composed of an electromagnetically conductive/absorptive material; and an base material containing an electromagnetically conductive/absorptive material on a surface or inside thereof.

Of such electromagnetically conductive/absorptive base materials, the base material composed of an electromagnetically conductive/absorptive material is not particularly limited. For example, one or more kinds of electromagnetically conductive/absorptive materials such as a metallic material, an electromagnetically conductive/absorptive plastic material (e.g., an electroconductive plastic material), and a magnetic material can be used. Examples of the metallic material, the electromagnetically conductive/absorptive plastic material, and the magnetic material include metallic materials, electromagnetically conductive/absorptive plastic materials, and magnetic materials as exemplified in the electromagnetically conductive/absorptive fiber constituting the above-mentioned electromagnetically conductive/absorptive fibrous protrusion and the electromagnetically conductive/absorptive material to be contained in the pressure-sensitive adhesive composition or adhesive composition.

The base material containing an electromagnetically conductive/absorptive material on the surface or inside thereof is not particularly limited, as long as it is a base material of every kind in which an electromagnetically conductive/absorptive material is used on the surface or inside thereof. Examples of the base material containing an electromagnetically conductive/absorptive material on the surface thereof include a base material having a layer made of an electromagnetically conductive/absorptive material-containing composition containing an electromagnetically conductive/absorptive material (hereinafter also referred to as "electromagnetically conductive/absorptive material-containing layer") on the surface thereof. In the base material having an electromagnetically conductive/absorptive material-containing layer on the surface thereof, it is only required that the electromagnetically conductive/absorptive material-containing layer is arranged on at least one surface of the base material. The thickness of the electromagnetically conductive/absorptive material-containing layer is not particularly limited. For example, it can be properly selected within the range of 0.1 $\mu$m or more, for example, from 0.1 $\mu$m to 1 mm. The electromagnetically conductive/absorptive material-containing layer may be a layer having a small thickness, such as a thin film layer having a thickness of from about 0.1 to 30 $\mu$m. Accordingly, the base material having an electromagnetically conductive/absorptive material-containing layer on the surface thereof may be a base material having a configuration in which an electromagnetically conductive/absorptive material-containing layer having a small thickness is formed on a base material not having electromagnetic conductivity/absorptivity (hereinafter also referred to as "electromagnetically non-conductive/non-absorptive base material") or may be a base material having a configuration in which an electromagnetically non-conductive/non-absorptive base material and an electromagnetically conductive/absorptive material-containing layer are laminated.

In an electromagnetically conductive/absorptive material-containing composition for forming such an electromagnetically conductive/absorptive material-containing layer, the electromagnetically conductive/absorptive material may be contained as a major component or an additional component (subcomponent). The electromagnetically conductive/absorptive material is not particularly limited. Usable examples thereof include a metallic material, an electromagnetically conductive/absorptive plastic material (e.g., an electrically conducting plastic material), and a magnetic material. Accordingly, the electromagnetically conductive/absorptive material-containing layer may be a metallic material layer such as a metal foil or a metal plate; an electromagnetically conductive/absorptive plastic material layer such as a film or sheet composed of an electromagnetically conductive/absorptive plastic material; or a magnetic material layer. Incidentally, examples of the metallic material for forming the electromagnetically conductive/absorptive material-containing layer include metallic materials as exemplified previously typically in the electromagnetically conductive/absorptive fiber constituting the electromagnetically conductive/absorptive fibrous protrusion. Examples of the electromagnetically conductive/absorptive plastic material include electromagnetically conductive/absorptive plastic materials as exemplified previously typically in the electromagnetically conductive/absorptive fiber constituting the electromagnetically conductive/absorptive fibrous protrusion. Examples of the magnetic material include magnetic materials as exemplified previously typically in the electromagnetically conductive/absorptive fiber constituting the electromagnetically conductive/absorptive fibrous protrusion. Each of such electromagnetically conductive/absorptive materials can be used alone or in combination. The electromagnetically conductive/absorptive material such as a metallic material, an electromagnetically conductive/absorptive plastic material, or a magnetic material may have any form such as a powdery form, a film form, a foil form, or a thin-layer form.

The electromagnetically non-conductive/non-absorptive base material to be coated or laminated by the electromagnetically conductive/absorptive material is not particularly limited, as long as it is a base material not having electromagnetic conductivity/absorptivity. Usable examples thereof include plastic base materials not having electromagnetic conductivity/absorptivity including, for example, a plastic base material composed of, as a raw material, a resin not having electromagnetic conductivity/absorptivity, such as a polyolefin resin, a polyester resin, a poly(vinyl chloride), a vinyl acetate resin, a poly(phenylene sulfide), an amide resin, a polyimide resin, and a poly(ether ether ketone; paper-based base materials not having electromagnetic conductivity/absorptivity, such as wood-free paper, Japanese paper, kraft paper, glassine paper, synthetic paper, and topcoat paper; and fibrous base materials not having electromagnetic conductivity/absorptivity, such as a cloth or non-woven fabric not having electromagnetic conductivity/absorptivity. The electromagnetically non-conductive/non-absorptive base material may have any form of a single-layered form or a multilayered form.

In the base material having an electromagnetically conductive/absorptive material-containing layer on the surface thereof, a process for forming an electromagnetically conductive/absorptive material-containing material on the surface of the base material is not particularly limited. It can be properly selected and applied from a known process (e.g., a metal vapor deposition process, a metal plating process, a lamination process by adhesion, an impregnation process, and a painting process) depending typically upon the type of the electromagnetically conductive/absorptive material and the thickness of the electromagnetically conductive/absorptive material-containing layer. For example, when the electromagnetically conductive/absorptive material is a metallic material and the electromagnetically conductive/absorptive material-containing layer is an electromagnetically conductive/absorptive material-containing layer having a small thickness, the electromagnetically conductive/absorptive material-containing layer can be formed on the surface of the base material, for example, by applying a coating process by vapor deposition of a metallic material or a coating process by plating of a metallic material. Accordingly, the base material having an electromagnetically conductive/absorptive material-containing layer on the surface thereof may be a plastic film or sheet having a metallic material deposited on the surface thereof (a metal-deposited plastic film or sheet) or a plastic film or sheet having a metallic material plated on the surface thereof (a metal-plated plastic film or sheet).

Examples of the base material containing an electromagnetically conductive/absorptive material in the inside thereof include a base material which is composed of an electromagnetically conductive/absorptive material-containing composition containing an electromagnetically conductive/absorptive material. Such a base material may be a base material containing an electromagnetically conductive/absorptive material as a major material constituting the base material (hereinafter also referred to as "electromagnetically conductive/absorptive material-based base material"), or a base material formed of a material mixture containing a major material constituting the base material and an electromagnetically conductive/absorptive material (hereinafter also referred to as "electromagnetically conductive/absorptive material-containing base material"). Examples of the electromagnetically conductive/absorptive material-based base material include metallic base materials such as a metal foil and a metal plate; electromagnetically conductive/absorptive plastic base materials such as a film or sheet composed of an electromagnetically conductive/absorptive plastic material; fibrous base materials having electromagnetic conductivity/absorptivity (electromagnetically conductive/absorptive fibrous base materials) including a woven fabric such as a cloth and a non-woven fabric and the like, formed of a fiber having electromagnetic conductivity/absorptivity; and magnetic material-based base materials such as a magnetic material plate. Examples of a metallic material for forming the metallic base material include a metallic material as exemplified previously typically in the electromagnetically conductive/absorptive fiber constituting the electromagnetically conductive/absorptive fibrous protrusion. Examples of an electromagnetically conductive/absorptive plastic material for forming the electromagnetically conductive/absorptive plastic base material include electromagnetically conductive/absorptive plastic materials as exemplified previously typically in the electromagnetically conductive/absorptive fiber constituting the electromagnetically conductive/absorptive fibrous protrusion. Usable examples of a fiber in the electromagnetically conductive/absorptive fibrous base material include electromagnetically conductive/absorptive fibers, such as a carbonaceous fiber, a fiber made of an electroconductive polymer, and a metallic fiber, as exemplified previously typically in the electromagnetically conductive/absorptive fiber constituting the electromagnetically conductive/absorptive fibrous protrusion. Examples of a magnetic material in the magnetic material-based base material include a magnetic material as exemplified previously typically in the electromagnetically conductive/absorptive fiber constituting the electromagnetically conductive/absorptive fibrous protrusion.

In the electromagnetically conductive/absorptive material-containing base material, examples of the major material constituting the base material include materials not having electromagnetic conductivity/absorptivity (hereinafter also referred to as "electromagnetically non-conductive/non-absorptive materials") such as plastic materials not having electromagnetic conductivity/absorptivity, including, for example, resins not having electromagnetic conductivity/absorptivity such as a polyolefin resin, a polyester resin, polyvinyl chloride, a vinyl acetate resin, a poly(phenylene sulfide), an amide resin, a polyimide resin, and a poly(ether ether ketone); paper materials not having electromagnetic conductivity/absorptivity including, for example, paper materials for forming a paper-based base material not having electromagnetic conductivity/absorptivity, such as wood-free paper, Japanese paper, kraft paper, glassine paper, synthetic paper, and topcoat paper; and fibrous materials not having electromagnetic conductivity/absorptivity, including fibrous materials for forming a fibrous base material not having electromagnetic conductivity/absorptivity, such as a cloth or non-woven fabric not having electromagnetic conductivity/absorptivity. Each of such electromagnetically non-conductive/non-absorptive materials can be used alone or in combination. Examples of the electromagnetically conductive/absorptive material in the electromagnetically conductive/absorptive material-containing base material include metallic materials as exemplified previously typically in the electromagnetically conductive/absorptive fiber constituting the electromagnetically conductive/absorptive fibrous protrusion; electromagnetically conductive/absorptive plastic materials as exemplified previously typically in the electromagnetically conductive/absorptive fiber constituting the electromagnetically conductive/absorptive fibrous protrusion; and magnetic materials as exemplified previously typically in the electromagnetically conductive/absorptive fiber constituting the electromagnetically conductive/absorptive fibrous protrusion.

In the electromagnetically conductive/absorptive material-containing base material, when the major material constituting the base material is a fibrous material not having electromagnetic conductivity/absorptivity, the electromagnetically conductive/absorptive material may be contained as being impregnated in the fiber or as being mixed in the fibrous material constituting the fiber.

In the base material containing an electromagnetically conductive/absorptive material in the inside thereof, a process for incorporating the electromagnetically conductive/absorptive material into the inside of the base material is not particularly limited. For example, when the base material containing an electromagnetically conductive/absorptive material in the inside thereof is an electromagnetically conductive/absorptive material-based base material, the electromagnetically conductive/absorptive material-based base material can be formed by applying a known process for forming a metal foil, a known process for forming a plastic film or sheet, or a known process for forming a fiber and the like, depending typically upon the type of the electromagnetically conductive/absorptive material-based base material. When the base material containing an electromagnetically conductive/absorptive material in the inside thereof is an electromagnetically conductive/absorptive material-containing base material, the electromagnetically conductive/absorptive material-containing base material can be formed, for example, by mixing the major material constituting the base material with the electromagnetically conductive/absorptive material and thereafter applying, for example, a known process for forming a metal foil, or a known process for forming a plastic film or sheet, depending typically upon the types of the major material constituting the base material and the electromagnetically conductive/absorptive material.

If desired, the base material may contain a variety of additives including inorganic fillers such as titanium oxide and zinc oxide; antiaging agents such as an amine antiaging agent, a quinoline antiaging agent, a hydroquinone antiaging agent, a phenolic antiaging agent, a phosphorus-containing antiaging agent, and a phosphorous acid ester antiaging agent; antioxidants; ultraviolet absorbers such as a salicylic acid derivative, a benzophenone ultraviolet absorber, a benzotriazole ultraviolet absorber, and a hindered amine ultraviolet absorber; lubricants; plasticizers; and coloring agents such as a pigment and a dye. In addition, the base material may contain an electromagnetically conductive/absorptive material as described above.

For the purpose typically of improving adhesion to a pressure-sensitive adhesive or adhesive layer, one or both surfaces of the base material may be subjected to an appropriate surface treatment such as a physical treatment (e.g., a corona treatment and a plasma treatment) and a chemical treatment (e.g., an undercoating treatment).

The thickness of the base material is not particularly limited and can be selected within a range of, for example, from 10 $\mu$m to 20 mm, and preferably from 30 $\mu$m to 12 mm.

(Release Liner)

Examples of the release liner as the support, such as a release liner for pressure-sensitive adhesive tape or sheet, include a known low adhesive base material in addition to a base material having a layer which has been subjected to a release treatment with a releasing agent on at least one surface thereof. A suitable example of the release liner includes a release liner having a release-treated layer arranged on at least one surface of a base material for release liner. Examples of the base material for release liner include a plastic base material film (synthetic resin film) of every kind, paper, and a multilayered article (two-layered or three-layered composite article) by laminating or co-extruding these base materials. For example, the release-treated layer can be formed by using a known releasing agent (e.g., a silicone-based releasing agent, a fluorine-based releasing agent, and a long-chain alkyl-based releasing agent) alone or in combination. The release-treated layer can be formed by applying a releasing agent to a predetermined surface (at least one surface) of a base material for release liner and then performing a heating step typically for drying or a curing reaction.

Conditions such as the thickness of the release liner, the thickness of the base material for release liner, and the thickness of the release-treated layer are not particularly limited but can be properly selected depending typically upon the shape of the electromagnetically conductive/absorptive fibrous protrusion.

(Covering Layer)

A covering layer may be arranged in the present invention so as to cover the electromagnetically conductive/absorptive fibrous protrusion as illustrated in Fig. 4. The covering layer is a layer which coats or covers the electromagnetically conductive/absorptive fibrous protrusion. The subject covering layer can serve to suppress or prevent the fiber constituting the electromagnetically conductive/absorptive fibrous protrusion from coming out from the substrate, and it acts to maintain the fiber of the electro-magnetic conducting or absorbing fibrous protrusion more effectively. In addition, the covering layer acts to enhance properties such as impact resistance. Such a covering layer may be a layer which covers at least a part of or the top surface of the fiber in the electromagnetically conductive/absorptive fibrous protrusion. In particular, the covering layer is preferably a layer which covers the top surface of the fiber in the electromagnetically conductive/absorptive fibrous protrusion. The covering layer may be arranged so as to be in contact with the electromagnetically conductive/absorptive fibrous protrusion or may be arranged so as not to be in contact with the electromagnetically conductive/absorptive fibrous protrusion. When the covering layer is arranged so as not to be in contact with the electromagnetically conductive/absorptive fibrous protrusion, the covering layer may be arranged on a fiber protector that has a thickness (height) larger than the thickness (height) of a portion of the electromagnetically conductive/absorptive fibrous protrusion positioned outward from the surface of the substrate, as illustrated in Fig. 4.

Fig. 4 is a schematic cross-sectional view showing a structure according to an embodiment of the present invention. Fig. 4 illustrates a structure 4, a substrate 41, an electromagnetically conductive/absorptive fibrous protrusion 42, a fiber protector 43, and a covering layer 44. The structure 4 in Fig. 4 has a configuration in which the electromagnetically conductive/absorptive fibrous protrusion 42 and the fiber protector 43 are arranged in predetermined portions of the substrate 41, respectively; the covering layer 44 is arranged on the fiber protector 43; and the covering layer 44 covers the top surface of the fibers in the electromagnetically conductive/absorptive fibrous protrusion 42.

The covering material constituting the covering layer is not particularly limited. Examples thereof include a covering material composition containing, as a major component, a known polymer component. Examples of the polymer component include resin components such as a thermoplastic resin, a thermosetting resin, and an ultraviolet ray-curable resin; rubber components; and elastomer components. Specifically, in the covering material composition constituting the covering layer, the polymer component can be properly selected from among polymer components as with the polymer components as exemplified previously in the substrate (e.g., resin components such as a thermoplastic resin, a thermosetting resin, and an ultraviolet ray-curable resin; rubber components; and elastomer components).

The covering layer may have any form of a single-layered form and a multilayered formed.

The covering layer for use in the present invention preferably has electromagnetic conductivity/absorptivity. When the covering layer also has electromagnetic conductivity/absorptivity, the structure can have further enhanced electromagnetic conductivity/absorptivity. The covering layer having electromagnetic conductivity/absorptivity can be composed of a covering material composition containing an electromagnetically conductive/absorptive material. The electromagnetically conductive/absorptive material which is used in the covering material is not particularly limited. For example, an electromagnetically conductive/absorptive material such as a metallic material, an electromagnetically conductive/absorptive plastic material (e.g., an electroconductive plastic material), and a magnetic material can be used alone or in combination. Examples of the metallic material, the electromagnetically conductive/absorptive plastic material, and the magnetic material include metallic materials, electromagnetically conductive/absorptive plastic materials, and magnetic materials as exemplified previously, such as metallic materials, electromagnetically conductive/absorptive plastic materials, and magnetic materials as exemplified previously in the electromagnetically conductive/absorptive fiber constituting the electromagnetically conductive/absorptive fibrous protrusion, the pressure-sensitive adhesive composition or adhesive composition constituting the pressure-sensitive adhesive or adhesive layer, and the composition constituting the substrate.

The covering material composition containing an electromagnetically conductive/absorptive material can be prepared by mixing a covering material and an electromagnetically conductive/absorptive material. In the covering material composition, the content of the electromagnetically conductive/absorptive material is not particularly limited but can be properly selected depending typically upon the type of a polymer component of the covering material, and the electromagnetic conductivity/absorptivity of the covering layer. For example, the content of the electromagnetically conductive/absorptive material is preferably from 3 to 98 percent by weight, and particularly preferably from 5 to 95 percent by weight, of the total amount of solids in the covering material composition. When the content of the electromagnetically conductive/absorptive material is too small, the electromagnetic conductivity/absorptivity of the covering layer may be lowered, while when it is too large, the formation of the covering layer may become difficult.

In forming the covering layer, it is important that the electromagnetically conductive/absorptive fibrous protrusion and the fiber protector be formed in advance in the substrate, because the covering layer is a layer for covering the electromagnetically conductive/absorptive fibrous protrusion. Accordingly, the covering layer can be formed after forming the electromagnetically conductive/absorptive fibrous protrusion and the fiber protector in the substrate.

As a process for forming the covering layer, a known forming process (e.g., a coating forming process, a dip forming process, and a spray forming process) can be employed. The forming process can be properly selected depending upon the form of the covering layer, the types and forms of the electromagnetically conductive/absorptive fibrous protrusion and the fiber protector. Specifically, the covering layer can be formed by applying the covering material composition onto the electromagnetically conductive/absorptive fibrous protrusion arranged in the substrate so that at least a part of the fiber is positioned outward from the surface of the substrate, or onto the subject electromagnetically conductive/absorptive fibrous protrusion and the fiber protector.

The thickness of the covering layer is not particularly limited but can be properly set up depending typically upon the type and form of the covering layer, the length of the fiber which is exposed in the electromagnetically conductive/absorptive fibrous protrusion, and the thickness of the fiber protector. The thickness of the covering layer can be selected within the range of, for example, from 10 to 5,000 μm, preferably from 30 to 3,000 μm, and more preferably from 30 to 2,000 μm.

The covering layer for use in the present invention may be a layer composed of a pressure-sensitive adhesive tape or sheet. More specifically, the covering layer may be formed by affixing a pressure-sensitive adhesive tape or sheet onto the electromagnetically conductive/absorptive fibrous protrusion, the pressure-sensitive adhesive tape or sheet for constituting the covering layer may be a pressure-sensitive adhesive tape or sheet composed of a pressure-sensitive adhesive layer alone (base material-less type pressure-sensitive adhesive tape or sheet) or a pressure-sensitive adhesive tape or sheet composed of a base material and a pressure-sensitive adhesive layer arranged on one side or both sides thereof (base material-provided type pressure-sensitive adhesive tape or sheet). Thus, the covering layer may be a layer composed of a pressure-sensitive adhesive layer alone or a multilayer (assembly) composed of a pressure-sensitive adhesive layer and a base material. Such a covering layer composed of a pressure-sensitive adhesive tape or sheet may be formed not by, for example, application of a covering material composition but by affixing the pressure-sensitive adhesive tape or sheet onto the electromagnetically conductive/absorptive fibrous protrusion.

When the covering layer is composed of a base material-less type pressure-sensitive adhesive tape or sheet or a base material-provided type pressure-sensitive adhesive tape or sheet, the pressure-sensitive adhesive layer in these pressure-sensitive adhesive tapes or sheets can be any of a pressure-sensitive adhesive layer not having electromagnetic conductivity/absorptivity (electromagnetically non-conductive/non-absorptive pressure-sensitive adhesive layer) and a pressure-sensitive adhesive layer having electromagnetic conductivity/absorptivity (electromagnetically conductive/absorptive pressure-sensitive adhesive layer). Examples of a pressure-sensitive adhesive composition for constituting the electromagnetically non-conductive/non-absorptive pressure-sensitive adhesive layer in these pressure-sensitive adhesive tapes or sheets as the covering layer include pressure-sensitive adhesive compositions as exemplified in the pressure-sensitive adhesive or adhesive layer as the substrate. Examples of a pressure-sensitive adhesive composition for constituting the electromagnetically conductive/absorptive pressure-sensitive adhesive layer in these pressure-sensitive adhesive tapes or sheets include electromagnetically conductive/absorptive material-containing pressure-sensitive adhesive compositions exemplified as the pressure-sensitive adhesive composition for constituting the pressure-sensitive adhesive or adhesive layer having electromagnetic conductivity/absorptivity, in the pressure-sensitive adhesive or adhesive layer as the substrate.

When the covering layer is composed of a base material-provided type pressure-sensitive adhesive tape or sheet, a base material in the pressure-sensitive adhesive tape or sheet may be a base material not having electromagnetic conductivity/absorptivity (electromagnetically non-conductive/non-absorptive base material), or a base material having electromagnetic conductivity/absorptivity (electromagnetically conductive/absorptive base material). In a covering layer of this type, examples of an electromagnetically non-conductive/non-absorptive base material in the base material-provided type pressure-sensitive adhesive tape or sheet include a plastic-based base material having electromagnetic non-conductivity/non-absorptivity, a paper-based base material having electromagnetic non-conductivity/non-absorptivity, and a fiber-based base material having electromagnetic non-conductivity/non-absorptivity. Specific examples thereof include plastic-based base materials, paper-based base materials, and fiber -based base materials as exemplified in the base material as the support in the structure. Examples of an electromagnetically conductive/absorptive base material in the base material-provided type pressure-sensitive adhesive tape or sheet include those exemplified in the description of the base material, such as a base material composed of an electromagnetically conductive/absorptive material, and a base material containing an electromagnetically conductive/absorptive material on the surface or inside thereof.

More specifically, usable examples of the pressure-sensitive adhesive tape or sheet for constituting the covering layer include a pressure-sensitive adhesive tape or sheet having no base material; a pressure-sensitive adhesive tape or sheet having a plastic film or sheet, such as a polyester film or sheet, as the base material; a pressure-sensitive adhesive tape or sheet having a nonwoven fabric as the base material; and a pressure-sensitive adhesive tape or sheet having a metal foil, such as aluminum foil, as the base material. A pressure-sensitive adhesive constituting the pressure-sensitive adhesive layer in these pressure-sensitive adhesive tapes or sheets is preferably an acrylic pressure-sensitive adhesive or a rubber pressure-sensitive adhesive. The pressure-sensitive adhesive may contain an electromagnetically conductive/absorptive material.

A process for forming a pressure-sensitive adhesive tape or sheet constituting the covering layer can be selected as appropriate from among known processes for forming a pressure-sensitive adhesive tape or sheet. The thickness of the pressure-sensitive adhesive tape or sheet is naturally the thickness of the covering layer. Accordingly, it is important to adjust the thicknesses of the pressure-sensitive adhesive layer and base material in the pressure-sensitive adhesive tape or sheet so as to allow the covering layer to have a thickness within the above-exemplified range. Each of the pressure-sensitive adhesive layer and base material in the pressure-sensitive adhesive tape or sheet for constituting the covering layer may have whichever of a single-layered form and a multilayered form. When the covering layer is composed of a pressure-sensitive adhesive tape or sheet including a base material and a pressure-sensitive adhesive layer arranged on both surfaces thereof, the pressure-sensitive adhesive layers arranged on both sides of the base material can be the same pressure-sensitive adhesive layer or different pressure-sensitive adhesive layers.

(Structure)

As is described above, it is important that a structure according to the present invention has a configuration in which an electromagnetically conductive/absorptive fibrous protrusion is partially arranged in a substrate so that at least a part of a fiber thereof is positioned outward from a surface of the substrate; and a fiber protector is arranged at least partially in a portion of the surface of the substrate where no electromagnetically conductive/absorptive fibrous protrusion is arranged. The structure may further have appropriate layer or layers at appropriate position or positions, as long as it has the configuration and as long as the advantages and operation of the present invention are not significantly adversely affected. More specifically, examples of the configuration of a structure according to the present invention include the following configurations (A) to (D).

(A) A configuration in which a pressure-sensitive adhesive layer or adhesive layer (pressure-sensitive adhesive or adhesive layer) as the substrate is arranged in at least one surface (one surface or both surfaces) of a base material as a support for supporting the substrate; an electromagnetically conductive/absorptive fibrous protrusion is arranged in the pressure-sensitive adhesive or adhesive layer in at least one surface (one surface or both surfaces) of the base material so that at least a part of a fiber thereof is positioned outward from the surface of the pressure-sensitive adhesive or adhesive layer; and a fiber protector is arranged at least partially in a portion of the surface of the substrate where no electromagnetically conductive/absorptive fibrous protrusion is arranged.
(B) A configuration in which a pressure-sensitive adhesive layer as the substrate is arranged on a release surface on one surface of a release liner supporting the substrate; an electromagnetically conductive/absorptive fibrous protrusion is arranged on a pressure-sensitive adhesive layer on the surface of the release liner so that at least a part of a fiber thereof is positioned outward from the surface of the pressure-sensitive adhesive or adhesive layer; and a fiber protector is arranged at least partially in a portion of the surface of the substrate where no electromagnetically conductive/absorptive fibrous protrusion is arranged.
(C) A configuration in which the substrate is not supported by a support; an electromagnetically conductive/absorptive fibrous protrusion is arranged in at least one surface (one surface or both surfaces) of a pressure-sensitive adhesive layer or polymer layer as the substrate so that at least a part of a fiber thereof is positioned outward from the surface of the polymer layer; and a fiber protector is arranged at least partially in a portion of the surface of the polymer layer where no electromagnetically conductive/absorptive fibrous protrusion is arranged.
(D) A configuration corresponding to any of the configurations (A) to (C), in which the electromagnetically conductive/absorptive fibrous protrusion is covered by a covering layer. Specifically, in this configuration, a substrate is, where necessary, supported by a support such as a base material or a release liner; an electromagnetically conductive/absorptive fibrous protrusion is arranged in at least one surface (one surface or both surfaces) of a pressure-sensitive adhesive or adhesive layer or polymer layer as the substrate so that at least a part of a fiber thereof is positioned outward from a surface of the pressure-sensitive adhesive or adhesive layer or polymer layer; a fiber protector is arranged at least partially in a portion of the surface of the pressure-sensitive adhesive or adhesive layer or polymer layer where no electromagnetically conductive/absorptive fibrous protrusion is arranged; and a covering layer covers the electromagnetically conductive/absorptive fibrous protrusion.

The structure can also be a structure having a configuration in which two or more structures each having a configuration selected from the configurations (A) to (D) are stacked.
Electromagnetic conductive/absorptive fibrous protrusions, when arranged on both surfaces of the substrate, may be the same electromagnetically conductive/absorptive fibrous protrusion or different electromagnetically conductive/absorptive fibrous protrusions. In the latter case, covering layers covering the electromagnetically conductive/absorptive fibrous protrusions may be the same covering layer or different covering layers. Pressure-sensitive adhesive or adhesive layers, when arranged on both surfaces of the base material, may be the same pressure-sensitive adhesive or adhesive layer or different pressure-sensitive adhesive or adhesive layers.
When the structure has an electromagnetically conductive/absorptive fibrous protrusion in one surface alone, the other surface of the structure may constitute a pressure-sensitive adhesive surface or adhesive surface entirely or partially. For example, a pressure-sensitive adhesive surface or adhesive surface is provided in edge alone of at least one ends of the structure. Thus, when one surface of the structure serves as a pressure-sensitive adhesive surface or adhesive surface, the pressure-sensitive adhesive surface or adhesive surface may be whichever of a pressure-sensitive adhesive surface or adhesive surface composed of a pressure-sensitive adhesive layer or adhesive layer having electromagnetic conductivity/absorptivity; and a pressure-sensitive adhesive surface or adhesive surface composed of a pressure-sensitive adhesive layer or adhesive layer not having electromagnetic conductivity/absorptivity; however, it is preferably a pressure-sensitive adhesive surface or adhesive surface composed of a pressure-sensitive adhesive layer or adhesive layer having electromagnetic conductivity/absorptivity. When the structure has a configuration in which an electromagnetically conductive/absorptive fibrous protrusion is covered by a covering layer, the surface of the covering layer may constitute a pressure-sensitive adhesive surface or adhesive surface entirely or partially. For example, a pressure-sensitive adhesive surface or adhesive surface may be provided in edge alone of at least one ends of the covering layer. When the structure includes a covering layer, and the surface of the covering layer serves as a pressure-sensitive adhesive surface or adhesive surface, the pressure-sensitive adhesive surface or adhesive surface may be whichever of a pressure-sensitive adhesive surface or adhesive surface composed of a pressure-sensitive adhesive layer or adhesive layer having electromagnetic conductivity/absorptivity; and a pressure-sensitive adhesive surface or adhesive surface composed of a pressure-sensitive adhesive layer or adhesive layer not having electromagnetic conductivity/absorptivity. Such a pressure-sensitive adhesive surface or adhesive surface can be formed, for example, a process using a known pressure-sensitive adhesive or adhesive, or a process of using a known pressure-sensitive adhesive double coated tape. Accordingly, a structure having a pressure-sensitive adhesive surface or adhesive surface as its surface can be prepared, for example, according to a process of using a support (base material) previously having a pressure-sensitive adhesive surface or adhesive surface as a surface to be exposed outward; a process of applying a pressure-sensitive adhesive or adhesive to a surface of a support (base material) having no pressure-sensitive adhesive surface or adhesive surface as the surface to be exposed outward; a process of affixing a pressure-sensitive adhesive double coated tape or sheet (e.g., a base material-less type pressure-sensitive adhesive double coated tape or sheet, or a base material-provided type pressure-sensitive adhesive double coated tape or sheet) to a surface of a support (base material) having no pressure-sensitive adhesive surface or adhesive surface as the surface to be exposed outward; a process of using pressure-sensitive adhesive tape or sheet previously having a pressure-sensitive adhesive surface or adhesive surface as a surface to be exposed outward; a process of applying a pressure-sensitive adhesive or adhesive to a surface of a covering layer having no pressure-sensitive adhesive surface or adhesive surface as the surface to be exposed outward; or a process of affixing a pressure-sensitive adhesive double coated tape or sheet (e.g., a base material-less type pressure-sensitive adhesive double coated tape or sheet, or a base material-provided type pressure-sensitive adhesive double coated tape or sheet) to a surface of a covering layer having no pressure-sensitive adhesive surface or adhesive surface as the surface to be exposed outward.

According to the present invention, electromagnetic conductivity/absorptivity is suppressed or prevented from decreasing, and effective electromagnetic conductivity/absorptivity (in particular, electromagnetic shielding ability to shield electromagnetic waves by conduction or absorption) can be maintained and expressed even when the electromagnetically conductive/absorptive fibrous protrusion is covered by a covering layer, and the covering layer includes an insulating layer or constitutes an insulating layer. Such an insulating layer may be, for example, a non-electroconductive member such as a non-electroconductive pressure-sensitive adhesive layer or adhesive layer constituting a pressure-sensitive adhesive surface or adhesive surface. When a structure according to the present invention includes a covering layer, the surface of the covering layer preferably serves as an insulating layer. Such an insulating layer can be formed, for example, according to a process of using a base material-provided type pressure-sensitive adhesive tape or sheet including an electromagnetically non-conductive/non-absorptive base material (in particular, a plastic base material not having electromagnetic conductivity/absorptivity); or a process of affixing a base material-provided type pressure-sensitive adhesive tape or sheet to the surface of the covering layer, in which the base material-provided type pressure-sensitive adhesive tape or sheet uses an electromagnetically non-conductive/non-absorptive base material (in particular, a plastic base material not having electromagnetic conductivity/absorptivity).

In particular, when the structure has electromagnetically conductive/absorptive fibrous protrusions in both surfaces, the fiber protector may be arranged in a portion of at least one surface of the substrate where no electromagnetically conductive/absorptive fibrous protrusion is arranged; however, it is preferably arranged in portions of both surfaces of the substrate where no electromagnetically conductive/absorptive fibrous protrusion is arranged.

When the electromagnetically conductive/absorptive fibrous protrusion is arranged on each of the both surfaces of the substrate in a structure having this configuration, the electromagnetic conductivity/absorptivity are further enhanced. In addition, since the base material for supporting the substrate can be thinned or be not used, not only lightening in weight can be achieved, but also flexibility or follow-up properties can be improved.

A structure according to the present invention is not particularly limited with respect to the form, as long as it has any of the above-mentioned configurations. Specifically, the structure may have a form of every kind such as spherical, columnar, polygonal, polygonal conical, conical, plate-like, and sheet forms. Of these, a sheet form is preferable. That is, a structure according to the present invention is preferably a sheet-like structure having a sheet form. The sheet-like structure can have not only electromagnetic conductivity/absorptivity but also pressure-sensitive adhesive or adhesive properties (in particularly, pressure-sensitive adhesive properties). For example, when the sheet-like structure has pressure-sensitive adhesive properties, the sheet-like structure may have a form of a pressure-sensitive adhesive tape or sheet in which only one surface thereof, where no electromagnetically conductive/absorptive fibrous protrusion is arranged, serves as a pressure-sensitive adhesive surface.

When the structure is a sheet-like structure, the subject sheet-like structure can be prepared in a roll-like wound form or in a single-layered or multilayered form. Accordingly, a sheet-like structure where a fiber of the electromagnetically conductive/absorptive fibrous protrusion is suppressed or prevented from flattening can be obtained even when the sheet-like structure is applied in a roll-like wound form (wound article or rolled article) or in a single-layered or sheet-multilayered form, and the sheet-like structure is then rewound or is separated from the laminate form. When the structure according to the present invention is a sheet-like structure, the structure can be provided as a product in a roll-like wound form (wound article or rolled article) or in a single-layered or sheet-multilayered form.

As is described above, structures according to the present invention each have a configuration in which an electromagnetically conductive/absorptive fibrous protrusion is arranged in a substrate so that at least a part of a fiber thereof is positioned outward from a surface of the substrate; and the electromagnetically conductive/absorptive fibrous protrusion is suppressed or prevented from flattening by the action of a fiber protector. Thus, the structures can effectively exhibit the electromagnetic conductivity/absorptivity by the electromagnetically conductive/absorptive fibrous protrusion; and they can be used in a variety of utilities using electromagnetic conductivity/absorptivity of the electromagnetically conductive/absorptive fibrous protrusion. The structures can be suitably used, for example, in utilities using electrical conductivity for conducting electricity, properties for conducting electromagnetic waves (electromagnetic conductivity), properties for absorbing electromagnetic waves (electromagnetic absorptivity), electromagnetic shielding ability by conducting or absorbing electromagnetic waves to shield them, or static elimination properties for eliminating static electricity by applying an electric current. Specifically, the structures can be suitably used as electroconductive materials for conducting electricity, electromagnetically conductive materials for conducting electromagnetic waves, electromagnetic absorptive materials for absorbing electromagnetic waves, electromagnetic shielding materials for shielding electromagnetic waves, and/or antistatic materials for eliminating static electricity to prevent the generation of static electricity (or static hazard-preventive materials to prevent various hazards due to static electricity). In particularly, the structures can be suitably used as electroconductive materials, electromagnetic absorptive materials, and/or electromagnetic shielding materials.

More specifically, structures according to the present invention, when used as electromagnetic shielding materials, can each be used as, for example, an electromagnetic shielding material for wire covering (in particular, an electromagnetic shielding material for covering electric wires used in automobiles), an electromagnetic shielding material for electronic component, an electromagnetic shielding material for clothing materials, and an electromagnetic shielding material for building. When a structure according to the present invention is used as an electromagnetic shielding material for wire covering, it can be used for the purpose typically of suppressing or preventing noise from an electric wire by shielding electromagnetic waves emitted from the electric wire. When a structure according to the present invention is used as an electromagnetic shielding material for an electronic component, it can be used, for example, for the purpose of suppressing or preventing noise from affecting the electronic component (e.g., an electronic circuit board or an electronic device including an electronic circuit board) by shielding the electronic component from external electromagnetic waves, or for the purpose of suppressing or preventing noise emitted from the electronic component by shielding electromagnetic waves emitted from the electronic component. When a structure according to the present invention is used as an electromagnetic shielding material for clothing materials, it can be used, for example, for the purpose of suppressing or preventing electromagnetic waves from affecting the human body by shielding, for example, electromagnetic waves emitted from computers, electromagnetic waves emitted from household electric cooking appliances, or electromagnetic waves emitted from medical-use devices such as so-called devices for "MRI", devices for so-called "CT scanner", and devices for so-called "radiographic visualization." When a structure according to the present invention is used as an electromagnetic shielding material for building, it can be used, for example, for the purpose of suppressing or preventing information from leaking by shielding electromagnetic waves emitted from the building. In this case, it can also be used, for example, for the purpose of preventing the use of so-called "mobile phones" or preventing adverse effects of FM waves (radiowaves) (e.g., preventing a wireless microphone from malfunction) by shielding the inside of the building from external electromagnetic waves in the building or a room (such as a conference room) as a part of the building. Examples of the building herein include assembly halls for various uses, such as a movie theater, a concert hall, a drama theater, an art museum, a museum, a wedding hall, and a hall for conference or lecture.

A structure according to the present invention, when used as an electromagnetic absorptive material, can be used as an electromagnetic absorptive material for building. More specifically, when a structure according to the present invention is used as an electromagnetic absorptive material for building, it can also be used, for example, for the purpose of preventing an electronic device of every kind placed in a room from malfunction by suppressing or preventing scattering or irregular reflection of electromagnetic waves emitted from the electronic device placed in the room; or for the purpose of efficiently operating the electronic device. In these cases, the structure may be affixed to a member which partitions the room (e.g., a member constituting, for example, a ceiling plane, a wall plane, or a floor plane).

In particular, a structure according to the present invention can effectively exhibit a shielding function against not only electromagnetic waves having a single peak wavelength but also electromagnetic waves having plural peak wavelengths. This may be achieved by using two or more different electromagnetically conductive/absorptive fibers or by using an electromagnetically conductive/absorptive fiber which is a single kind of an electromagnetically conductive/absorptive fiber but uses two or more different electromagnetically conductive/absorptive materials, as an electromagnetically conductive/absorptive fiber for constituting the electromagnetically conductive/absorptive fibrous protrusion. Examples of the two or more different electromagnetically conductive/absorptive fibers include two or more different electromagnetically conductive/absorptive raw-material fibers and an electromagnetic conductivity/absorptivity-imparted fiber using different metallic materials as an electromagnetically conductive/absorptive material, such as two or more different electromagnetically conductive/absorptive material-coated fibers or electromagnetically conductive/absorptive material-impregnated fibers. Examples of the electromagnetically conductive/absorptive fiber which is a single kind of an electromagnetically conductive/absorptive fiber but uses two or more different electromagnetically conductive/absorptive materials include an electromagnetic conductivity/absorptivity-imparted fiber, using two or more different electromagnetically conductive/absorptive materials, such as an electromagnetically conductive/absorptive material-coated fibers and an electromagnetically conductive/absorptive material-impregnated fiber. Specifically, electromagnetic waves can be effectively shielded by a single structure (electromagnetic shielding material) against a radiation source such as an article or a substance, from which plural electromagnetic waves having various peak lengths are emitted in a predetermined proportion, as the electromagnetically conductive/absorptive fiber constituting the electromagnetically conductive/absorptive fibrous protrusion, by using two or more different electromagnetically conductive/absorptive fibers in combination and properly adjusting a proportion thereof. In this way, when a structure according to the present invention is used as an electromagnetic shielding material, the type of the radiation source from which electromagnetic waves are emitted is not limited, and the electromagnetic shielding material can be easily prepared in such a configuration that the shielding function can be exhibited against a radiation source of a wide range. Accordingly, in the present invention, it is possible to easily obtain an electromagnetic shielding material capable of performing shielding by further effectively conducting or absorbing electromagnetic waves.

More specifically, when an electromagnetic conductivity/absorptivity-imparted fiber is used as the electromagnetically conductive/absorptive fiber, the type or wavelength of electromagnetic waves capable of performing shielding by conducting or absorbing electromagnetic waves is different between metallic materials, such as nickel and gold, in the electromagnetically conductive/absorptive material constituting the electromagnetic conductivity/absorptivity-imparted fiber. Accordingly, when the electromagnetically conductive/absorptive fibrous protrusion is formed by using, for example, a nickel plated fiber and a gold plated fiber as the electromagnetically conductive/absorptive fiber, the resulting electromagnetic shielding material can efficiently exhibit an electromagnetic shielding effect by nickel and an electromagnetic shielding effect by gold, respectively, thereby enabling further effective shielding of electromagnetic waves.

In addition, the electromagnetically conductive/absorptive fibrous protrusion in a structure according to the present invention is arranged so that at least a part of the fiber is positioned outward from the surface of the substrate. When the structure is used typically as an electromagnetic shielding material, the structure can be used so that at least a part of the fiber of the electromagnetically conductive/absorptive fibrous protrusion is in contact with the surface of an article of every kind, regardless typically of the surface shape of the article to be shielded from electromagnetic waves. Therefore, the resulting structure can further effectively exhibit, for example, electromagnetic shielding ability.

In addition, it is possible to make a structure according to the present invention serve as a structure capable of exhibiting, for example, the desired or adequate electrical conductivity and electromagnetic shielding ability by properly adjusting, for example, the length of the electromagnetically conductive/absorptive fiber and the density of the electromagnetically conductive/absorptive fiber in the electromagnetically conductive/absorptive fibrous protrusion as well as the type of the electromagnetically conductive/absorptive fiber for constituting the electromagnetically conductive/absorptive fibrous protrusion.

Incidentally, the structure according to the present invention may be grounded for the purpose of further conducting or absorbing electromagnetic waves.

Furthermore, the structure according to the present invention can be used in various utilities using various properties such as soundproofing, pyroconductivity, light reflection properties, and design properties as well as various utilities using electromagnetic conductivity/absorptivity.

A process for producing a structure according to the present invention is not particularly limited, and may be a process of forming an electromagnetically conductive/absorptive fibrous protrusion in a predetermined portion on a predetermined surface of a substrate, and then forming a fiber protector in a portion of the surface of the substrate where no electromagnetically conductive/absorptive fibrous protrusion is arranged. However, preferred is a process of forming a fiber protector in a predetermined portion of a predetermined surface of a substrate, and then forming an electromagnetically conductive/absorptive fibrous protrusion in a predetermined portion on the surface of the substrate where no fiber protector is arranged. A process for forming the electromagnetically conductive/absorptive fibrous protrusion is not particularly limited; however, a flocking process is particularly preferred. Accordingly, the process for producing a structure according to the present invention preferably includes the step of forming an electromagnetically conductive/absorptive fibrous protrusion in a predetermined portion of a predetermined surface of a substrate using a flocking process. It is therefore possible in the present invention to produce a structure having electromagnetic conductivity/absorptivity easily and cheaply by a simple process of flocking an electromagnetically conductive/absorptive fiber.

More specifically, a structure having the electromagnetically conductive/absorptive fibrous protrusion in the substrate can be produced by subjecting a predetermined portion in the substrate to flocking according to the flocking process to form the electromagnetically conductive/absorptive fibrous protrusion in such a manner that at least a part of the fiber is positioned outward from the surface of the substrate in a predetermined site of the above-mentioned substrate. As such a flocking process, an electrostatic flocking process is especially suitable. Incidentally, an example of the electrostatic flocking process includes a processing process in which a material to be flocked having a pressure-sensitive adhesive or adhesive layer or a substrate is set as a counter electrode to one electrode; a direct-current high voltage is applied thereto; flocks (fibers) are supplied between these electrodes; and the flocks are flied along the line of electric force due to a Coulomb force and made to stick into the surface of the material to be flocked (e.g., the surface of the substrate or the wall surface of the concave of the substrate), thereby achieving flocking. Such an electrostatic flocking process is not particularly limited, as long as it is a known electrostatic flocking process. For example, any of an up process, a down process and a side process as described in "Seidenshokumo No Genri To Jissai (in Japanese; Principle and Practice of Electrostatic Flocking)" in SENI (Fiber), Vol. 34, No. 6 (1982-6) may be employed.

It is desirable to arrange a fiber protector in advance in a surface of the substrate so as to efficiently produce a structure by forming an electromagnetically conductive/absorptive fibrous protrusion in a partial predetermined portion of the substrate (e.g., a partial predetermined portion on a surface of the substrate, or a wall plane of a concave partially arranged in the substrate according to a flocking process (in particular, according to an electrostatic flocking process). Previous arrangement of the fiber protector on a surface of the substrate can efficiently yield a structure which has the electromagnetically conductive/absorptive fibrous protrusion that is suppressed or prevented by the fiber protector from flattening.

A fiber protector composed of a member having one or more through holes can be used as such a fiber protector to be arranged previously on a surface of the substrate. Accordingly, a preferred process for producing a structure according to the present invention is a process of arranging a fiber protector having one or more through holes on a surface of the substrate, and forming electromagnetically conductive/absorptive fibrous protrusion in a portion of the substrate corresponding to the through hole(s) of the fiber protector according to a flocking process so that at least a part of a fiber thereof is positioned outward from the surface of the substrate.

As a matter of course, the fiber protector may be arranged on a surface of the substrate after forming the electromagnetically conductive/absorptive fibrous protrusion in the substrate. In this case, a structure can be produced by forming an electromagnetically conductive/absorptive fibrous protrusion in a partial predetermined portion such as a surface of the substrate or a wall plane of the concave using a member having one or more openings (e.g., a release base material having one or more openings), then, removing the member having one or more openings, and arranging the fiber protector in a predetermined portion of the surface of the substrate.

A process for arranging the fiber protector on a surface of the substrate is not particularly limited and can be a fixing process selected from among known fixing processes according typically to the type of the substrate and the type of the fiber protector. More specifically, when the substrate is a pressure-sensitive adhesive or adhesive layer, the fiber protector can be arranged in a predetermined portion of the surface of the pressure-sensitive adhesive or adhesive layer by affixing the fiber protector to the predetermined portion of the surface of the pressure-sensitive adhesive or adhesive layer serving as the substrate. When the substrate is a polymer layer, the fiber protector can be arranged in a predetermined portion of the surface of the polymer layer by affixing the fiber protector in the predetermined portion of the surface of the polymer layer as the substrate using, for example, an affixing process with a pressure-sensitive adhesive or adhesive; or an affixing process by forming a pressure-sensitive adhesive or adhesive layer on a surface of the fiber protector.

In the process for producing a structure by previously arranging the fiber protector on a surface of the substrate and then forming the electromagnetically conductive/absorptive fibrous protrusion in a predetermined portion of the substrate as described above, for example, the position on a surface of the substrate where the electromagnetically conductive/absorptive fibrous protrusion is to be formed, the size and number of the electromagnetically conductive/absorptive fibrous protrusion, and the concave for the formation of the electromagnetically conductive/absorptive fibrous protrusion can be controlled by adjusting, for example, the position of the fiber protector where the through hole(s) is to be arranged, and the size and number of the through hole(s) in the fiber protector.

In the present invention, the electromagnetic conductivity/absorptivity (in particular, the electrical conductivity) of a structure can be evaluated by measuring a volume resistivity according to Japanese Industrial Standards (JIS) K6705. The electromagnetic conductivity/absorptivity of the structure can be controlled according to, for example, the size of the respective electromagnetically conductive/absorptive fibrous protrusion which is arranged in the substrate (the occupied area of one electromagnetically conductive/absorptive fibrous protrusion) and the shape thereof, the proportion of the whole electromagnetically conductive/absorptive fibrous protrusion arranged in the substrate to the entire surface of the substrate (the proportion of the occupied area of the whole electromagnetically conductive/absorptive fibrous protrusion), the dimensions (e. g., length and thickness) and raw material of the fiber in the electromagnetically conductive/absorptive fibrous protrusion.

EXAMPLES

The present invention will be illustrated below in further detail with reference to the following examples, but it should not be construed that the present invention is limited to these examples. In the examples and comparative examples, electrostatic flocking was carried out by using a box (size: 2.5 m long in a line flow direction, 1.3 m wide, and 1.4 m high) provided with a line capable of spraying a fiber in the positively charged state and of flowing a long strip-form sheet in the negatively charged state from one side to the other side. Specifically, the electrostatic flocking was carried out by spraying the fiber from an upper portion (one portion) within the above-mentioned box and introducing and moving the longitudinal strip-form sheet within the box at a line speed of 5 m/min. in the state of spraying at an applied voltage of 30 kV such that the surface on which the fiber was to be formed was positioned in the upper side.

(EXAMPLE 1)

To one surface of an aluminum base material (thickness: 60 $\mu$m) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 $\mu$m to form an electromagnetically conductive/absorptive pressure-sensitive adhesive layer. In addition, a polyethylene net-like member, as a fiber protector, having a thickness of 0.35 mm and a percentage of holes of 32% and having a shape shown in Fig. 5 was affixed to the surface of the electromagnetically conductive/absorptive pressure-sensitive adhesive layer. Thereafter, the surface of the electromagnetically conductive/absorptive pressure-sensitive adhesive layer was subjected to electrostatic flocking using, as an electromagnetically conductive/absorptive fiber, an acrylic fiber with nickel-plated surface (surface subjected to a plating treatment with nickel) (fiber diameter: 20 $\mu$m, fiber thickness: 3 deniers, fiber length: 0.5 mm), thereby flocking the acrylic fiber with nickel-plated surface on portions of the surface of the electromagnetically conductive/absorptive pressure-sensitive adhesive layer corresponding to the through holes of the net-like member. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the net-like member from flattening (the sheet-like structure will be hereinafter also referred to as "sheet-like structure A1") as shown in Fig. 6. The sheet-like structure was then wound into a roll and thereby yielded a sheet-like structure A1 in the form of a wound roll. In the sheet-like structure A1, the height of the net-like member stood 70% of the height of the electromagnetically conductive/absorptive fiber-raised section.

Fig. 5 is a schematic view showing a polyethylene net-like member as the fiber protector for use in Example 1. Fig. 6 is a schematic cross-sectional view showing the sheet-like structure prepared according to Example 1. In Fig. 6, 5 stands for the sheet-like structure A1; 51 stands for an electromagnetically conductive/absorptive base material (60 $\mu$m) composed of an aluminum base material; 52 stands for an electromagnetically conductive/absorptive pressure-sensitive adhesive layer (35 $\mu$m) composed of an acrylic pressure-sensitive adhesive containing nickel powder; 53 stands for a fiber protector (0.35 mm) composed of a polyethylene net-like member; and 54 stands for an electromagnetically conductive/absorptive fiber-raised section (0.50 mm) composed of an acrylic fiber which had been subjected to nickel plating.

(EXAMPLE 2)

A sheet-like structure having a configuration as shown in Fig. 7 was prepared by the procedure of Example 1, except for using, as the fiber protector, a polyethylene net-like member (percentage of holes: 32%) having a shape of through holes and raw materials the same as with the net-like member used in Example 1, except for having a thickness of 0.70 mm. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material, and the electromagnetically conductive/absorptive fiber-raised section was suppressed or prevented by the net-like member from flattening (the sheet-like structure will be hereinafter also referred to as "sheet-like structure A2") as shown in Fig. 7. The sheet-like structure was then wound into a roll and thereby yielded a sheet-like structure A2 in the form of a wound roll: In the sheet-like structure A2, the height of the net-like member stood 140% of the height of the electromagnetically conductive/absorptive fiber-raised section.

Fig. 7 is a schematic cross-sectional view showing the sheet-like structure prepared according to Example 2. In Fig. 7, 6 stands for the sheet-like structure A2; 61 stands for an electromagnetically conductive/absorptive base material (60 μm) composed of an aluminum base material; 62 stands for an electromagnetically conductive/absorptive pressure-sensitive adhesive layer (35 μm) composed of an acrylic pressure-sensitive adhesive containing nickel powder; 63 stands for a fiber protector composed of a polyethylene net-like member (0.70 mm); and 64 stands for an electromagnetically conductive/absorptive fiber-raised section (0.50 mm) composed of an acrylic fiber which had been subjected to nickel plating.

In the sheet-like structure A2 according to Example 2, the thickness of the fiber protector (0.70 mm) is larger than the thickness of the electromagnetically conductive/absorptive fiber-raised section (0.5 mm), and the front end of the fiber protector is positioned outward from the front end of the fiber of the electromagnetically conductive/absorptive fiber-raised section.

(EXAMPLE 3)

Two plies of sheet-like structure A2 were prepared by the procedure of Example 2 and were overlaid so that the top surface of the fiber protector of one sheet-like structure A2 was in contact with the surface of the aluminum base material of the other sheet-like structure A2. Thus, there was prepared a sheet-like structure as shown in Fig. 8 (the sheet-like structure will be hereinafter also referred to as "sheet-like structure A3"). The sheet-like structure was then wound into a roll and thereby yielded a sheet-like structure A3 in the form of a wound roll.

Fig. 8 is a schematic cross-sectional view showing the sheet-like structure prepared according to Example 3. In Fig. 8, 7 stands for the sheet-like structure A3, and the other numerals are as above.

(EXAMPLE 4)

To one surface of an aluminum base material (thickness: 60 μm) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 μm to form an electromagnetically conductive/absorptive pressure-sensitive adhesive layer. In addition, a polyethylene net-like member as a fiber protector having a thickness of 0.70 mm and a percentage of holes of 32% and having a shape shown in Fig. 5 was affixed to the surface of the electromagnetically conductive/absorptive pressure-sensitive adhesive layer. Thereafter, the surface of the electromagnetically conductive/absorptive pressure-sensitive adhesive layer was subjected to electrostatic flocking using, as an electromagnetically conductive/absorptive fiber, an acrylic fiber with nickel-plated surface (fiber diameter: 20 μm, fiber thickness: 3 deniers, fiber length: 0.5 mm), thereby flocking the acrylic fiber with nickel-plated surface on portions of the surface of the electromagnetically conductive/absorptive pressure-sensitive adhesive layer corresponding to the through holes of the net-like member to form a fiber-raised section (electromagnetically conductive/absorptive fiber-raised section) composed of the electromagnetically conductive/absorptive fiber (acrylic fiber with nickel-plated surface). In addition, a poly(ethylene terephthalate) film (film thickness: 50 μm) having an acrylic pressure-sensitive adhesive layer (thickness: 24 μm) on one surface was affixed to the top surface of the net-like member to yield a covering layer. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; the electromagnetically conductive/absorptive fiber-raised section was suppressed or prevented by the net-like member from flattening; and the electromagnetically conductive/absorptive fiber-raised section was covered by the covering layer (the sheet-like structure will be hereinafter also referred to as "sheet-like structure A4") as shown in Fig. 9. The sheet-like structure was then wound into a roll and thereby yielded a sheet-like structure A4 in the form of a wound roll. In the sheet-like structure A4, the height of the net-like member stood 140% of the height of the electromagnetically conductive/absorptive fiber-raised section.

Fig. 9 is a schematic cross-sectional view showing the sheet-like structure prepared according to Example 4. In Fig. 9, 8 stands for sheet-like structure A4; 81 stands for an electromagnetically conductive/absorptive base material (60 μm) composed of an aluminum base material; 82 stands for an electromagnetically conductive/absorptive pressure-sensitive adhesive layer (35 μm) composed of an acrylic pressure-sensitive adhesive containing nickel powder; 83 stands for a fiber protector composed of a polyethylene net-like member (0.70 mm); 84 stands for an electromagnetically conductive/absorptive fiber-raised section (0.50 mm) composed of an acrylic fiber which had been subjected to nickel plating; 85 stands for a covering layer composed of a poly(ethylene terephthalate) film having an acrylic pressure-sensitive adhesive layer; 85a stands for an acrylic pressure-sensitive adhesive layer (24 μm); and 85b stands for a poly (ethylene terephthalate) film (50 μm).

(EXAMPLE 5)

To one surface of an aluminum base material (thickness: 60 μm) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 μm to form an electromagnetically conductive/absorptive pressure-sensitive adhesive layer. In addition, a polyethylene net-like member as a fiber protector having a thickness of 0.70 mm and a percentage of holes of 32% and having a shape shown in Fig. 5 was affixed to the surface of the electromagnetically conductive/absorptive pressure-sensitive adhesive layer. Thereafter, the surface of the electromagnetically conductive/absorptive pressure-sensitive adhesive layer was subjected to electrostatic flocking using, as an electromagnetically conductive/absorptive fiber, an acrylic fiber with nickel-plated surface (fiber diameter: 20 μm, fiber thickness: 3 deniers, fiber length: 0.5 mm), thereby flocking the acrylic fiber with nickel-plated surface on portions of the surface of the electromagnetically conductive/absorptive pressure-sensitive adhesive layer corresponding to the through holes of the net-like member. There was thus formed a fiber-raised section (electromagnetically conductive/absorptive fiber-raised section) composed of the electromagnetically conductive/absorptive fiber (acrylic fiber with nickel-plated surface). In addition, a woven fabric (fabric thickness: 86 μm) composed of an acrylic fiber with nickel-plated surface and having an acrylic pressure-sensitive adhesive layer (thickness: 24 μm) on one surface was affixed to the top surface of the net-like member to yield a covering layer. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; the electromagnetically conductive/absorptive fiber-raised section was suppressed or prevented by the net-like member from flattening; and the electromagnetically conductive/absorptive fiber-raised section was covered by the covering layer (the sheet-like structure will be hereinafter also referred to as "sheet-like structure A5") as shown in Fig. 10. The sheet-like structure was then wound into a roll and thereby yielded a sheet-like structure A5 in the form of a wound roll. In the sheet-like structure A5, the height of the net-like member stood 140% of the height of the electromagnetically conductive/absorptive fiber-raised section.

Fig. 10 is a schematic cross-sectional view showing the sheet-like structure prepared according to Example 5. In Fig. 10, 9 stands for sheet-like structure A5; 91 stands for an electromagnetically conductive/absorptive base material (60 μm) composed of an aluminum base material; 92 stands for an electromagnetically conductive/absorptive pressure-sensitive adhesive layer (35 μm) composed of an acrylic pressure-sensitive adhesive containing nickel powder; 93 stands for a fiber protector composed of a polyethylene net-like member (0.70 mm); 94 stands for an electromagnetically conductive/absorptive fiber-raised section (0.50 mm) composed of an acrylic fiber which had been subjected to nickel plating; 95 stands for a covering layer composed of a woven fabric including an acrylic fiber with nickel-plated surface and having an acrylic pressure-sensitive adhesive layer (thickness: 24 μm) ; 95a stands for an acrylic pressure-sensitive adhesive layer (24 μm); and 95b stands for a woven fabric composed of an acrylic fiber with nickel-plated surface (86 μm).

(COMPARATIVE EXAMPLE 1)

To one surface of an aluminum base material (thickness: 60 μm) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 μm to form an electromagnetically conductive/absorptive pressure-sensitive adhesive layer. Thereafter, the entire surface of the electromagnetically conductive/absorptive pressure-sensitive adhesive layer was subjected to electrostatic flocking using, as an electromagnetically conductive/absorptive fiber, an acrylic fiber with nickel-plated surface (fiber diameter: 20 μm, fiber thickness: 3 deniers, fiber length: 0.5 mm), thereby flocking the acrylic fiber with nickel-plated surface on the entire surface of the electromagnetically conductive/absorptive pressure-sensitive adhesive layer. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was arranged entirely on the surface of the electromagnetically conductive/absorptive pressure-sensitive adhesive layer arranged on the electromagnetically conductive/absorptive base material (the sheet-like structure will be hereinafter also referred to as "sheet-like structure A6") as shown in Fig. 11. The sheet-like structure was then wound into a roll and thereby yielded a sheet-like structure A6 in the form of a wound roll.

Fig. 11 is a schematic cross-sectional view showing the sheet-like structure prepared according to Comparative Example 1. In Fig. 11, 10 stands for a sheet-like structure A6; 101 stands for an electromagnetically conductive/absorptive base material (60 μm) composed of an aluminum base material; 102 stands for an electromagnetically conductive/absorptive pressure-sensitive adhesive layer (35 μm) composed of an acrylic pressure-sensitive adhesive containing nickel powder; and 103 stands for an electromagnetically conductive/absorptive fiber-raised section (0.50 mm) composed of an acrylic fiber which had been subjected to nickel plating.

(Evaluation)

The sheet-like structures A1 to A6 each in the form of a wound roll prepared according to Examples 1 to 5 and Comparative Example 1 were unwound. Whether or not the fiber of the electromagnetically conductive/absorptive fibrous protrusion (electromagnetically conductive/absorptive fiber-raised section) in the unwound structures was flattened was visually observed, and the flattening resistance of the fiber of the electromagnetically conductive/absorptive fibrous protrusion was evaluated according to the following criteria. The evaluation results are shown in "Resistance to flattening" in Table 1.
Criteria for evaluating the flattening resistance of fiber:

Good: The flattening of the fiber of the electromagnetically conductive/absorptive fibrous protrusion was suppressed or prevented, and the thickness of a portion of the electromagnetically conductive/absorptive fibrous protrusion positioned outward from the surface of the substrate stood 50% or more of the thickness before the structure was wound into a roll (the thickness at the time when the' electromagnetically conductive/absorptive fibrous protrusion was formed by flocking).

Poor: The fiber of the electromagnetically conductive/absorptive fibrous protrusion was flattened, and the thickness of a portion of the electromagnetically conductive/absorptive fibrous protrusion positioned outward from the surface of the substrate stood less than 50% of the thickness before the structure was wound into a roll (the thickness at the time when the electromagnetically conductive/absorptive fibrous protrusion was formed by flocking).

With respect to the sheet-like structures A1 to A6 each in the form of a wound roll prepared according to Example 1 to 5 and Comparative Example 1, and, as Referential Example 1, the sheet-like structure A6 in Comparative Example 1 before winding into a roll, a magnetic field shielding effect was evaluated using a measuring instrument for the evaluation of the electromagnetic shielding effectiveness by the KEC Method. The evaluation results are shown in Table 2, and graphs plotted therefrom are shown in Figs. 12 to 15. The graphs in Figs. 12 to 15 are graphs each plotted based on a part of the data in Table 2 and are graphs relating to magnetic field shielding effects. In the graphs in Figs. 12 to 15, the abscissa indicates the frequency (MHz) of an applied electromagnetic wave, and the ordinate indicates the shielding effect (dB).

Incidentally, the KEC Method in the measuring instrument for the evaluation of the electromagnetic shielding effectiveness by the KEC Method is a method as developed by Kansai Electronic Industry Development Center. According to this method, the shielding effect in a near electromagnetic field is evaluated by using an amplifier, a spectrum analyzer, and respective shielding boxes (a shielding box for electrical field and a shielding box for magnetic field) marketed from Anritsu Corporation. Specifically, by using a shielding box for electrical field as shown in Fig. 16(a) or a shielding box for magnetic field as shown in Fig. 16(b), the sheet-like structure is placed in a predetermined position; an electromagnetic wave having a predetermined frequency (MHz) (incident wave: incident electrical field or incident magnetic field) is allowed to enter with predetermined energy (hereinafter also referred to as "E1") from the side of the electromagnetically conductive/absorptive fibrous protrusion of the sheet-like structure; the energy (hereinafter also referred to as "E2") of a transmitted wave (transmitted electrical field or transmitted magnetic field) which has transmitted through the other surface of the sheet-like structure is measured; and the shielding effect (dB) is determined according to following Equation (1) :

$$\text{Shielding effect (dB)} = 20 \times \log (E2/E1) \quad (1)$$

Fig. 16 shows schematic diagrams of shielding boxes to be used in the measuring instrument for the evaluation of the electromagnetic shielding effectiveness by the KEC Method, in which Fig. 16(a) shows a shielding box for electrical field, while Fig. 16(b) shows a shielding box for magnetic field. The shielding box for electrical field (unit for electrical field shielding evaluation) has a structure in which dimensional distribution of a TEM cell is employed and the cell consists of symmetrical halves as sectioned in the right middle of the transmission path. However, a short circuit is prevented from the formation by inserting a measurement sample. The shielding box for magnetic field (unit for magnetic field shielding evaluation) has a structure in which a circular shielded loop antenna is used for the purpose of generating a large electromagnetic field of the magnetic field component and combined with a metal plate of 90° square such that a 1/4 portion of the loop antenna is exposed outward.

In this connection, the details of the shielding effect can be found, for example, in Denjiha Shahei Gijutsu (in Japanese; Electromagnetic Shielding Technologies) (pages 253 to 269) in Tokkyo Mappu Shirizu: Denki 23 (in Japanese; Patent Map Series: Electricity 23) published by Japan Institute of Invention and Innovation. In this document, it is described that an index to what extent the electromagnetic energy of the incident electrical field or incident magnetic field can be decayed is the shielding effect, and the shielding effect is expressed, as shown in Equation (1), as a value resulting from multiplication of a common logarithm of a ratio of the electromagnetic energy of the transmitted electrical field or transmitted magnetic field to the electromagnetic energy of the incident electrical field or incident magnetic field by twenty (unit: dB). With respect to the shielding effect, it is described (on pages 254 to 253) that as the standard of the shielding effect, the shielding effect is not substantially exhibited at from 0 to 10 dB; the shielding effect is the minimum at from 10 to 30 dB; the shielding effect is an average level at from 30 to 60 dB; the shielding effect is considerably exhibited at from 60 to 90 dB; and the shielding effect is the maximum at 90 dB or more.

In the KEC method, a measurement limit is different between a low frequency region and a high frequency region. This is because a transmission characteristic of shielding (aluminum shielding plate) is constant regardless of the frequency (-105 dBm over from 1 MHz to 1 GHz in the electrical field shielding box), while a transmission characteristic of the through where no aluminum shielding plate is provided has a frequency characteristic (the transmission characteristic is decayed to about -50 dBm in the low frequency region, whereas substantially the same as 0 dBm as in the transmitting side is received in the high frequency region). In this connection, it is thought that the transmission characteristic of shielding (2 mm-thick aluminum shielding plate) is actually a much smaller value and that "-105 dBm" is a noise level (ability) of the spectrum analyzer. It is also thought that if the noise level (ability) of the spectrum analyzer becomes higher, the transmission characteristic of shielding (aluminum shielding plate) becomes a smaller value, and a difference from the through becomes large, whereby the measurement limit is expanded. However, it is considered that more enhancement is difficult because "-105 dBm" is, when expressed in terms of electrical power, a very small value as not more than 0.1 pW.

[Table 1]

TABLE 1

| | Example | | | | | Comparative Example 1 |
|---|---|---|---|---|---|---|
| | 1 | 2 | 3 | 4 | 5 | |
| Resistance to flattening of fiber | Good | Good | Good | Good | Good | Poor |

[Table 2]

TABLE 2

| | Frequency (MHz) | | | | | | | | | | | | | | | |
|---|---|---|---|---|---|---|---|---|---|---|---|---|---|---|---|---|
| | 1 | 2 | 3 | 5 | 7 | 10 | 20 | 30 | 50 | 70 | 100 | 200 | 300 | 500 | 700 | 1000 |
| Measurement limit (dB) | 56 | 63 | 67 | 72 | 73 | 76 | 82 | 86 | 89 | 92 | 96 | 99 | 100 | 97 | 94 | 78 |
| Ref. Ex. 1 (dB) | 31 | 37 | 41 | 46 | 50 | 54 | 63 | 71 | 82 | 90 | 96 | 99 | 100 | 97 | 94 | 78 |
| Example 1 (dB) | 31 | 37 | 41 | 46 | 49 | 53 | 63 | 71 | 83 | 92 | 94 | 98 | 100 | 98 | 94 | 80 |
| Example 2 (dB) | 31 | 37 | 41 | 45 | 48 | 53 | 64 | 71 | 81 | 88 | 95 | 97 | 100 | 97 | 94 | 78 |
| Example 3 (dB) | 36 | 43 | 47 | 53 | 58 | 66 | 82 | 80 | 82 | 86 | 91 | 96 | 99 | 97 | 94 | 78 |
| Example 4 (dB) | 32 | 37 | 42 | 46 | 50 | 54 | 65 | 74 | 88 | 87 | 88 | 95 | 99 | 97 | 94 | 78 |
| Example 5 (dB) | 33 | 40 | 46 | 53 | 60 | 67 | 82 | 86 | 90 | 93 | 96 | 99 | 100 | 97 | 94 | 78 |
| Com. Ex. 1 (dB) | 29 | 35 | 38 | 43 | 45 | 48 | 54 | 57 | 60 | 63 | 65 | 71 | 74 | 77 | 80 | 80 |

Tables 1 and 2 and the graphs in Figs. 12 to 15 demonstrate that the sheet-like structures A1 to A5 according to Examples 1 to 5 are markedly excellent in magnetic field shielding effect as compared with the sheet-like structure A6 according to Comparative Example 1. More specifically, the sheet-like structures A1 to A5 according to Examples 1 to 5 exhibit magnetic field shielding effects equivalent to or more excellent than that of the sheet-like structure A6 before winding into a roll in Comparative Example 1, namely, the sheet-like structure A6 in which the fiber of the electromagnetically conductive/absorptive fibrous protrusion is not flattened. In contrast, the sheet-like structure A6 according to Comparative Example 1 has a poor magnetic field shielding effect, and in particular markedly poor magnetic field shielding effect in a high frequency region (in particular, from 100 MHz to 1,000 MHz) as compared with the sheet-like structure A6 before winding into a roll.

It is also verified that the magnetic field shielding effect (in particular, shielding effect in a low frequency region of 100 MHz or less) can further be enhanced by stacking two or more plies of sheet-like structures and/or by using an electromagnetically conductive/absorptive covering layer as a covering layer for covering an electromagnetically conductive/absorptive fibrous protrusion.

As a matter of course, the sheet-like structures A1 to A5 according to Examples 1 to 5 are also excellent in electric field shielding effect.

In addition, the sheet-like structures A1 to A5 according to Examples 1 to 5 are excellent in resistance to flattening of fiber, are suppressed or prevented from flattening of fiber, can efficiently exhibit a thickness effect of the electromagnetically conductive/absorptive fibrous protrusion, can provide flexible shielding materials, and therefore are easily applicable to various portions. This is because the fiber protector protects the electromagnetically conductive/absorptive fibrous protrusion composed of an electromagnetically conductive/absorptive fiber.

(EXAMPLE 6)

To one surface of an aluminum base material (thickness: 50 μm) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 μm to form an electromagnetically conductive/absorptive pressure-sensitive adhesive layer. In addition, as a fiber protector, an article under the trade name of "NISSEKI CONWED ON6200" (NISSEKI PLASTO CO., LTD.; mesh opening: 4 mm x 4 mm, basis weight: 34 g/$m^2$, percentage of holes: 76%, thickness: 0.5 mm) (net-like member) was affixed to the surface of the electromagnetically conductive/absorptive pressure-sensitive adhesive layer. Thereafter, the surface of the electromagnetically conductive/absorptive pressure-sensitive adhesive layer was subjected to electrostatic flocking using, as an electromagnetically conductive/absorptive fiber, an acrylic fiber with nickel-plated surface (fiber diameter: 20 μm, fiber length: 0.5 mm), thereby flocking the acrylic fiber with nickel-plated surface on portions of the surface of the electromagnetically conductive/absorptive pressure-sensitive adhesive layer corresponding to the through holes of the net-like member (fiber protector). There was thus prepared a sheet-like structure having a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the net-like member from flattening (the sheet-like structure will be hereinafter also referred to as "sheet-like structure B1"). The sheet-like structure had not been wound into a roll. In the sheet-like structure B1, the height of the net-like member stood 100% of the height of the electromagnetically conductive/absorptive fiber-raised section.

(EXAMPLE 7)

A sheet-like structure B1 was prepared by the procedure of Example 6. Thereafter, an article under the trade name of "NISSEKI CONWED XN9567" (NISSEKI PLASTO CO., LTD.; mesh opening: 1 mm x 1 mm, basis weight: 151 g/$m^2$, percentage of holes: 46%, thickness: 0.34 mm) (net-like member) was overlaid on a surface of the sheet-like structure B1 where the electromagnetically conductive/absorptive fiber-raised section was arranged, thus preparing a sheet-like structure having an apparent thickness of the net-like member of 0.84 mm. The sheet-like structure will be hereinafter also referred to as "sheet-like structure B2." This sheet-like structure had not been wound into a roll. In the sheet-like structure B2, the height of the net-like member stood 168% of the height of the electromagnetically conductive/absorptive fiber-raised section.

(EXAMPLE 8)

A sheet-like structure B1 was prepared by the procedure of Example 6. Thereafter, an article under the trade name of "NISSEKI CONWED ON6200" (NISSEKI PLASTO CO., LTD.; mesh opening: 4 mm x 4 mm, basis weight: 34 g/$m^2$, percentage of holes: 76%, thickness: 0.5 mm) (net-like member) was overlaid on a surface of the sheet-like structure B1 where the electromagnetically conductive/absorptive fiber-raised section was arranged, thus preparing a sheet-like structure having an apparent thickness of the net-like member of 1.0 mm. The sheet-like structure will be hereinafter also referred to as "sheet-like structure B3." This sheet-like structure had not been wound into a roll. In the sheet-like structure B3, the height of the net-like member stood 200% of the height of the electromagnetically conductive/absorptive fiber-raised section.

(EXAMPLE 9)

A sheet-like structure B1 was prepared by the procedure of Example 6. Thereafter, two plies of an article under the trade name of "NISSEKI CONWED XN9567" (NISSEKI PLASTO CO., LTD.; mesh opening: 1 mm x 1 mm, basis weight: 151 g/$m^2$, percentage of holes: 46%, thickness: 0.34 mm) (net-like member) were overlaid on a surface of the sheet-like structure B1 where the electromagnetically conductive/absorptive fiber-raised section was arranged, thus preparing a sheet-like structure having an apparent thickness of the net-like member of 1.18 mm. The sheet-like structure will be hereinafter also referred to as "sheet-like structure B4." This sheet-like structure had not been wound into a roll. In the sheet-like structure B4, the height of the net-like member stood 236% of the height of the electromagnetically conductive/absorptive fiber-raised section.

(EXAMPLE 10)

A sheet-like structure was prepared by the procedure of Example 6, except for using an article under the trade name of "NISSEKI CONWED ON3330" (NISSEKI PLASTO CO., LTD.; mesh opening: 4 mm x 1 mm, basis weight: 32 g/$m^2$, percentage of holes: 68%, thickness: 0.32 mm) (net-like member) as a fiber protector. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the net-like member from flattening (the sheet-like structure will be hereinafter also referred to as "sheet-like structure B5"). The sheet-like structure had not been wound into a roll. In the sheet-like structure B5, the height of the net-like member stood 64% of the height of the electromagnetically conductive/absorptive fiber-raised section.

(EXAMPLE 11)

A sheet-like structure was prepared by the procedure of Example 6, except for using an article under the trade name of "NISSEKI CONWED XN9567" (NISSEKI PLASTO CO., LTD.; mesh opening: 1 mm x 1 mm, basis weight: 151 g/$m^2$, percentage of holes: 46%, thickness: 0.34 mm) (net-like member) as a fiber protector. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the net-like member from flattening (the sheet-like structure will be hereinafter also referred to as "sheet-like structure B6"). The sheet-like structure had not been wound into a roll. In the sheet-like structure B6, the height of the net-like member stood 68% of the height of the electromagnetically conductive/absorptive fiber-raised section.

(EXAMPLE 12)

A sheet-like structure was prepared by the procedure of Example 6, except for using an article under the trade name of "NISSEKI CONWED XN6065" (NISSEKI PLASTO CO., LTD.; mesh opening: 1 mm x 1 mm, basis weight: 100 g/$m^2$, percentage of holes: 38%, thickness: 0.48 mm) (net-like member) as a fiber protector. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the net-like member from flattening (the sheet-like structure will be hereinafter also referred to as "sheet-like structure B7"). The sheet-like structure had not been wound into a roll.

In the sheet-like structure B7, the height of the net-like member stood 96% of the height of the electromagnetically conductive/absorptive fiber-raised section.

(EXAMPLE 13)

A sheet-like structure was prepared by the procedure of Example 6, except for using a sheet-like member (perforated sheet member) as a fiber protector. This sheet-like member was composed of a polyethylene resin base material (thickness: 0.10 mm) having round holes (diameter: 0.8 mm) formed at substantially equal intervals by perforating so as to have a percentage of holes of 2%. In the sheet-like member, the thickness of a thick-walled section in a peripheral region of the perforated section was 0.18 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B8"). The sheet-like structure had not been wound into a roll. In the sheet-like structure B8, the height of the perforated sheet member stood 36% of the height of the electromagnetically conductive/absorptive fiber-raised section.

(EXAMPLE 14)

A sheet-like structure was prepared by the procedure of Example 6, except for using a sheet-like member (perforated sheet member) as a fiber protector. This sheet-like member was composed of a polyethylene resin base material (thickness: 0.25 mm) having round holes (diameter: 0.8 mm) formed at substantially equal intervals by perforating so as to have a percentage of holes of 2%. In the sheet-like member, the thickness of a thick-walled section in a peripheral region of the perforated section was 0.35 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B9"). The sheet-like structure had not been wound into a roll. In the sheet-like structure B9, the height of the perforated sheet member stood 70% of the height of the electromagnetically conductive/absorptive fiber-raised section.

(EXAMPLE 15)

A sheet-like structure was prepared by the procedure of Example 6, except for using a sheet-like member (perforated sheet member) as a fiber protector. This sheet-like member was composed of a polyethylene resin base material (thickness: 0.18 mm) having round holes (diameter: 0.8 mm) formed at substantially equal intervals by perforating so as to have a percentage of holes of 0.65%. In the sheet-like member, the thickness of a thick-walled section in a peripheral region of the perforated section was 0.27 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B10"). The sheet-like structure had not been wound into a roll. In the sheet-like structure B10, the height of the perforated sheet member stood 54% of the height of the electromagnetically conductive/absorptive fiber-raised section.

(EXAMPLE 16)

A sheet-like structure was prepared by the procedure of Example 6, except for using a sheet-like member (perforated sheet member) as a fiber protector. This sheet-like member was composed of a polyethylene resin base material (thickness: 0.20 mm) having round holes (diameter: 0.8 mm) formed at substantially equal intervals by perforating so as to have a percentage of holes of 0.32%. In the sheet-like member, the thickness of a thick-walled section in a peripheral region of the perforated section was 0.28 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B11"). The sheet-like structure had not been wound into a roll. In the sheet-like structure B11, the height of the perforated sheet member stood 56% of the height of the electromagnetically conductive/absorptive fiber-raised section.

(EXAMPLE 17)

A sheet-like structure was prepared by the procedure of Example 6, except for using a sheet-like member (perforated sheet member) as a fiber protector. This sheet-like member was composed of a poly(ethylene terephthalate) base material (thickness: 0.075 mm) having round holes (diameter: 0.8 mm) formed at substantially equal intervals by perforating so as to have a percentage of holes of 0.17%. In the sheet-like member, the thickness of a thick-walled section in a peripheral region of the perforated section was 0.1 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B12"). The sheet-like structure had not been wound into a roll. In the sheet-like structure B12, the height of the perforated sheet member stood 20% of the height of the electromagnetically conductive/absorptive fiber-raised section.

(EXAMPLE 18)

A sheet-like structure was prepared by the procedure of Example 6, except for using a sheet-like member (perforated sheet member) as a fiber protector. This sheet-like member was composed of a polyolefin resin base material (thickness: 0.13 mm) having round holes (diameter: 0.8 mm) formed at substantially equal intervals by perforating so as to have a percentage of holes of 0.17%. In the sheet-like member, the thickness of a thick-walled section in a peripheral region of the perforated section was 0.2 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B13"). The sheet-like structure had not been wound into a roll. In the sheet-like structure B13, the height of the perforated sheet member stood 40% of the height of the electromagnetically conductive/absorptive fiber-raised section.

(EXAMPLE 19)

A sheet-like structure was prepared by the procedure of Example 6, except for using a sheet-like member (perforated sheet member) as a fiber protector. This sheet-like member was composed of a polyolefin resin base material (thickness: 0.25 mm) having round holes (diameter: 0.8 mm) formed at substantially equal intervals by perforating so as to have a percentage of holes of 0.17%. In the sheet-like member, the thickness of a thick-walled section in a peripheral region of the perforated section was 0.37 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B14"). The sheet-like structure had not been wound into a roll. In the sheet-like structure B14, the height of the perforated sheet member stood 74% of the height of the electromagnetically conductive/absorptive fiber-raised section.

(EXAMPLE 20)

A sheet-like structure B12 was prepared by the procedure of Example 17. Thereafter, an article under the trade name of "NISSEKI CONWED ON6200" (NISSEKI PLASTO CO., LTD.; mesh opening: 4 mm x 4 mm, basis weight: 34 g/m$^2$, percentage of holes: 76%, thickness: 0.5 mm) (net-like member) was overlaid on a surface of the sheet-like structure B12 where the electromagnetically conductive/absorptive fiber-raised section was arranged, thus preparing a sheet-like structure having an apparent thickness of the fiber protector (a total thickness of the perforated sheet member and the net-like member) of 0.7 mm. The sheet-like structure will be hereinafter also referred to as "sheet-like structure B15." This sheet-like structure had not been wound into a roll. In the sheet-like structure B15, the height of the fiber protector stood 140% of the height of the electromagnetically conductive/absorptive fiber-raised section.

(EXAMPLE 21)

A sheet-like structure was prepared by the procedure of Example 6, except for using a sheet-like member (perforated sheet member) as a fiber protector. This sheet-like member was composed of a poly(ethylene terephthalate) resin base material (thickness: 0.075 mm) having round holes (diameter: 0.8 mm) formed at substantially equal intervals by perforating so as to have a percentage of holes of 0.04%. In the sheet-like member, the thickness of a thick-walled section in a peripheral region of the perforated section was 0.1 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B16"). The sheet-like structure had not been wound into a roll. In the sheet-like structure B16, the height of the perforated sheet member stood 20% of the height of the electromagnetically conductive/absorptive fiber-raised section.

(EXAMPLE 22)

A sheet-like structure was prepared by the procedure of Example 6, except for using a sheet-like member (perforated sheet member) as a fiber protector. This sheet-like member was composed of a polyolefin resin base material (thickness: 0.13 mm) having round holes (diameter: 0.8 mm) formed at substantially equal intervals by perforating so as to have a percentage of holes of 0.04%. In the sheet-like member, the thickness of a thick-walled section in a peripheral region of the perforated section was 0.2 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B17"). The sheet-like structure had not been wound into a roll. In the sheet-like structure B17, the height of the perforated sheet member stood 40% of the height of the electromagnetically conductive/absorptive fiber-raised section.

(EXAMPLE 23)

A sheet-like structure was prepared by the procedure of Example 6, except for using a sheet-like member (perforated sheet member) as a fiber protector. This sheet-like member was composed of a polyolefin resin base material (thickness: 0.25 mm) having round holes (diameter: 0.8 mm) formed at substantially equal intervals by perforating so as to have a percentage of holes of 0.04%. In the sheet-like member, the thickness of a thick-walled section in a peripheral region of the perforated section was 0.37 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B18"). The sheet-like structure had not been wound into a roll. In the sheet-like structure B18, the height of the perforated sheet member stood 74% of the height of the electromagnetically conductive/absorptive fiber-raised section.

(EXAMPLE 24)

A sheet-like structure B16 was prepared by the procedure of Example 21. Thereafter, an article under the trade name of "NISSEKI CONWED ON6200" (NISSEKI PLASTO CO., LTD.; mesh opening: 4 mm x 4 mm, basis weight: 34 g/m$^2$, percentage of holes: 76%, thickness: 0.5 mm) (net-like member) was overlaid on a surface of the sheet-like structure B16 where the electromagnetically conductive/absorptive fiber-raised section was arranged, thus preparing a sheet-like structure having an apparent thickness of a fiber protector (a total thickness of the perforated sheet member and the net-like member) of 0.7 mm.. The sheet-like structure will be hereinafter also referred to as "sheet-like structure B19." This sheet-like structure had not been wound into a roll. In the sheet-like structure B19, the height of the fiber protector stood 140% of the height of the electromagnetically conductive/absorptive fiber-raised section.

(EXAMPLE 25)

A sheet-like structure was prepared by the procedure of Example 6, except for using a sheet-like member (perforated sheet member) as a fiber protector. This sheet-like member was composed of a polyolefin resin base material (thickness: 0.11 mm) having round holes (diameter: 0.8 mm) formed at substantially equal intervals by perforating so as to have a percentage of holes of 0.01%. In the sheet-like member, the thickness of a thick-walled section in a peripheral region of the perforated section was 0.2 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B20"). The sheet-like structure had not been wound into a roll. In the sheet-like structure B20, the height of the perforated sheet member stood 40% of the height of the electromagnetically conductive/absorptive fiber-raised section.

(EXAMPLE 26)

A sheet-like structure was prepared by the procedure of Example 6, except for using a sheet-like member (perforated sheet member) as a fiber protector. This sheet-like member was composed of a polyolefin resin base material (thickness: 0.25 mm) having round holes (diameter: 0.8 mm) formed at substantially equal intervals by perforating so as to have a percentage of holes of 0.01%. In the sheet-like member, the thickness of a thick-walled section in a peripheral region of the perforated section was 0.37 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically conductive/absorptive base material; and the electromagnetically conductive/absorptive fiber-raised section was suppressed or prevented by the perforated sheet member from flattening (the sheet-like structure will be hereinafter also referred to as "sheet-like structure B21"). The sheet-like structure had not been wound into a roll. In the sheet-like structure B21, the height of the perforated sheet member stood 74% of the height of the electromagnetically conductive/absorptive fiber-raised section.

(EXAMPLE 27)

A sheet-like structure was prepared by the procedure of Example 6, except for using a sheet-like member (perforated sheet member) as a fiber protector. This sheet-like member was composed of a polyolefin resin base material (thickness: 0.25 mm) having round holes (diameter: 0.8 mm) formed at substantially equal intervals by perforating so as to have a percentage of holes of 0.003%. In the sheet-like member, the thickness of a thick-walled section in a peripheral region of the perforated section was 0.37 mm. The resulting sheet-like structure had a configuration in which the fiber-raised section (electromagnetically conductive/absorptive fiber-raised section) composed of an electromagnetically conductive/absorptive fiber (acrylic fiber with nickel-plated surface) was partially arranged on the surface of the electromagnetically conductive/absorptive pressure-sensitive adhesive layer arranged on the electromagnetically, conductive/absorptive base material; and the electromagnetically conductive/absorptive fiber-raised section was suppressed or prevented by the perforated sheet member from flattening (the sheet-like structure will be hereinafter also referred to as "sheet-like structure B22"). The sheet-like structure had not been wound into a roll. In the sheet-like structure B22, the height of the perforated sheet member stood 74% of the height of the electromagnetically conductive/absorptive fiber-raised section.

(COMPARATIVE EXAMPLE 2)

To one surface of an aluminum base material (thickness: 50 μm) as an electromagnetically conductive/absorptive base material, an acrylic pressure-sensitive adhesive (base polymer: butyl acrylate/acrylic acid copolymer) containing 35 percent by weight (proportion based on the total solid contents) of a nickel powder blended therein was applied to a thickness after drying of 35 μm to form an electromagnetically conductive/absorptive pressure-sensitive adhesive layer. Thereafter, the entire surface of the subject electromagnetically conductive/absorptive pressure-sensitive adhesive layer was subjected to electrostatic flocking using, as an electromagnetically conductive/absorptive fiber, an acrylic fiber with nickel-plated surface (fiber diameter: 20 μm, fiber length: 0.5 mm), thereby flocking the acrylic fiber with nickel-plated surface on the entire surface of the above-mentioned electromagnetically conductive/absorptive pressure-sensitive adhesive layer. There was thus prepared a sheet-like structure having a configuration in which a fiber-raised section (electromagnetically conductive/absorptive fiber-raised section) composed of the electromagnetically conductive/absorptive fiber (acrylic fiber with nickel-plated surface) was entirely arranged on the surface of the electromagnetically conductive/absorptive pressure-sensitive adhesive layer arranged on the electromagnetically conductive/absorptive base material (the sheet-like structure will be hereinafter also referred to as "sheet-like structure B23"). The sheet-like structure had not been wound into a roll.

(Evaluation)

The magnetic field shielding effects of the sheet-like structures B1 to B23 prepared according to Examples 6 to 27 and Comparative Example 2 were evaluated by the above procedure using a measuring instrument for the evaluation of the electromagnetic shielding effectiveness by the KEC Method. In addition, the sheet-like structure B1 and the sheet-like structures B5 to B23 prepared according to Example 6, Examples 10 to 27, and Comparative Example 2 were subjected to pressurization (pressing) through a laminator, and the magnetic field shielding effects of the pressed sheet-like structure B1 and sheet-like structures B5 to B23 were evaluated in the same manner as above using a measuring instrument for the evaluation of the electromagnetic shielding effectiveness by the KEC Method. The evaluation results are shown in Tables 3 and 4. In these tables, data regarding samples which had not been subjected to pressing through a laminator are shown in "Non-pressed", and data regarding samples which had been subjected to pressurization through a laminator are shown in "Pressed."

In addition, an electroconductive pressure-sensitive adhesive tape (a product under the trade name of "NITOFOIL AT-5105E" from Nitto Denko Corporation) including an aluminum base material as a base material was affixed to each of the electromagnetically conductive/absorptive fiber-raised sections of the sheet-like structure B1, sheet-like structures B5 to B8, sheet-like structure B13, and sheet-like structure B23 prepared according to Example 6, Examples 10 to 13, Example 18, and Comparative Example 2 and thereby yielded sheet-like structures composed of the sheet-like structure B1, sheet-like structures B5 to B8, sheet-like structure B13, and sheet-like structure B23 each of whose electromagnetically conductive/absorptive fiber-raised sections had been covered by a covering layer composed of an electroconductive pressure-sensitive adhesive tape. The magnetic field shielding effects of the resulting sheet-like structures were evaluated in the same manner as above using a measuring instrument for the evaluation of the electromagnetic shielding effectiveness by the KEC Method. In addition, the sheet-like structures composed of the sheet-like structure B1, sheet-like structures B5 to B8, sheet-like structure B13, and sheet-like structure B23 whose electromagnetically conductive/absorptive fiber-raised section was covered by a covering layer composed of an electroconductive pressure-sensitive adhesive tape were pressed through a laminator in the same manner as above to yield pressed sheet-like structures. The magnetic field shielding effects of the pressed sheet-like structures were evaluated in the same manner as above using a measuring instrument for the evaluation of the electromagnetic shielding effectiveness by the KEC Method. These evaluation results are shown in Table 5. In Table 5, data regarding samples which had not been subjected to pressing through a laminator are shown in "Non-pressed", and data regarding samples which had been subjected to pressurization through a laminator are shown in "Pressed."

In addition, an acrylic pressure-sensitive adhesive tape (a product under the trade name of "No. 31B" from Nitto Denko Corporation) including a polyester film as a base material was affixed to each of the electromagnetically conductive/absorptive fiber-raised sections of the sheet-like structure B1, sheet-like structures B5 to B8, sheet-like structure B13, and sheet-like structure B23 prepared according to Example 6, Examples 10 to 13, Example 18, and Comparative Example 2 and thereby yielded sheet-like structures composed of the sheet-like structure B1, sheet-like structures B5 to B8, sheet-like structure B13, and sheet-like structure B23 whose electromagnetically conductive/absorptive fiber-raised section was covered by a covering layer composed of an acrylic pressure-sensitive adhesive tape. The magnetic field shielding effects of the resulting sheet-like structures were evaluated in the same manner as above using a measuring instrument for the evaluation of the electromagnetic shielding effectiveness by the KEC Method. In addition, the sheet-like structures composed of the sheet-like structure B1, sheet-like structures B5 to B8, sheet-like structure B13, and sheet-like structure B23 whose electromagnetically conductive/absorptive fiber-raised section was covered by a covering layer composed of an acrylic pressure-sensitive adhesive tape were pressurized through a laminator in the same manner as above to yield pressed sheet-like structures. The magnetic field shielding effects of the pressed sheet-like structures were evaluated in the same manner as above using a measuring instrument for the evaluation of the electromagnetic shielding effectiveness by the KEC Method. These evaluation results are shown in Table 6. In Table 6, data regarding samples which had not been subjected to pressing through a laminator are shown in "Non-pressed", and data regarding samples which had been subjected to pressurization through a laminator are shown in "Pressed."

[Table 3]

TABLE 3

Unit: (dB)

| | | | Frequency (MHz) | | | | | | | | | | | | | | | |
|---|---|---|---|---|---|---|---|---|---|---|---|---|---|---|---|---|---|---|
| | | | 1 | 2 | 3 | 5 | 7 | 10 | 20 | 30 | 50 | 70 | 100 | 200 | 300 | 500 | 700 | 1000 |
| Measurement limit | | | 57 | 63 | 66 | 71 | 74 | 77 | 83 | 86 | 90 | 92 | 95 | 98 | 100 | 97 | 93 | 75 |
| Example | 6 | Non-pressed | 32 | 38 | 41 | 46 | 50 | 54 | 64 | 72 | 85 | 91 | 95 | 98 | 100 | 97 | 93 | 75 |
| | | Pressed | 32 | 37 | 41 | 46 | 49 | 53 | 64 | 70 | 84 | 92 | 95 | 98 | 100 | 97 | 93 | 75 |
| | 7 | Non-pressed | 32 | 38 | 42 | 47 | 50 | 55 | 66 | 75 | 90 | 90 | 89 | 94 | 96 | 97 | 93 | 75 |
| | | Pressed | - | - | - | - | - | - | - | - | - | - | - | - | - | - | - | - |
| | 8 | Non-pressed | 32 | 38 | 42 | 47 | 51 | 55 | 66 | 74 | 90 | 92 | 92 | 95 | 98 | 97 | 93 | 75 |
| | | Pressed | - | - | - | - | - | - | - | - | - | - | - | - | - | - | - | - |
| | 9 | Non-pressed | 33 | 38 | 42 | 47 | 51 | 55 | 66 | 73 | 90 | 92 | 92 | 95 | 98 | 97 | 93 | 75 |
| | | Pressed | - | - | - | - | - | - | - | - | - | - | - | - | - | - | - | - |
| | 10 | Non-pressed | 30 | 36 | 40 | 45 | 48 | 53 | 65 | 75 | 85 | 91 | 95 | 98 | 100 | 97 | 93 | 75 |
| | | Pressed | 31 | 37 | 41 | 46 | 50 | 54 | 64 | 70 | 83 | 92 | 95 | 98 | 100 | 97 | 93 | 75 |
| | 11 | Non-pressed | 31 | 38 | 41 | 46 | 49 | 54 | 63 | 70 | 82 | 88 | 95 | 98 | 100 | 97 | 93 | 75 |
| | | Pressed | 31 | 37 | 41 | 45 | 49 | 54 | 66 | 81 | 77 | 76 | 77 | 83 | 85 | 87 | 89 | 75 |
| | 12 | Non-pressed | 31 | 37 | 41 | 46 | 50 | 54 | 64 | 71 | 83 | 89 | 95 | 98 | 100 | 97 | 93 | 75 |
| | | Pressed | 32 | 37 | 41 | 46 | 49 | 53 | 65 | 73 | 79 | 79 | 82 | 89 | 94 | 95 | 89 | 75 |
| | 13 | Non-pressed | 29 | 35 | 39 | 44 | 47 | 51 | 62 | 72 | 88 | 83 | 85 | 90 | 95 | 97 | 93 | 75 |
| | | Pressed | 31 | 37 | 40 | 45 | 49 | 53 | 67 | 74 | 71 | 72 | 74 | 77 | 78 | 80 | 80 | 75 |
| | 14 | Non-pressed | 34 | 40 | 43 | 49 | 52 | 57 | 69 | 81 | 81 | 79 | 81 | 85 | 85 | 85 | 86 | 75 |
| | | Pressed | 30 | 37 | 40 | 45 | 49 | 53 | 66 | 73 | 71 | 72 | 73 | 76 | 77 | 77 | 80 | 75 |
| | 15 | Non-pressed | 31 | 37 | 40 | 45 | 48 | 53 | 65 | 77 | 78 | 77 | 79 | 84 | 86 | 90 | 93 | 75 |
| | | Pressed | 31 | 37 | 40 | 45 | 48 | 53 | 65 | 77 | 78 | 77 | 79 | 84 | 86 | 90 | 93 | 75 |
| | 16 | Non-pressed | 30 | 36 | 40 | 44 | 48 | 53 | 64 | 75 | 78 | 77 | 79 | 84 | 85 | 88 | 94 | 75 |
| | | Pressed | 30 | 36 | 40 | 44 | 48 | 53 | 64 | 75 | 78 | 77 | 79 | 84 | 85 | 88 | 94 | 75 |

[Table 4]

TABLE 4

Unit: (dB)

| | | | Frequency (MHz) | | | | | | | | | | | | | | | |
|---|---|---|---|---|---|---|---|---|---|---|---|---|---|---|---|---|---|---|
| | | | 1 | 2 | 3 | 5 | 7 | 10 | 20 | 30 | 50 | 70 | 100 | 200 | 300 | 500 | 700 | 1000 |
| Measurement limit | | | 57 | 63 | 66 | 71 | 74 | 77 | 83 | 86 | 90 | 92 | 95 | 98 | 100 | 97 | 93 | 75 |
| Example | 17 | Non-pressed | 32 | 38 | 42 | 47 | 50 | 54 | 65 | 75 | 84 | 82 | 84 | 91 | 94 | 95 | 92 | 75 |
| | | Pressed | 31 | 37 | 41 | 45 | 49 | 53 | 66 | 72 | 70 | 71 | 74 | 76 | 77 | 74 | 85 | 74 |
| | 18 | Non-pressed | 30 | 37 | 41 | 45 | 49 | 53 | 64 | 74 | 88 | 84 | 85 | 90 | 93 | 93 | 95 | 75 |
| | | Pressed | 31 | 36 | 41 | 46 | 49 | 53 | 65 | 77 | 81 | 78 | 80 | 85 | 87 | 97 | 93 | 75 |
| | 19 | Non-pressed | 32 | 39 | 42 | 47 | 51 | 55 | 66 | 77 | 81 | 80 | 82 | 87 | 88 | 88 | 94 | 75 |
| | | Pressed | 31 | 37 | 41 | 45 | 49 | 53 | 66 | 74 | 73 | 73 | 75 | 79 | 81 | 80 | 89 | 75 |
| | 20 | Non-pressed | 31 | 37 | 41 | 45 | 49 | 53 | 65 | 75 | 83 | 82 | 83 | 90 | 95 | 95 | 92 | 75 |
| | | Pressed | 31 | 37 | 41 | 46 | 50 | 54 | 66 | 70 | 69 | 70 | 73 | 76 | 79 | 81 | 79 | 75 |
| | 21 | Non-pressed | 32 | 38 | 42 | 47 | 51 | 55 | 67 | 78 | 80 | 79 | 80 | 85 | 88 | 89 | 91 | 75 |
| | | Pressed | 30 | 36 | 40 | 45 | 48 | 52 | 60 | 61 | 62 | 62 | 65 | 68 | 70 | 69 | 70 | 75 |
| | 22 | Non-pressed | 30 | 37 | 41 | 45 | 49 | 53 | 64 | 74 | 88 | 84 | 85 | 90 | 93 | 93 | 95 | 75 |
| | | Pressed | 30 | 37 | 41 | 45 | 49 | 53 | 64 | 74 | 88 | 84 | 85 | 90 | 93 | 93 | 95 | 77 |
| | 23 | Non-pressed | 31 | 37 | 41 | 45 | 50 | 53 | 65 | 75 | 84 | 82 | 84 | 90 | 92 | 97 | 92 | 75 |
| | | Pressed | 31 | 37 | 41 | 45 | 50 | 54 | 66 | 69 | 68 | 70 | 72 | 74 | 75 | 82 | 83 | 72 |
| | 24 | Non-pressed | 31 | 37 | 41 | 45 | 50 | 54 | 66 | 75 | 77 | 77 | 79 | 85 | 88 | 82 | 92 | 75 |
| | | Pressed | 32 | 37 | 41 | 46 | 50 | 54 | 65 | 71 | 71 | 72 | 74 | 78 | 81 | 79 | 87 | 73 |
| | 25 | Non-pressed | 32 | 37 | 41 | 46 | 50 | 53 | 66 | 78 | 81 | 80 | 82 | 85 | 89 | 90 | 93 | 75 |
| | | Pressed | 31 | 37 | 41 | 45 | 50 | 53 | 66 | 70 | 69 | 70 | 72 | 75 | 75 | 71 | 86 | 75 |
| | 26 | Non-pressed | 32 | 38 | 42 | 46 | 50 | 55 | 65 | 74 | 90 | 92 | 92 | 98 | 98 | 98 | 95 | 75 |
| | | Pressed | 31 | 37 | 41 | 46 | 50 | 54 | 66 | 79 | 76 | 76 | 78 | 82 | 82 | 83 | 91 | 75 |

(continued)

Unit: (dB)

| | | Frequency (MHz) | | | | | | | | | | | | | | | |
|---|---|---|---|---|---|---|---|---|---|---|---|---|---|---|---|---|---|
| | | 1 | 2 | 3 | 5 | 7 | 10 | 20 | 30 | 50 | 70 | 100 | 200 | 300 | 500 | 700 | 1000 |
| 27 | Non-pressed | 31 | 38 | 41 | 46 | 50 | 54 | 65 | 74 | 89 | 91 | 90 | 98 | 98 | 98 | 95 | 75 |
| | Pressed | 31 | 37 | 41 | 45 | 49 | 53 | 65 | 71 | 71 | 72 | 74 | 77 | 78 | 78 | 89 | 75 |
| Comparative Example 2 | Non-pressed | 29 | 36 | 39 | 44 | 48 | 52 | 63 | 69 | 80 | 88 | 95 | 98 | 100 | 97 | 93 | 75 |
| | Pressed | 30 | 36 | 40 | 45 | 48 | 53 | 59 | 58 | 58 | 59 | 61 | 64 | 66 | 72 | 77 | 75 |

[Table 5]

TABLE 5 (Covered by electroconductive pressure-sensitive adhesive tape)

Unit: (dB)

| | | | Frequency (MHz) | | | | | | | | | | | | | | | |
|---|---|---|---|---|---|---|---|---|---|---|---|---|---|---|---|---|---|---|
| | | | 1 | 2 | 3 | 5 | 7 | 10 | 20 | 30 | 50 | 70 | 100 | 200 | 300 | 500 | 700 | 1000 |
| Measurement limit | | | 57 | 63 | 66 | 71 | 74 | 77 | 83 | 86 | 90 | 92 | 95 | 98 | 100 | 97 | 93 | 75 |
| Example | 6 | Non-pressed | 51 | 62 | 66 | 71 | 74 | 77 | 83 | 86 | 90 | 92 | 95 | 98 | 100 | 97 | 93 | 75 |
| | | Pressed | 47 | 60 | 65 | 71 | 74 | 77 | 83 | 86 | 90 | 92 | 95 | 98 | 100 | 97 | 93 | 75 |
| | 10 | Non-pressed | 47 | 59 | 65 | 71 | 74 | 77 | 83 | 86 | 90 | 92 | 95 | 98 | 100 | 97 | 93 | 75 |
| | | Pressed | 47 | 59 | 64 | 71 | 74 | 77 | 83 | 86 | 90 | 92 | 95 | 98 | 100 | 97 | 93 | 75 |
| | 11 | Non-pressed | 49 | 61 | 66 | 71 | 74 | 77 | 83 | 86 | 90 | 92 | 95 | 98 | 100 | 97 | 93 | 75 |
| | | Pressed | 48 | 61 | 66 | 71 | 74 | 77 | 83 | 86 | 90 | 92 | 94 | 98 | 100 | 97 | 93 | 75 |
| | 12 | Non-pressed | 50 | 60 | 65 | 71 | 74 | 77 | 83 | 86 | 90 | 92 | 95 | 98 | 100 | 97 | 93 | 75 |
| | | Pressed | 50 | 61 | 65 | 71 | 74 | 77 | 83 | 86 | 90 | 92 | 95 | 98 | 100 | 97 | 93 | 75 |
| | 13 | Non-pressed | 47 | 59 | 66 | 71 | 74 | 77 | 83 | 86 | 90 | 92 | 95 | 98 | 100 | 97 | 93 | 75 |
| | | Pressed | 41 | 53 | 62 | 71 | 74 | 77 | 83 | 86 | 90 | 92 | 95 | 98 | 100 | 97 | 93 | 75 |
| | 18 | Non-pressed | 44 | 57 | 65 | 71 | 74 | 77 | 83 | 86 | 90 | 92 | 95 | 98 | 100 | 97 | 93 | 75 |
| | | Pressed | 43 | 55 | 63 | 71 | 74 | 77 | 83 | 86 | 90 | 92 | 95 | 98 | 100 | 97 | 93 | 75 |
| Comparative Example 2 | | Non-pressed | 44 | 56 | 64 | 71 | 74 | 77 | 83 | 86 | 90 | 92 | 95 | 98 | 100 | 97 | 93 | 75 |
| | | Pressed | 41 | 53 | 63 | 71 | 71 | 72 | 75 | 78 | 83 | 87 | 90 | 98 | 100 | 97 | 93 | 75 |

[Table 6]

TABLE 6 (Covered by acrylic pressure-sensitive adhesive tape)

Unit: (dB)

| | | | Frequency (MHz) | | | | | | | | | | | | | | | |
|---|---|---|---|---|---|---|---|---|---|---|---|---|---|---|---|---|---|---|
| | | | 1 | 2 | 3 | 5 | 7 | 10 | 20 | 30 | 50 | 70 | 100 | 200 | 300 | 500 | 700 | 1000 |
| Measurement limit | | | 57 | 63 | 66 | 71 | 74 | 77 | 83 | 86 | 90 | 92 | 95 | 98 | 100 | 97 | 93 | 75 |
| Example | 6 | Non-pressed | 32 | 37 | 41 | 46 | 49 | 53 | 66 | 77 | 76 | 76 | 77 | 77 | 80 | 97 | 93 | 75 |
| | | Pressed | 32 | 37 | 41 | 46 | 49 | 53 | 64 | 73 | 86 | 82 | 82 | 98 | 100 | 97 | 93 | 75 |
| | 10 | Non-pressed | 31 | 37 | 41 | 46 | 49 | 53 | 65 | 73 | 90 | 92 | 90 | 93 | 95 | 97 | 93 | 75 |
| | | Pressed | 31 | 37 | 45 | 46 | 49 | 53 | 67 | 77 | 72 | 72 | 74 | 77 | 84 | 80 | 93 | 75 |
| | 11 | Non-pressed | 32 | 37 | 41 | 46 | 49 | 53 | 65 | 73 | 90 | 89 | 89 | 93 | 97 | 97 | 93 | 75 |
| | | Pressed | 31 | 37 | 41 | 46 | 49 | 53 | 65 | 76 | 85 | 82 | 82 | 82 | 95 | 97 | 93 | 75 |
| | 12 | Non-pressed | 31 | 37 | 42 | 46 | 49 | 54 | 64 | 73 | 90 | 90 | 89 | 93 | 100 | 97 | 93 | 75 |
| | | Pressed | 31 | 37 | 41 | 46 | 50 | 53 | 66 | 75 | 75 | 75 | 77 | 79 | 83 | 92 | 93 | 75 |
| | 13 | Non-pressed | 31 | 37 | 41 | 46 | 49 | 53 | 57 | 79 | 74 | 73 | 75 | 78 | 78 | 87 | 93 | 75 |
| | | Pressed | 30 | 37 | 41 | 46 | 49 | 53 | 67 | 77 | 72 | 72 | 73 | 76 | 76 | 90 | 93 | 75 |
| | 18 | Non-pressed | 31 | 37 | 41 | 45 | 49 | 53 | 66 | 84 | 77 | 76 | 77 | 81 | 81 | 97 | 93 | 75 |
| | | Pressed | 30 | 37 | 40 | 46 | 49 | 53 | 65 | 70 | 68 | 69 | 71 | 73 | 72 | 86 | 90 | 75 |
| Comparative Example 2 | | Non-pressed | 30 | 36 | 40 | 44 | 48 | 52 | 63 | 71 | 89 | 92 | 91 | 95 | 95 | 97 | 93 | 75 |
| | | Pressed | 30 | 37 | 40 | 45 | 48 | 53 | 65 | 70 | 68 | 69 | 71 | 73 | 72 | 85 | 93 | 75 |

Tables 3 and 4 demonstrate that the structures can effectively exhibit an electromagnetic shielding effect to shield electromagnetic waves by conduction or absorption, and, even after a pressure is applied thereon, they can effectively exhibit the electromagnetic shielding effect, even when the total area of portions where the electromagnetically conductive/absorptive fibrous protrusion is arranged stands 0.003% of the total surface area of one surface of the substrate.

Tables 5 and 6 demonstrate that the structures are suppressed or prevented from decreasing in electromagnetic conductivity/absorptivity, can effectively maintain their electromagnetic shielding ability, and can exhibit an excellent electromagnetic shielding effect even when the surface of their electromagnetically conductive/absorptive fibrous protrusion is covered typically by an insulating layer.

Industrial Applicability

Structures according to the present invention have the above-mentioned configurations and can thereby effectively maintain a capability of conducting or absorbing electromagnetic waves at a good level even when an external pressure is applied thereon. Accordingly, the structures according to the present invention can be suitably used as electroconductive materials, electromagnetic absorptive materials, and/or electromagnetic shielding materials.

## Claims

1. A structure having a capability of conducting or absorbing electromagnetic waves, comprising a substrate and a fibrous protrusion having a fiber and a capability of conducting or absorbing electromagnetic waves and being partially arranged in the substrate so that at least a part of the fiber of the fibrous protrusion is positioned outward from a surface of the substrate, the structure further comprising
a fiber protector arranged at least partially in a portion of the surface of the substrate where the fibrous protrusion having a capability of conducting or absorbing electromagnetic waves is not arranged,
wherein the fiber protector is capable of suppressing or preventing the fibrous protrusion having a capability of conducting or absorbing electromagnetic waves from flattening.

2. The structure of claim 1, wherein the fiber protector comprises a member having a through hole.

3. The structure of claim 2, wherein the member having a through hole is one of a net-like member having two or more through holes and a sheet-like member having two or more perforated through holes.

4. The structure of any one of claims 1 to 3, wherein the fiber protector comprises a plastic material as a raw material.

5. The structure of any one of claims 1 to 4, wherein the fiber protector has such a thickness as to be 10% to 250% of the thickness of the part of the fiber of the fibrous protrusion having a capability of conducting or absorbing electromagnetic waves positioned outward from the surface of the substrate.

6. The structure of any one of claims 2 to 5, wherein a total area of a portion of the surface of the substrate where the fibrous protrusion having a capability of conducting or absorbing electromagnetic waves is arranged has such the total area as to be more than 0% and equal to or less than 99.9% of a total surface area of a surface of the substrate.

7. The structure of any one of claims 1 to 6, wherein the substrate is at least one layer selected from the group consisting of a pressure-sensitive adhesive layer, an adhesive layer, and a polymer layer.

8. The structure of any one of claims 1 to 7, wherein the substrate has a capability of conducting or absorbing electromagnetic waves.

9. The structure of any one of claims 1 to 8, wherein the structure further comprises a support, and wherein the substrate is arranged at least on one side of the support.

10. The structure of claim 9, wherein the support has a capability of conducting or absorbing electromagnetic waves.

11. The structure of any one of claims 1 to 10, wherein the structure further comprises a covering layer that covers the fibrous protrusion having a capability of conducting or absorbing electromagnetic waves.

**12.** The structure of claim 11, wherein the covering layer has a capability of conducting or absorbing electromagnetic waves.

**13.** The structure of any one of claims 1 to 12, which is a sheet-like structure having a sheet form.

**14.** The structure of any one of claims 1 to 13, which is applied as an electroconductive material.

**15.** The structure of any one of claims 1 to 13, which is applied as an electromagnetic absorptive material.

**16.** The structure of any one of claims 1 to 13, which is applied as an electromagnetic shielding material.

Fig. 1

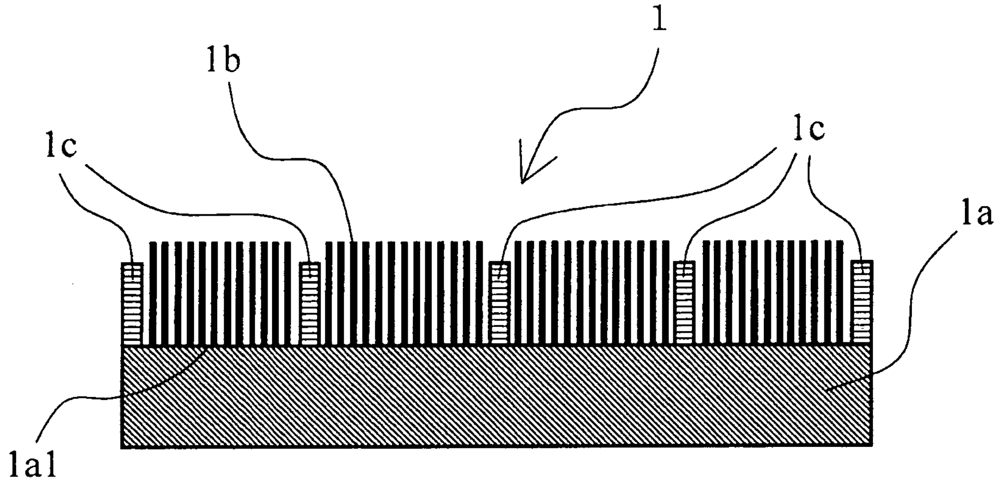


Fig. 2

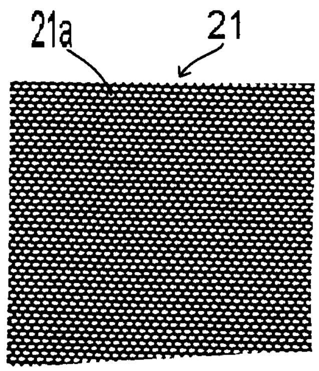


( a )

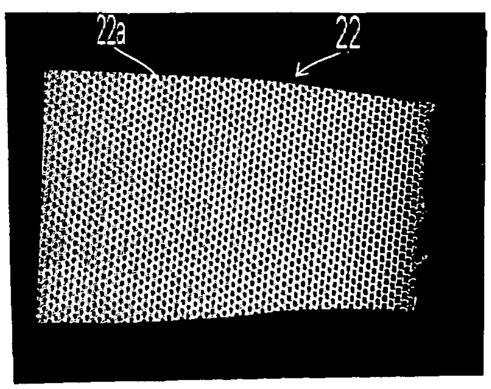


( b )

Fig. 3

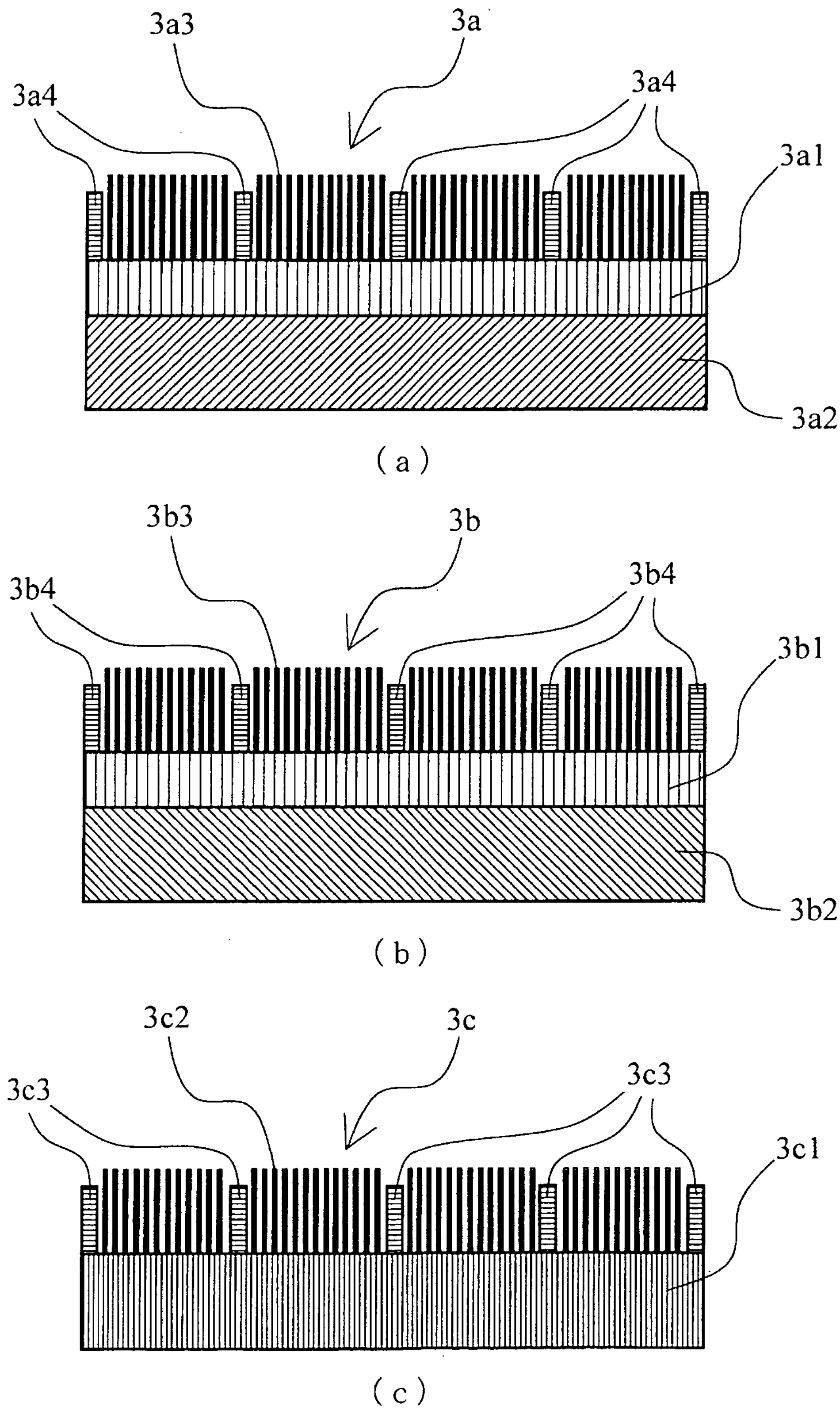
3a3
3a
3a4
3a4
3a1
3a2
(a)
3b3
3b
3b4
3b4
3b1
3b2
(b)
3c2
3c
3c3
3c3
3c1
(c)

Fig. 4

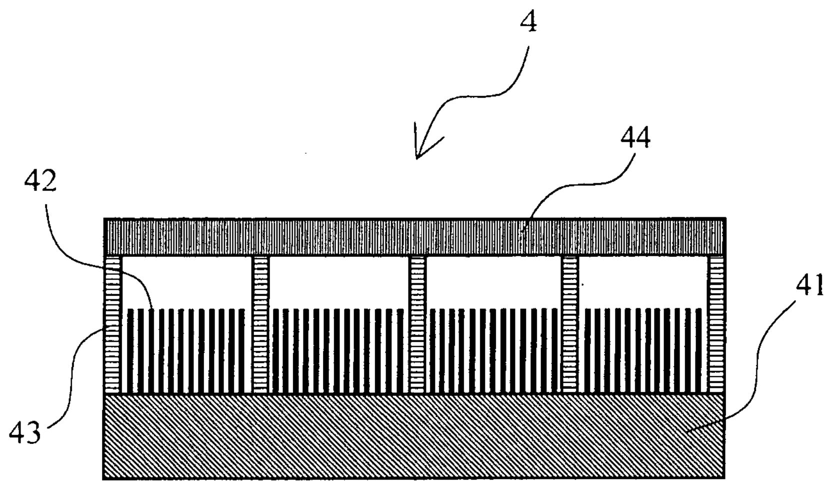


Fig. 5

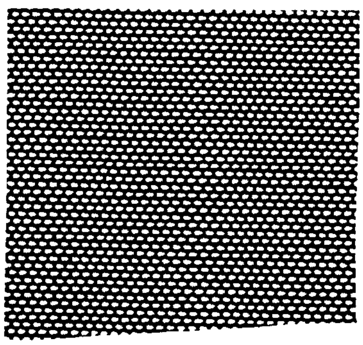

Fig. 6

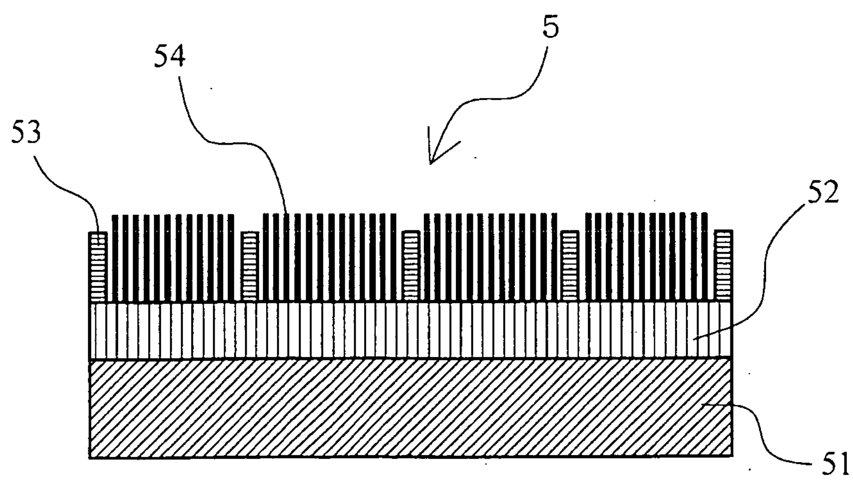

Fig. 7

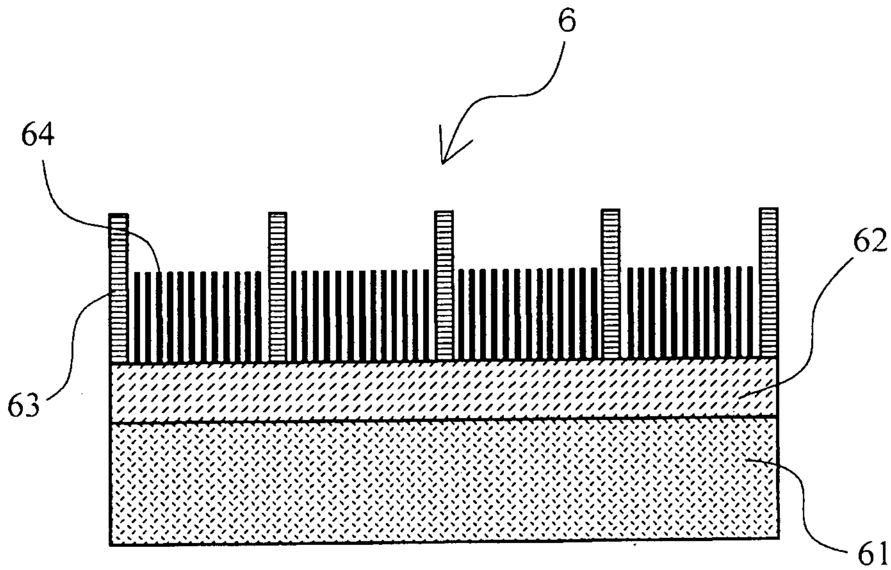


Fig. 8

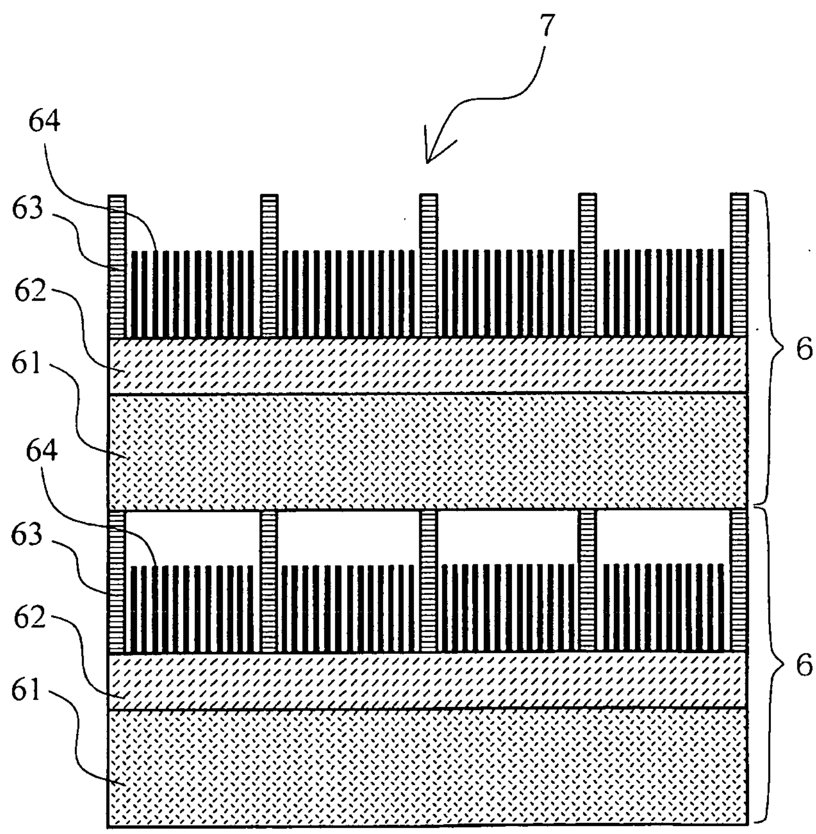

Fig. 9

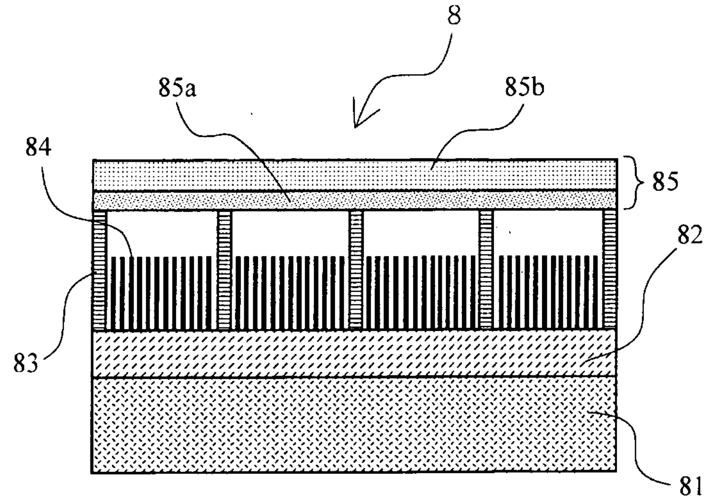


Fig. 10

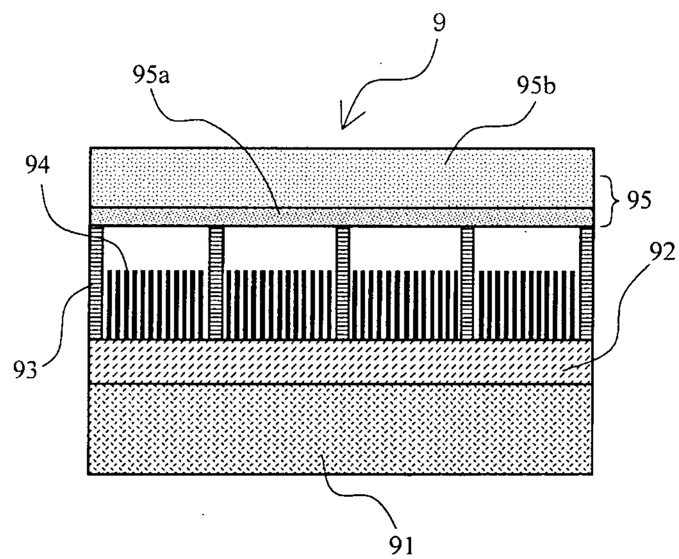


Fig. 11

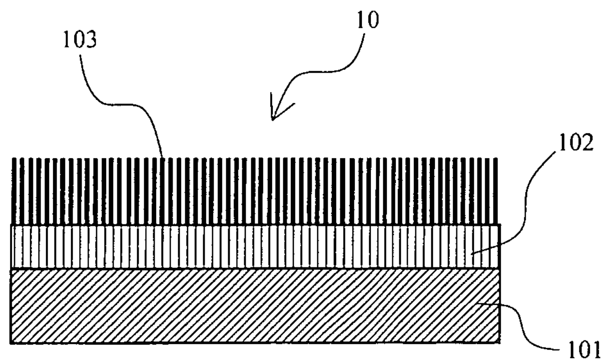

Fig. 12

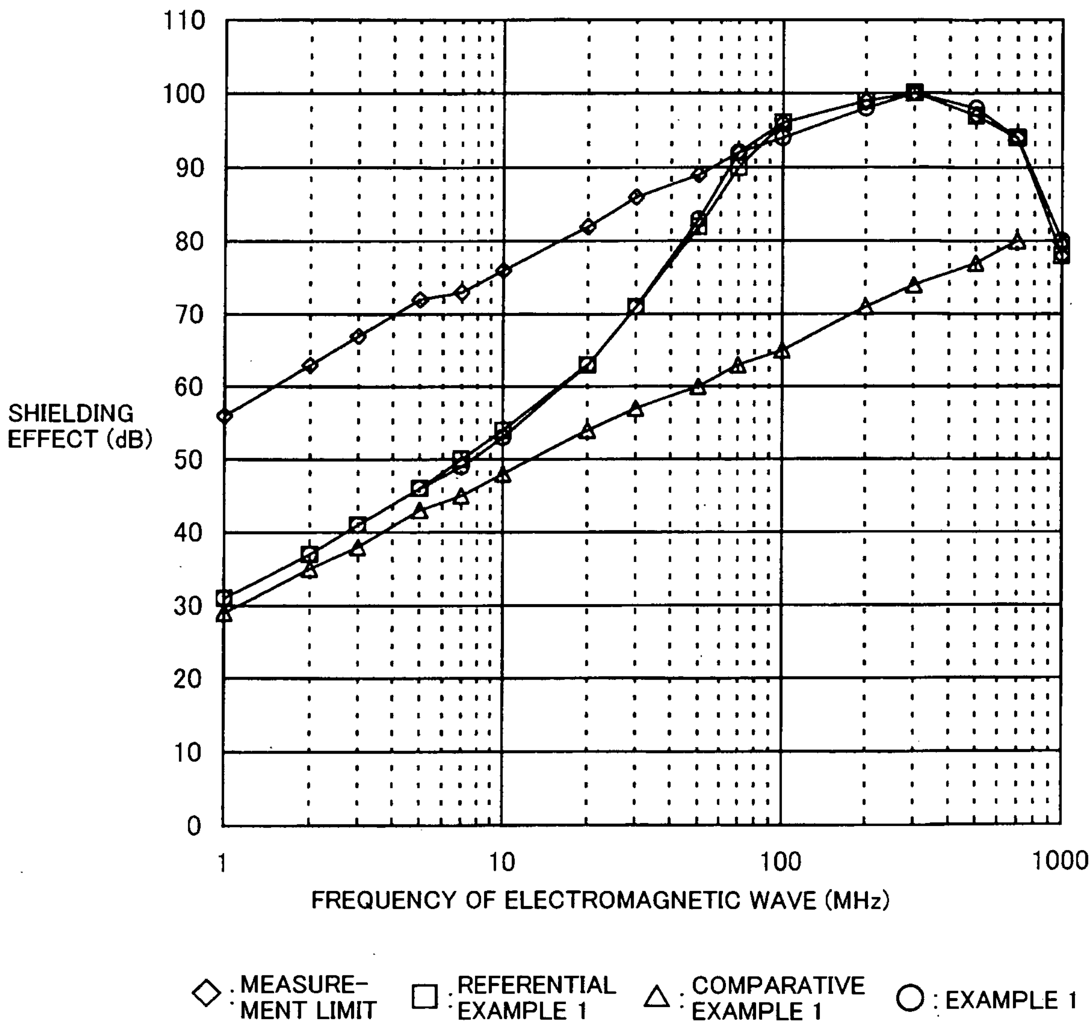
110
100
90
80
70
60
50
40
30
20
10
0
SHIELDING EFFECT (dB)
1
10
100
1000
FREQUENCY OF ELECTROMAGNETIC WAVE (MHz)
◇: MEASUREMENT LIMIT
□: REFERENTIAL EXAMPLE 1
△: COMPARATIVE EXAMPLE 1
○: EXAMPLE 1

Fig. 13

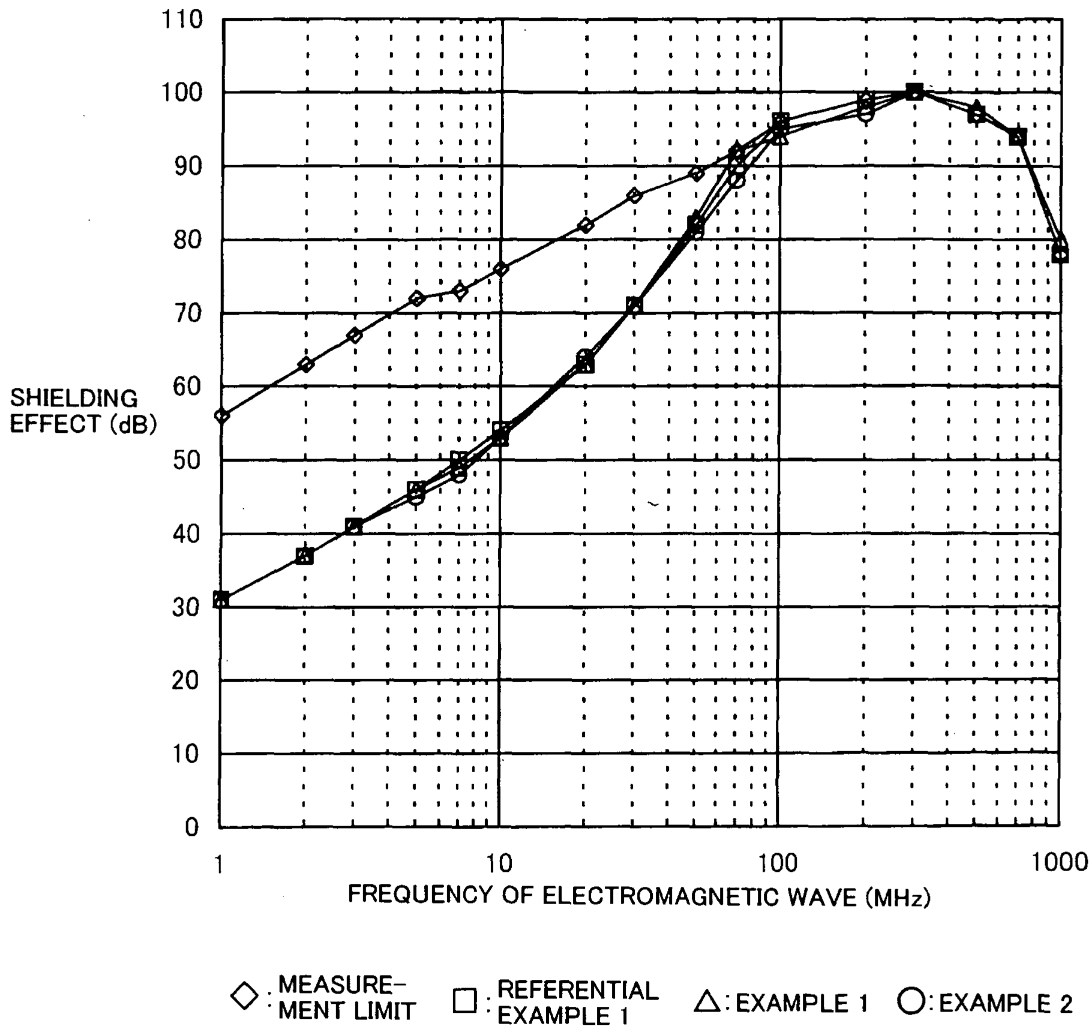
110
100
90
80
70
60
50
40
30
20
10
0
SHIELDING EFFECT (dB)
1
10
100
1000
FREQUENCY OF ELECTROMAGNETIC WAVE (MHz)
◇: MEASURE-MENT LIMIT
□: REFERENTIAL EXAMPLE 1
△: EXAMPLE 1
○: EXAMPLE 2

Fig. 14

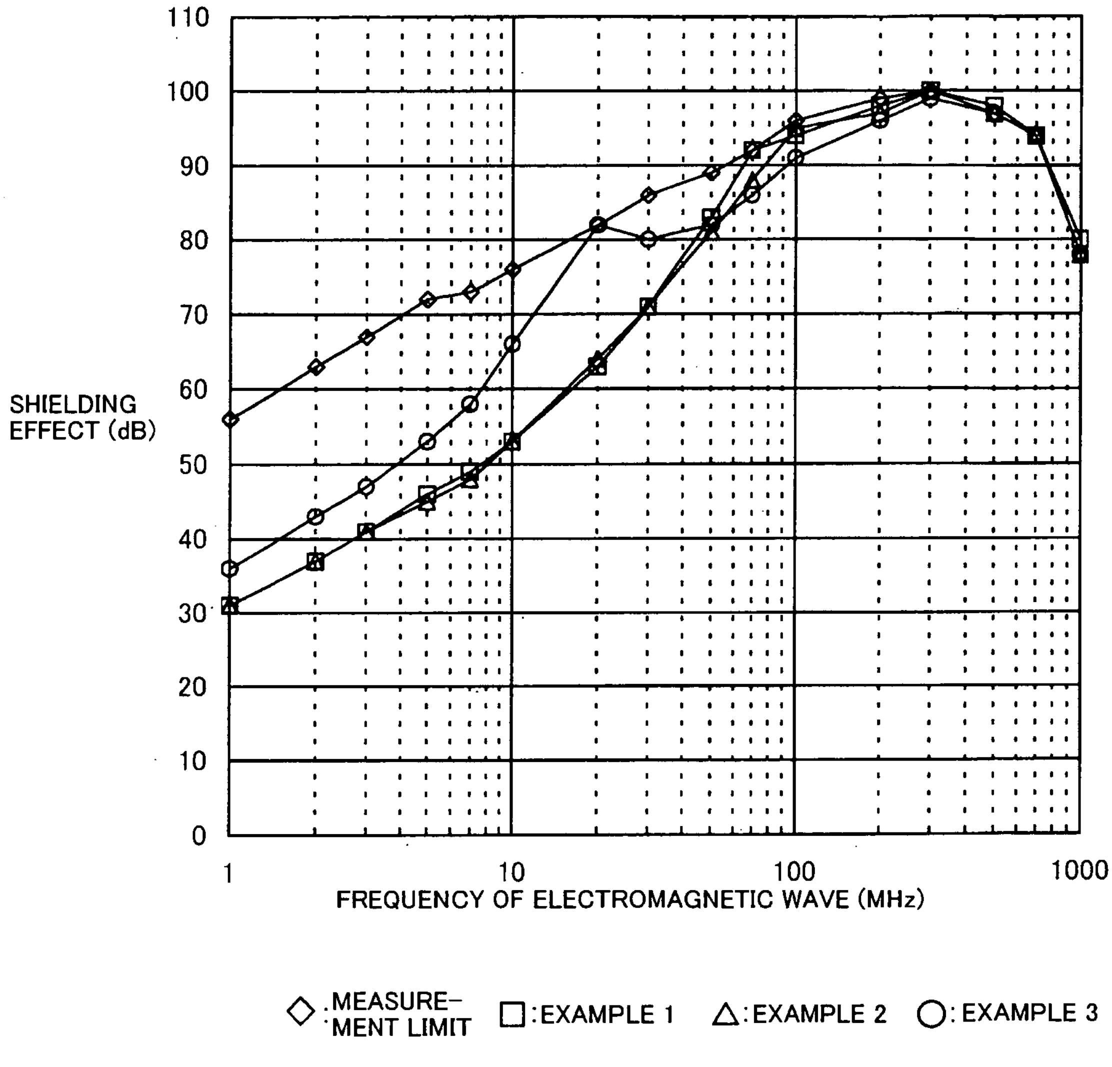
110
100
90
80
70
60
50
40
30
20
10
0
SHIELDING EFFECT (dB)
1
10
100
1000
FREQUENCY OF ELECTROMAGNETIC WAVE (MHz)
◇:MEASURE-MENT LIMIT
□:EXAMPLE 1
△:EXAMPLE 2
○:EXAMPLE 3

Fig. 15

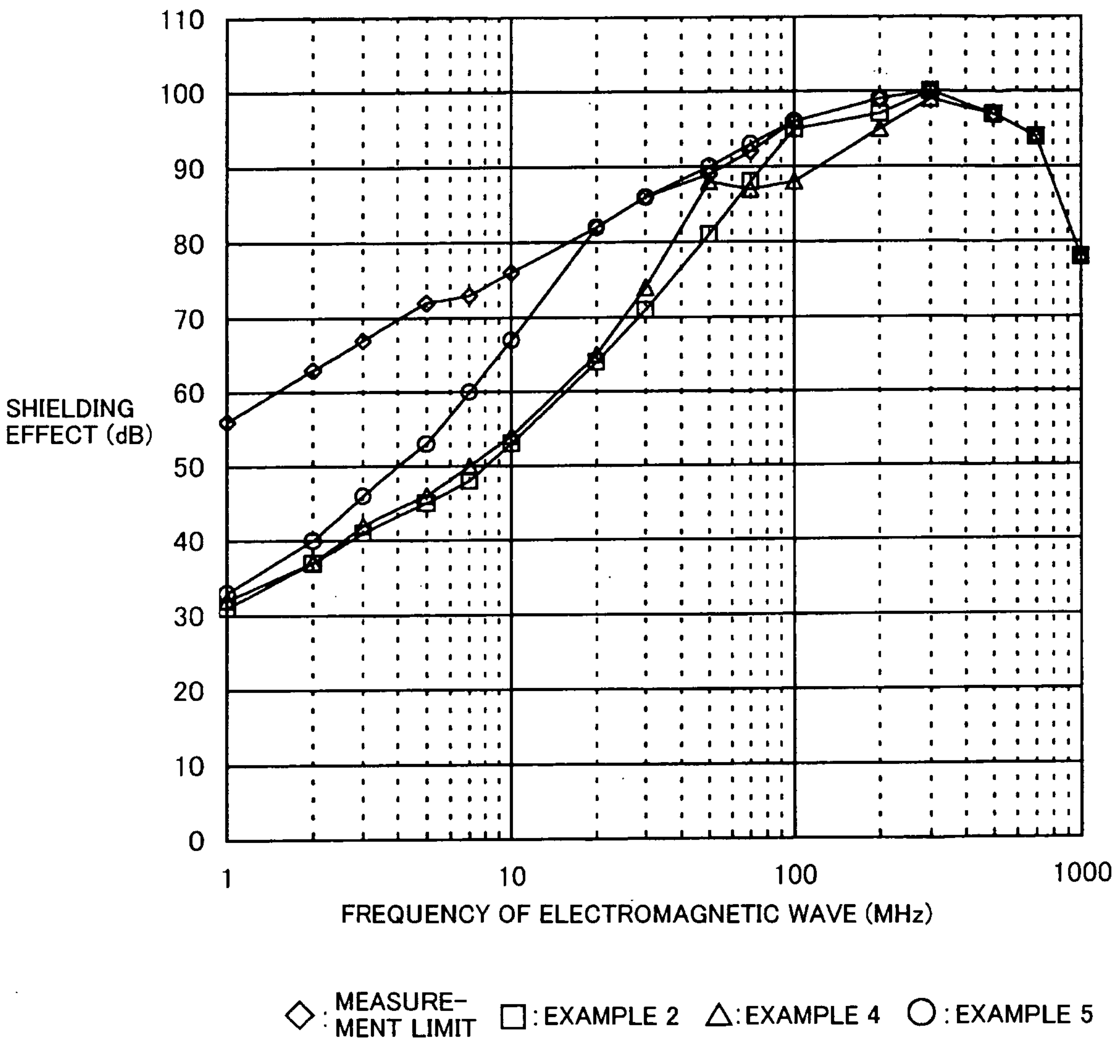
110
100
90
80
70
60
50
40
30
20
10
0
SHIELDING EFFECT (dB)
1
10
100
1000
FREQUENCY OF ELECTROMAGNETIC WAVE (MHz)
◇: MEASUREMENT LIMIT
□: EXAMPLE 2
△: EXAMPLE 4
○: EXAMPLE 5

Fig. 16

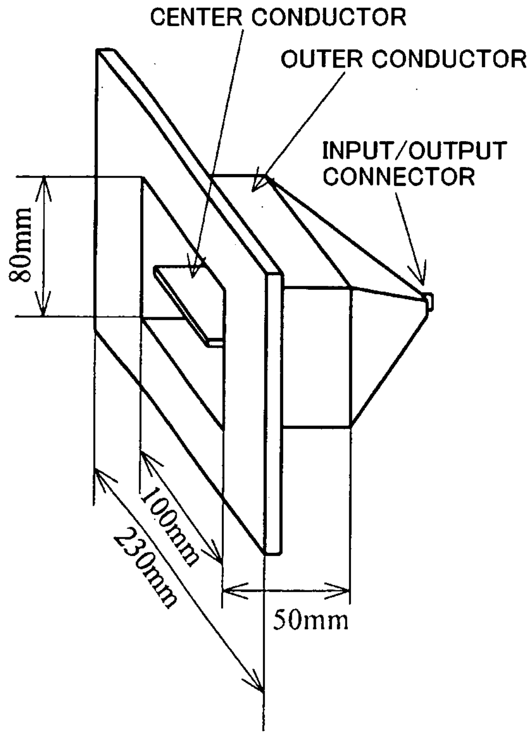


(a)

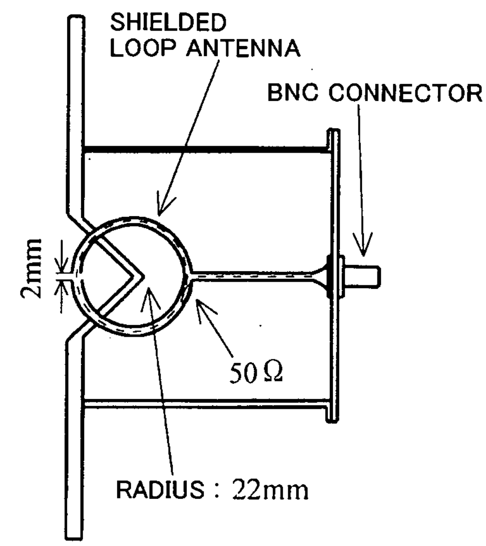


(b)

Fig. 17

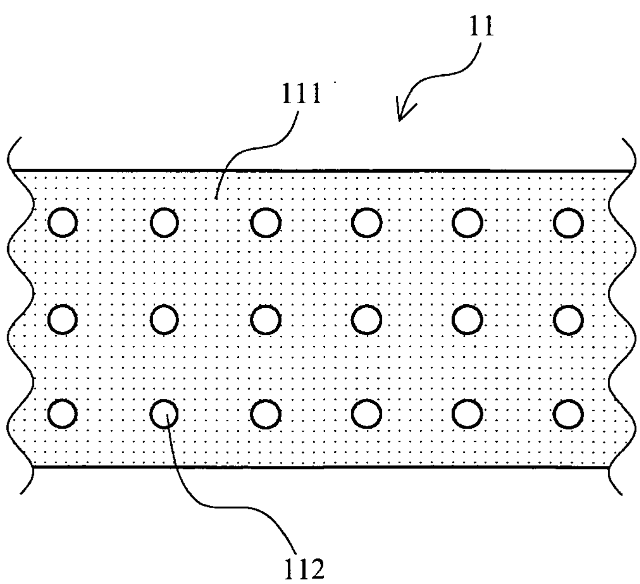

**INTERNATIONAL SEARCH REPORT**

International application No.
PCT/JP2006/307765

A. CLASSIFICATION OF SUBJECT MATTER
*H05K9/00*(2006.01)

According to International Patent Classification (IPC) or to both national classification and IPC

B. FIELDS SEARCHED

Minimum documentation searched (classification system followed by classification symbols)
H05K9/00

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 10-117089 A (Kitakawa Kogyo Kabushiki Kaisha),<br>06 May, 1998 (06.05.98),<br>Par. Nos. [0001], [0003] to [0009], [0013] to [0017]; Fig. 1<br>(Family: none) | 1-10,13,14,16<br>11,12,15 |
| Y | JP 2003-218580 A (Mitsubishi Cable Industries, Ltd.),<br>31 July, 2003 (31.07.03),<br>Par. Nos. [0014] to [0026]; Fig. 1<br>(Family: none) | 11,12,15 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 05 June, 2006 (05.06.06) | 13 June, 2006 (13.06.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/307765

C (Continuation). DOCUMENTS CONSIDERED TO BE RELEVANT

| Category* | Citation of document, with indication, where appropriate, of the relevant passages | Relevant to claim No. |
|---|---|---|
| A | JP 2004-104072 A (Koyo Sangyo Kabushiki Kaisha), 02 April, 2004 (02.04.04), Full text; Figs. 1 to 5 (Family: none) | 1-16 |
| A | JP 2004-104067 A (Koyo Sangyo Kabushiki Kaisha), 02 April, 2004 (02.04.04), Full text; Figs. 1 to 21 (Family: none) | 1-16 |
| A | Microfilm of the specification and drawings annexed to the request of Japanese Utility Model Application No. 197118/1984(Laid-open No. 112698/1986) (Kabushiki Kaisha Harada Sangyo), 16 July, 1986 (16.07.86), Full text; Figs. 1, 2 & EP 162645 A1 | 1-16 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002501821 A
- JP H10120904 A
- JP S612394 A

### Non-patent literature cited in the description

- Seidenshokumo No Genri To Jissai. *SENI,* June 1982, vol. 34 (6
- Denjiha Shahei. Tokkyo Mappu Shirizu: Denki 23. Japan Institute of Invention and Innovation, 253-269